(19) Europäisches Patentamt
European Patent Office
Office européen des brevets

(11) **EP 4 779 909 A1**

(12) **EUROPEAN PATENT APPLICATION**
published in accordance with Art. 153(4) EPC

(43) Date of publication:
**22.07.2026 Bulletin 2026/30**

(51) International Patent Classification (IPC):
*H04L 1/00* (2006.01)        *H03M 13/11* (2006.01)

(21) Application number: **24877577.7**

(52) Cooperative Patent Classification (CPC):
**H03M 13/11; H04L 1/00**

(22) Date of filing: **14.10.2024**

(86) International application number:
**PCT/KR2024/015449**

(87) International publication number:
**WO 2025/080042 (17.04.2025 Gazette 2025/16)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Samsung Electronics Co., Ltd.**
**Suwon-si, Gyeonggi-do 16677 (KR)**

(72) Inventors:
• **MYUNG, Seho**
  **Suwon-si, Gyeonggi-do 16677 (KR)**
• **JANG, Min**
  **Suwon-si, Gyeonggi-do 16677 (KR)**

(30) Priority: **12.10.2023 KR 20230135524**

(74) Representative: **Nederlandsch Octrooibureau**
**P.O. Box 29720**
**2502 LS The Hague (NL)**

(54) **METHOD AND APPARATUS FOR ENCODING AND DECODING DATA IN COMMUNICATION OR BROADCASTING SYSTEM**

(57) The disclosure relates to a method performed in a 5G or 6G communication system for supporting a higher data transmission rate than that of a 4G communication system such as LTE and, for example, to a low density parity check (LDPC) encoding method and apparatus capable of variably performing a method for maximizing an encoding gain or minimizing decoding latency by variably applying puncturing of data bits when determining encoding bits.

FIG. 10

EP 4 779 909 A1

**Description**

**BACKGROUND**

Field

The disclosure relates to a method and an apparatus for encoding and decoding data in communication or broadcasting systems.

Description of Related Art

Considering the development of wireless communication from generation to generation, the technologies have been developed mainly for services targeting humans, such as voice calls, multimedia services, and data services. Following the commercialization of 5G (5th-generation) communication systems, it is expected that the number of connected devices will exponentially grow. Increasingly, these will be connected to communication networks. Examples of connected things may include vehicles, robots, drones, home appliances, displays, smart sensors connected to various infrastructures, construction machines, and factory equipment. Mobile devices are expected to evolve in various form-factors, such as augmented reality glasses, virtual reality headsets, and hologram devices. In order to provide various services by connecting hundreds of billions of devices and things in the 6G (6th-generation) era, there have been ongoing efforts to develop improved 6G communication systems. For these reasons, 6G communication systems are referred to as beyond-5G systems.

6G communication systems, which are expected to be commercialized around 2030, will have a peak data rate of tera (1,000 giga)-level bps and a radio latency less than 100μsec, and thus will be 50 times as fast as 5G communication systems and have the 1/10 radio latency thereof.

In order to accomplish such a high data rate and an ultra-low latency, it has been considered to implement 6G communication systems in a terahertz band (for example, 95GHz to 3THz bands). It is expected that, due to severer path loss and atmospheric absorption in the terahertz bands than those in mmWave bands introduced in 5G, technologies capable of securing the signal transmission distance (that is, coverage) will become more crucial. It is necessary to develop, as major technologies for securing the coverage, radio frequency (RF) elements, antennas, novel waveforms having a better coverage than orthogonal frequency division multiplexing (OFDM), beamforming and massive multiple input multiple output (MIMO), full dimensional MIMO (FD-MIMO), array antennas, and multiantenna transmission technologies such as large-scale antennas. In addition, there has been ongoing discussion on new technologies for improving the coverage of terahertz-band signals, such as metamaterial-based lenses and antennas, orbital angular momentum (OAM), and reconfigurable intelligent surface (RIS).

Moreover, in order to improve the spectral efficiency and the overall network performances, the following technologies have been developed for 6G communication systems: a full-duplex technology for enabling an uplink transmission and a downlink transmission to simultaneously use the same frequency resource at the same time; a network technology for utilizing satellites, high-altitude platform stations (HAPS), and the like in an integrated manner; an improved network structure for supporting mobile base stations and the like and enabling network operation optimization and automation and the like; a dynamic spectrum sharing technology via collison avoidance based on a prediction of spectrum usage; an use of artificial intelligence (AI) in wireless communication for improvement of overall network operation by utilizing AI from a designing phase for developing 6G and internalizing end-to-end AI support functions; and a next-generation distributed computing technology for overcoming the limit of UE computing ability through reachable superhigh-performance communication and computing resources (such as mobile edge computing (MEC), clouds, and the like) over the network. In addition, through designing new protocols to be used in 6G communication systems, developing mechanisms for implementing a hardware-based security environment and safe use of data, and developing technologies for maintaining privacy, attempts to strengthen the connectivity between devices, optimize the network, promote softwarization of network entities, and increase the openness of wireless communications are continuing.

It is expected that research and development of 6G communication systems in hyper-connectivity, including person to machine (P2M) as well as machine to machine (M2M), will allow the next hyper-connected experience. Particularly, it is expected that services such as truly immersive extended reality (XR), high-fidelity mobile hologram, and digital replica could be provided through 6G communication systems. In addition, services such as remote surgery for security and reliability enhancement, industrial automation, and emergency response will be provided through the 6G communication system such that the technologies could be applied in various fields such as industry, medical care, automobiles, and home appliances.

## SUMMARY

Embodiments of the disclosure may provide algebraic characteristics that the parity check matrix of a low density parity check (LDPC) code must satisfy in order to reduce decoding latency and lower encoding complexity. Furthermore, an efficient encoding and decoding method and apparatus using an LDPC code having the algebraic characteristics are provided.

Embodiments of the disclosure may provide algebraic characteristics that the parity check matrix of an LDPC code must satisfy to reduce the block error rate (BLER). Furthermore, an efficient encoding and decoding method and apparatus using an LDPC code having the algebraic characteristics are provided.

Embodiments of the disclosure may provide algebraic characteristics that the parity check matrix of an LDPC code must satisfy by appropriately combining the algebraic characteristics to simultaneously reduce decoding latency, encoding complexity, and BLER. Furthermore, an efficient encoding and decoding method and apparatus using an LDPC code having the combined algebraic characteristics are provided.

Embodiments of the disclosure may provide a method for variably applying puncturing of LDPC encoded bits to support a trade-off between encoding performance and decoding latency. Furthermore, an efficient encoding and decoding method and apparatus that support the variable puncturing method are provided.

A data transmission method of a base station or UE in a communication system according to an example embodiment of the disclosure may include: low density parity check (LDPC)-encoding data bits, based on a base matrix and/or a parity check matrix, applying rate matching to the encoded bits, modulating the rate-matched encoded bits, and transmitting the modulated signal through a transmitting apparatus, wherein, based on a configuration of the system, the encoded bits are variably applied such that some of the data bits are included in or not included in the encoded bits.

A data reception method of a base station or UE in a communication system according to an example embodiment of the disclosure may include: receiving, through a receiving apparatus, a modulated signal corresponding to at least part of encoded bits, performing demodulation to determine values for decoding based on the received signal, performing low density parity check (LDPC) decoding based on the determined values and a base matrix and/or a parity check matrix, appropriately applying rate dematching to a result of the LDPC decoding, and determining data bits from the rate-dematched result, wherein, based on a configuration of the system, the encoded bits are variably applied such that some of the data bits are included in or not included in the encoded bits.

A method performed by a transmitting apparatus in a communication system according to an example embodiment of the disclosure may include: determining a number of input bits, determining a base matrix based on the number of input bits, determining a lifting size Z based on at least one of the number of input bits or the base matrix, determining a parity check matrix based on at least one of the base matrix and/or the lifting size Z, determining encoded bits by performing encoding based on the parity check matrix and the input bits, and transmitting at least part of the encoded bits to a receiving apparatus, wherein input bits of a first length among the input bits are not included in the encoded bits based on a first configuration being indicated, and input bits of a second length among the input bits are not included in the encoded bits based on a second configuration being indicated, and wherein the second length is 0 or less than the first length.

A method performed by a receiving apparatus in a communication system according to an example embodiment of the disclosure may include: receiving a signal corresponding to at least part of encoded bits, determining the number of input bits based on the signal, determining a base matrix based on the number of input bits, determining a lifting size Z based on at least one of the number of input bits or the base matrix, determining a parity check matrix based on at least one of the base matrix or the lifting size Z, and decoding the signal based on the parity check matrix, wherein input bits of a first length among the input bits are not included in the encoded bits based on a first configuration being indicated, and input bits of a second length among the input bits are not included in the encoded bits based on a second configuration being indicated, and wherein the second length is 0 or less than the first length.

A transmitting apparatus in a communication system according to an example embodiment of the disclosure may include: a transmitter, and a controller coupled with the transmitter, the controller configured to determine a number of input bits, determine a base matrix based on the number of input bits, determine a lifting size Z based on at least one of the number of input bits or the base matrix, determine a parity check matrix based on at least one of the base matrix or the lifting size Z, determine encoded bits by performing encoding based on the parity check matrix and the input bits, and transmit at least part of the encoded bits to a receiving apparatus, wherein input bits of a first length among the input bits are not included in the encoded bits based on a first configuration being indicated, and input bits of a second length among the input bits are not included in the encoded bits based on a second configuration being indicated, and wherein the second length is 0 or less than the first length.

A receiving apparatus in a communication system according to an example embodiment of the disclosure may: include a receiver, and a controller coupled with the transceiver, wherein the controller is configured to receive a signal corresponding to at least part of encoded bits, determine a number of input bits, based on the signal, determine a base matrix, based on the number of input bits, determine a lifting size Z based on at least one of the number of input bits or the base matrix, determine a parity check matrix based on at least one of the base matrix or the lifting size Z, and decode the signal based on the parity check matrix, wherein input bits of a first length among the input bits are not included in the encoded bits based on a first configuration being indicated, and input bits of a second length among the input bits are not included in the encoded bits based on a second configuration being indicated, and wherein the second length is 0 or less than the first length.

The disclosure applies a method for variably applying puncturing of data bits when determining encoded bits. The disclosure may support an efficient LDPC encoding method and apparatus by enabling variably applying methods for maximizing encoding gain or minimizing decoding latency depending on system conditions.

BRIEF DESCRIPTION OF THE DRAWINGS

The above and other aspects, features and advantages of certain embodiments of the present disclosure will be more apparent from the following detailed description, taken in conjunction with the accompanying drawings, in which:

FIG. 1 is a diagram illustrating an example systematic LDPC codeword structure according to various example embodiments.

FIG. 2 is a diagram illustrating a graphical representation method of an LDPC code according to various example embodiments.

FIG. 3A is a diagram illustrating example cycle characteristics of a QC-LDPC code according to various example embodiments.

FIG. 3B is a diagram illustrating example cycle characteristics of a QC-LDPC code according to various example embodiments.

FIG. 4 is a diagram illustrating an example transmission block structure according to various example embodiments.

FIG. 5 is an flowchart illustrating an example LDPC encoding process according to various example embodiments.

FIG. 6 is a flowchart illustrating an example LDPC decoding process according to various example embodiments.

FIG. 7 is a block diagram illustrating an example configuration of a transmitting apparatus according to various example embodiments.

FIG. 8 is a block diagram illustrating an example configuration of a receiving apparatus according to various example embodiments.

FIG. 9 is a block diagram illustrating an example configuration of an LDPC decoder according to various example embodiments.

FIG. 10 is an diagram illustrating an example structure of a parity check matrix of an LDPC code according to various example embodiments.

FIGS. 11A and 11B are diagrams illustrating examples of a parity check matrix for an LDPC code that satisfies the characteristics according to various example embodiments.

FIGS. 12A and 12B are diagrams illustrating examples where one or two punctured bit nodes are connected to a single check node, respectively according to various example embodiments.

DETAILED DESCRIPTION

Hereinafter, various example embodiments of the disclosure will be described in greater detail with reference to the accompanying drawings. In the disclosure, a detailed description of relevant known functions or configurations may be omitted when it is determined that the description may make the subject matter of the disclosure unnecessarily unclear. The terms which will be described below are terms defined in consideration of the functions in the disclosure, and may be different according to users, intentions of the users, or customs. Therefore, the definitions of the terms should be made based on the contents throughout the disclosure.

Based on determinations by those skilled in the art, the disclosure may also be applied to other systems having similar technical backgrounds through some modifications without significantly departing from the scope of the disclosure. For reference, the term "communication system" generally includes a broadcast system, but in the disclosure, a communication may be referred to as a broadcast system when the service of the communication system is a broadcast service.

The advantages and features of the disclosure will be apparent by making reference to various example embodiments as described below in greater detail in conjunction with the accompanying drawings. However, the disclosure is not limited to the examples set forth below, but may be implemented in various different forms. The following example embodiments are provided to inform those skilled in the art. Throughout the disclosure, the same or like reference signs indicate the same or like elements.

Low density parity check (LDPC) codes, first introduced by Gallager in the 1960s, were long forgotten due to the complexity that made them difficult to implement with the technology available at the time. However, following the demonstration that turbo codes, proposed by Berrou, Glavieux, and Thitimajshima in 1993, achieve performance approaching the Shannon channel capacity, numerous interpretations of the performance and characteristics of turbo codes have been conducted, leading to extensive research on iterative decoding and graph-based channel encoding. As a result, with the renewed study of LDPC codes in the late 1990s, it was shown that decoding LDPC codes by applying iterative decoding based on the sum-product algorithm on the corresponding Tanner graph enables LDPC codes to also achieve performance approaching the Shannon channel capacity.

LDPC codes are generally defined as a parity check matrix and may be represented using a bipartite graph, commonly referred to as a Tanner graph. Generally, LDPC codes are a type of parity check code and are called "low-density" parity check codes because, in the parity check matrix corresponding to very long lengths, the proportion of 1s (e.g., the density) is very low. Therefore, the techniques based on LDPC codes in the disclosure may be easily extended to general parity check matrix codes.

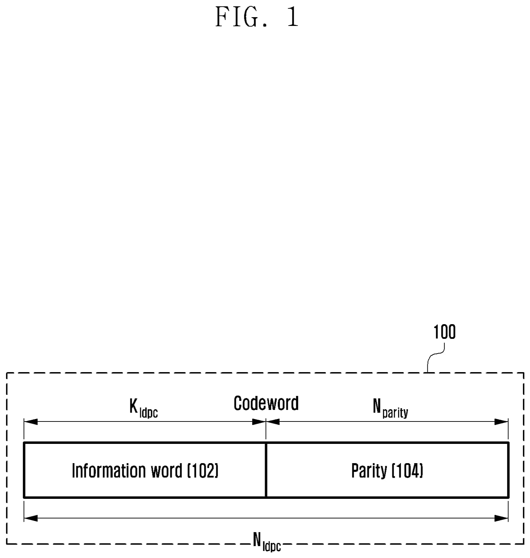

FIG. 1 is a diagram illustrating an example systematic LDPC codeword structure according to various example embodiments.

According to FIG. 1, an apparatus performing LDPC encoding receives an information word 102 including $K_{LDPC}$ bits or symbols and performs encoding to generate a codeword 100 including $N_{LDPC}$ bits or symbols. For convenience of explanation below, it is assumed that an information word 102 including $K_{LDPC}$ bits is input and a codeword 100 of $N_{LDPC}$ bits is generated. For example, when encoding the information word $\underline{i} = (i_0, i_1, i_2, ..., i_{K_{ldpc}-1})$ 102, which is an input of $K_{LDPC}$ bits, a codeword $\underline{c} = (c_0, c_1, c_2, ..., c_{N_{ldpc}-1})$ 100 is generated. For example, the information word and the codeword are bit strings of multiple bits, and the information bits and codeword bits represent the respective bits that include the information word and codeword. Typically, if the LDPC encoded bits include an information word, such as:

$$\underline{c} = \left( c_0, c_1, c_2, ..., c_{N_{ldpc}-1} \right) = \left( \underline{i}, \underline{w} \right) =$$

$$(i_0, i_1, i_2, ..., i_{K_{ldpc}-1}, w_0, w_1, w_2, ..., w_{N_{ldpc}-K_{ldpc}-1}),$$

This may be referred to as a systematic code. Here, $\underline{w} = [w_0\ w_1\ w_2\ ... \ w_{N_{ldpc}-K_{ldpc}}-1]$ is parity bits 104, and the number of parity bits, $N_{parity}$, may be expressed as $N_{parity} = N_{LDPC} - K_{LDPC}$.

An LDPC code is a type of linear block code and involves a process of determining a codeword that satisfies the conditions in Equation 1 below.

[Equation 1]

$$H \cdot \underline{c}^T = \begin{bmatrix} h_0 & h_1 & h_2 & \cdots & h_{N_{ldpc}-1} \end{bmatrix} \cdot \underline{c}^T = \sum_{i=0}^{N_{ldpc}-1} c_i \cdot h_i = \underline{0}$$

Here, $\underline{c} = [c_0\ c_1\ c_2\ ... \ c_{N_{ldpc}-1}]$.

In Equation 1, H represents a parity check matrix, c represents a codeword, $c_i$ represents the $i^{th}$ bit of the codeword, $N_{LDPC}$ represents the LDPC codeword length, and $h_i$ represents the $i^{th}$ column of the parity check matrix H.

The parity check matrix H includes $N_{LDPC}$ columns, which is equal to the number of bits of the LDPC codeword. Equation 1 indicates that the sum of the products of the $i^{th}$ column ($h_i$) of the parity check matrix and the $i^{th}$ codeword bit $c_i$ is "0", meaning that the $i^{th}$ column ($h_i$) is related to the $i^{th}$ codeword bit $c_i$.

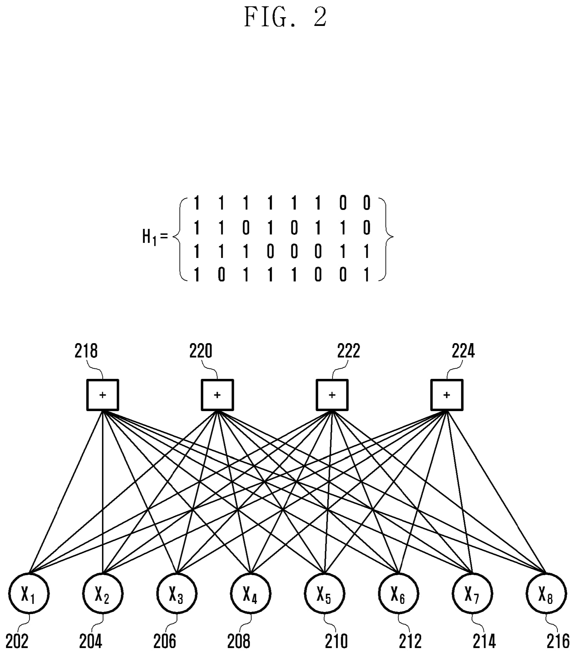

FIG. 2 is a diagram illustrating a graphical representation method of an LDPC code according to various example embodiments.

The graphical representation method for an LDPC code will be described with reference to FIG. 2.

FIG. 2 shows an example of the parity check matrix $H_1$ of an LDPC code of 4 rows and 8 columns, and its Tanner graph representation. Referring to FIG. 2, since the parity check matrix $H_1$ has 8 columns, a codeword with a length of 8 is generated. The code generated through $H_1$ represents an LDPC code, and each column corresponds to 8 encoded bits.

Referring to FIG. 2, the Tanner graph of the LDPC code, encoded and decoded based on the parity check matrix $H_1$, includes 8 variable nodes, e.g., $x_1$ (202), $x_2$ (204), $x_3$ (206), $x_4$ (208), $x_5$ (210, $x_6$ (212), $x_7$ (214), and $x_8$ (216), and 4 check nodes 218, 220, 222, and 224. The $i^{th}$ column and the $j^{th}$ row of the parity check matrix $H_1$ of the LDPC code correspond to the variable node $x_i$ and the $j^{th}$ check node, respectively. The value of 1, e.g., a non-zero value, at the point where the $i^{th}$ column and the $j^{th}$ row of the parity check matrix $H_1$ of the LDPC code intersect may refer, for example, to there being an edge connecting the variable node $x_i$ and the $j^{th}$ check node in the Tanner graph, as shown in FIG. 2.

The degree of the variable node and the check node in the Tanner graph of the LDPC code indicates the number of edges connected to the respective nodes, which is equal to the number of non-zero entries in the column or row corresponding to the node in the parity check matrix of the LDPC code. For example, in FIG. 2, the degrees of variable

nodes $x_1$ (202), $x_2$ (204), $x_3$ (206), $x_4$ (208), $x_5$ (210, $x_6$ (212), $x_7$ (214), and $x_8$ (216) are 4, 3, 3, 3, 2, 2, 2, 2, respectively, and the degrees of check nodes 218, 220, 222, and 224 are 6, 5, 5, 5, respectively, in that order. The number of non-zero entries in each column of the parity check matrix $H_1$ in FIG. 2 corresponding to the variable nodes in FIG. 2 matches the degrees of the aforementioned variable nodes, which are 4, 3, 3, 3, 2, 2, 2, 2, in that order, and the number of non-zero entries in each row of the parity check matrix $H_1$ in FIG. 2 corresponding to the check nodes in FIG. 2 matches the degrees of the aforementioned check nodes, which are 6, 5, 5, 5, in that order. For this reason, the degree of each variable node is also referred to as a column degree or column weight, and the degree of the check node is also referred to as a row degree or row weight.

The LDPC-encoded codeword bits may be decoded based on an iterative decoding algorithm based on a sum-product algorithm on the bipartite graph listed in FIG. 2. The sum-product algorithm may refer, for example, to a type of message passing algorithm, which is an algorithm that exchanges messages through edges in a bipartite graph and calculates and updates the output message from the messages input to the variable node or check node.

The value of the $i^{th}$ encoded bit may be determined based on the message of the $i^{th}$ variable node. Both hard decision and soft decision methods may be used to determine the value of the $i^{th}$ encoded bit. Therefore, the performance of $c_i$, the $i^{th}$ bit of an LDPC codeword, corresponds to the performance of the $i^{th}$ variable node of the Tanner graph, which may be determined by the position and number of 1s in the $i^{th}$ column of the parity check matrix. In other words, the performance of the $N_{LDPC}$ codeword bits of a codeword may be influenced by the position and number of 1s in the parity check matrix, which may refer, for example, to the performance of an LDPC code being significantly affected by the parity check matrix. Therefore, to design a high-performance LDPC code, a method for designing a good parity check matrix may be needed.

For ease of implementation, the parity check matrix used in communication and broadcasting systems is typically a quasi-cyclic LDPC code (or QC-LDPC code) (hereinafter referred to as QC-LDPC code) using a quasi-cyclic parity check matrix. Some communications and broadcasting systems use a parity check matrix that, while not completely a quasi-circular structure, closely resembles a quasi-circular structure. Although such LDPC codes may not be strictly classified as QC-LDPC codes from an algebraic perspective, for convenience they are sometimes categorized as QC-LDPC codes.

A typical QC-LDPC code is characterized by a parity check matrix of a small square matrix, either a 0-matrix (zero matrix) or circulant permutation matrices (or circular permutation matrices). In this case, a permutation matrix indicates a matrix in which each row or column contains only a single 1, with all other entries being 0. A circulant permutation matrix is a matrix in which each entry of the identity matrix is cyclically shifted to the right or left. Typically, the identity matrix itself is also considered a circulant permutation matrix, because each of its entries may be regarded as having undergone zero cyclic shifts. Therefore, the circulant permutation matrix basically includes the identity matrix, but for convenience of explanation, it may also be expressed by distinguishing between the identity matrix and the circulant permutation matrix, which is not an identity matrix.

Hereinafter, the QC-LDPC code will be described in detail.

A circulant permutation matrix P = ($P_{i,j}$) of size Z×Z is defined as shown in Equation 2. Here, $P_{i,j}$ represents the entry of the $i^{th}$ row and the $j^{th}$ column in the matrix P. $(0 \leq i,j < Z)$

[Equation 2-1]

$$P_{i,j} = \begin{cases} 1 & \text{if } i + 1 \equiv j \ (\text{mod } Z) \\ 0 & \text{otherwise.} \end{cases}$$

For the permutation matrix P defined as above, $P^i$ $(0 \leq i < Z)$ is a circulant permutation matrix obtained by circularly shifting the entries of an identity matrix of size Z×Z to the right by i times. The circulant permutation matrix may also be defined as in [Equation 2-2]. In this case, $P^i$ is a circulant permutation matrix obtained by circularly shifting the entries of an identity matrix of size Z×Z to the left by i times.

[Equation 2-2]

$$P_{i,j} = \begin{cases} 1 & \text{if } i \equiv j + 1 \ (\text{mod } Z) \\ 0 & \text{otherwise.} \end{cases}$$

In the disclosure, for convenience, the circulant permutation matrix defined based on [Equation 2-1] will be used to explain various example embodiments. However, the circulant permutation matrices defined in [Equation 2-1] and [Equation 2-2] share the same basic algebraic properties, although their representations differ. Therefore, the circulant permutation matrix defined based on Equation 2-2 may be used in the various example embodiments of the disclosure, or various circulant permutation matrices with the same algebraic properties may be used.

A simple parity check matrix H of the QC-LDPC code may be expressed in the following Equation 3.

[Equation 3]

$$H = \begin{bmatrix} P^{V_{1,1}} & P^{V_{1,2}} & \cdots & P^{V_{1,n_b}} \\ P^{V_{2,1}} & P^{V_{2,2}} & \cdots & P^{V_{2,n_b}} \\ \vdots & \vdots & \ddots & \vdots \\ P^{V_{m_b,1}} & P^{V_{m_b,2}} & \cdots & P^{V_{m_b,n_b}} \end{bmatrix}$$

For convenience, if $P^{-1}$ is defined as a 0-matrix of size $Z \times Z$, in Equation 3 above, each index $V_{i,j}$ of the circulant permutation matrix or 0-matrix has one of the values $\{-1, 0, 1, 2, ..., Z-1\}$. The identity matrix may be represented by $P^0$ or $I$, and the 0-matrix may be represented by $P^{-1}$ or O. Furthermore, since the parity check matrix H in Equation 3 has $n_b$ column blocks and $m_b$ row blocks, the size of the parity check matrix H is $n_b Z \, m_b Z$

If the parity check matrix of Equation 3 has full rank (e.g., full-rank), the length of the information bits of the QC-LDPC code corresponding to the parity check matrix is $(n_b - m_b)Z$ . For convenience, the $k_b = n_b - m_b$) column blocks corresponding to the information bits are called information word column blocks, the number of information bits is $k_b Z m_b$ column blocks corresponding to the remaining parity bits are called parity column blocks. In this case, the number of parity bits is $m_b Z$ does not have the full rank, the information bits are greater than $(n_b - m_b)Z$, the number of information bits is greater than $k_b Z m_b Z$

Typically, a binary matrix of size $m_b \times n_b$ obtained by replacing each circulant permutation matrix and 0-matrix in the parity check matrix of Equation 3 with 1 and 0, respectively, is called the mother matrix, base matrix, or base graph of the parity check matrix H and is expressed as M(H) or $H_{BG}$. In addition, an integer matrix of size $m_b \times n_b$ obtained by selecting the exponent of each circulant permutation matrix or 0-matrix as in Equation 4 is called the exponent matrix V(H) of the parity check matrix H.

[Equation 4]

$$V(H) = \begin{bmatrix} V_{1,1} & V_{1,2} & \cdots & V_{1,n_b} \\ V_{2,1} & V_{2,2} & \cdots & V_{2,n_b} \\ \vdots & \vdots & \ddots & \vdots \\ V_{m_b,1} & V_{m_b,2} & \cdots & V_{m_b,n_b} \end{bmatrix}$$

These matrix names are just examples, and the exponent matrix V(H) may be called by other names. For example, since the exponent of each circulant permutation matrix corresponds to a value that circularly shifts the identity matrix, as in [Equation 2-1] or [Equation 2-2], each exponent may be called a shift value (or circular shift value), and V(H) may also be called a circular shift value matrix or shift value matrix. In general, when an exponent matrix or a shift value matrix and a value Z corresponding to the size of a circulant permutation matrix or a zero matrix are given, a parity check matrix may be determined or identified. For this reason, according to the mathematical definition, the parity check matrix is a binary matrix H that satisfies the conditions of Equation 1. However, for convenience, the exponent matrix or shift value matrix may also be referred to as the parity check matrix.

Since a single integer contained in the exponent matrix or shift value matrix corresponds to a circulant permutation matrix in the parity check matrix, the exponent matrix may also be conveniently expressed as a sequence of integers. Generally, the parity check matrix may be expressed not only as an exponent matrix but also as various sequences that may express algebraically identical properties. Although, the parity check matrix is expressed for convenience as a sequence indicating the position of 1 within the exponent matrix or parity check matrix in the disclosure, there are various sequence notations that may distinguish the positions of 1s or 0s included in the parity check matrix. Therefore, the disclosure is not limited to the method described herein and the parity check matrix may be expressed in the form of various sequences or matrices that produce the algebraically identical effect. The above sequence may be referred to in various ways, such as an LDPC sequence, an LDPC code sequence, an LDPC sequence, a parity check matrix sequence, or a (circular) shift value sequence, to distinguish it from other sequences.

Although a transmitting/receiving apparatus may directly generate a parity check matrix to perform LDPC encoding and decoding, LDPC encoding and decoding may also be performed based on the exponent matrix, shift value matrix, or sequence that achieves the same algebraic effect as the parity check matrix, depending on implementation characteristics. Therefore, although the disclosure conveniently describes encoding and decoding using a parity check matrix for convenience, actual transmitting/receiving apparatuses may implement encoding and decoding using various methods that achieve the same effect as the parity check matrix.

For reference, the "algebraically identical effect" may refer, for example, to two or more different representations that can be described or converted to each other as being completely equivalent, either logically or mathematically. For example, for codes that may be defined by a matrix, such as LDPC codes, this may indicate, for example, that algebraic values defined by the matrix, such as a minimum distance, a rank, and cycle characteristics on a Tanner graph, are identical, or may refer, for example, to a basic structure or operation in the encoding/decoding process being identical. For example, if the same matrix is obtained through appropriate column and row permutations, the two matrices may be considered algebraically identical from a code perspective. Furthermore, various transposes that do not alter the actual characteristics of the code may produce algebraically identical effects.

As an example, given the following matrix A, examples of various transformations that produce algebraically identical effects are shown in A1 to A8.

$$A = \begin{bmatrix} P^{a_{1,1}} & P^{a_{1,2}} & P^{a_{1,3}} & P^{a_{1,4}} \\ P^{a_{2,1}} & P^{a_{2,2}} & P^{a_{2,3}} & P^{a_{2,4}} \\ P^{a_{3,1}} & P^{a_{3,2}} & P^{a_{3,3}} & P^{a_{3,4}} \\ P^{a_{4,1}} & P^{a_{4,2}} & P^{a_{4,3}} & P^{a_{4,4}} \end{bmatrix}$$

$$A_1 = \begin{bmatrix} P^{a_{1,1}} & P^{a_{1,3}} & P^{a_{1,2}} & P^{a_{1,4}} \\ P^{a_{2,1}} & P^{a_{2,3}} & P^{a_{2,2}} & P^{a_{2,4}} \\ P^{a_{3,1}} & P^{a_{3,3}} & P^{a_{3,2}} & P^{a_{3,4}} \\ P^{a_{4,1}} & P^{a_{4,3}} & P^{a_{4,2}} & P^{a_{4,4}} \end{bmatrix}, \quad A_2 = \begin{bmatrix} P^{a_{3,1}} & P^{a_{3,3}} & P^{a_{3,2}} & P^{a_{3,4}} \\ P^{a_{2,1}} & P^{a_{2,3}} & P^{a_{2,2}} & P^{a_{2,4}} \\ P^{a_{1,1}} & P^{a_{1,3}} & P^{a_{1,2}} & P^{a_{1,4}} \\ P^{a_{4,1}} & P^{a_{4,3}} & P^{a_{4,2}} & P^{a_{4,4}} \end{bmatrix}$$

$$A_3 = \begin{bmatrix} P^{a_{1,1}+x} & P^{a_{1,2}} & P^{a_{1,3}+y} & P^{a_{1,4}} \\ P^{a_{2,1}+x} & P^{a_{2,2}} & P^{a_{2,3}+y} & P^{a_{2,4}} \\ P^{a_{3,1}+x} & P^{a_{3,2}} & P^{a_{3,3}+y} & P^{a_{3,4}} \\ P^{a_{4,1}+x} & P^{a_{4,2}} & P^{a_{4,3}+y} & P^{a_{4,4}} \end{bmatrix}$$

$$A_4 = \begin{bmatrix} P^{a_{1,1}+x} & P^{a_{1,2}} & P^{a_{1,3}+y} & P^{a_{1,4}} \\ P^{a_{2,1}+x+z} & P^{a_{2,2}+z} & P^{a_{2,3}+y+z} & P^{a_{2,4}+z} \\ P^{a_{3,1}+x} & P^{a_{3,2}} & P^{a_{3,3}+y} & P^{a_{3,4}} \\ P^{a_{4,1}+x+w} & P^{a_{4,2}+w} & P^{a_{4,3}+y+w} & P^{a_{4,4}+w} \end{bmatrix}$$

$$A_5 = \begin{bmatrix} P^{-a_{1,1}} & P^{-a_{2,1}} & P^{-a_{3,1}} & P^{-a_{4,1}} \\ P^{-a_{1,2}} & P^{-a_{2,2}} & P^{-a_{3,2}} & P^{-a_{4,2}} \\ P^{-a_{1,3}} & P^{-a_{2,3}} & P^{-a_{3,3}} & P^{-a_{4,3}} \\ P^{-a_{1,4}} & P^{-a_{2,4}} & P^{-a_{3,4}} & P^{-a_{4,4}} \end{bmatrix}$$

$$A_6 = \begin{bmatrix} P^{a_{1,1}} & P^{a_{2,1}} & P^{a_{3,1}} & P^{a_{4,1}} \\ P^{a_{1,2}} & P^{a_{2,2}} & P^{a_{3,2}} & P^{a_{4,2}} \\ P^{a_{1,3}} & P^{a_{2,3}} & P^{a_{3,3}} & P^{a_{4,3}} \\ P^{a_{1,4}} & P^{a_{2,4}} & P^{a_{3,4}} & P^{a_{4,4}} \end{bmatrix}$$

$$A_7 = \begin{bmatrix} P^{-a_{1,1}} & P^{-a_{1,2}} & P^{-a_{1,3}} & P^{-a_{1,4}} \\ P^{-a_{2,1}} & P^{-a_{2,2}} & P^{-a_{2,3}} & P^{-a_{2,4}} \\ P^{-a_{3,1}} & P^{-a_{3,2}} & P^{-a_{3,3}} & P^{-a_{3,4}} \\ P^{-a_{4,1}} & P^{-a_{4,2}} & P^{-a_{4,3}} & P^{-a_{4,4}} \end{bmatrix}$$

$$A_8 = \begin{bmatrix} P^{ka_{1,1}} & P^{ka_{1,2}} & P^{ka_{1,3}} & P^{ka_{1,4}} \\ P^{ka_{2,1}} & P^{ka_{2,2}} & P^{ka_{2,3}} & P^{ka_{2,4}} \\ P^{ka_{3,1}} & P^{ka_{3,2}} & P^{ka_{3,3}} & P^{ka_{3,4}} \\ P^{ka_{4,1}} & P^{ka_{4,2}} & P^{ka_{4,3}} & P^{ka_{4,4}} \end{bmatrix},$$

(where k is an integer coprime to Z)

$A_1$ is an example of a block-wise permutation obtained by permuting the second column block and the third column block of $A$. $A_2$ is an example of a block-wise permutation obtained by further permuting the first row block and the third row block of $A_1$. $A_3$ is an example of applying a circular permutation to only the first column block and third column block of $A$. $A_4$ is an example of applying a circular permutation to only the second row block and fourth row block of $A_3$. $A_5$ is an example of applying a transpose transformation to $A$. $A_6$ is an example of applying a block-wise transpose transformation to $A$. $A_7$ is an example of reversing the signs of each exponent (or circular shift value) for A (however, for convenience, when expressing a 0-matrix of size $Z \times Z$ as $P^{-1}$, using negative exponents (or shift values) may be confusing, so ($-a_{i,j}$) may also be expressed as a positive value, such as ($Z - a_{i,j}$). $A_8$ is an example of applying an affine transformation with a constant term of 0 to A (in general, it may also be applied when the constant term is not 0). For reference, although the above examples have been described, for convenience, with respect to a case in which there is no entry where $P^{a_{i,j}}$ is a 0-matrix of size $Z \times Z$, if a 0-matrix is included, a portion corresponding to the 0-matrix is always a zero matrix regardless of the transformation. For example, if $P^{a2,3}$ is a 0-matrix in A, then $P^{a2,3}$ is also a 0-matrix in $A_1$, $A_2$, and $A_6$. $P^{a2,3+y}$ and $P^{a2,3+y+z}$ are 0-matrices in $A_3$ and $A_4$, respectively, $P^{-a2,3}$ is a 0-matrix in $A_5$ and $A_7$, and $P^{ka2,3}$ is a 0-matrix in $A_8$.

The above transformations are merely examples, and various other transformations may exist. Furthermore, the respective transformations may be applied independently, but they may also be applied in appropriate overlaps and combinations. The characteristic of respective transformations or combination of transformations is that it may be converted back to the original matrix through an appropriate invertible transform process.

Since the various transformations or combinations of the transformations described above are substantially reversible transformations in which, on a Tanner graph, the arrangement of bits (or variable nodes) or check nodes is merely changed, or symmetric transformations or specific structures are maintained, in terms of code performance, although instantaneous performance may vary depending on a given channel condition, the transformations may provide the same performance on average. In this disclosure, all parity check matrices obtained through transformations that achieve algebraically identical effects are considered as the same parity check matrix.

Although the case where a single circulant permutation matrix corresponds to a single square block of size $Z \times Z$ has been described above for convenience, the disclosure may also be applied to cases where multiple circulant permutation matrices are included in a single block. For example, when two circulant permutation matrices $P^{V_{ij}^{(1)}}$ and $P^{V_{ij}^{(2)}}$ correspond to the positions of one $i^{\text{th}}$ row block and $j^{\text{th}}$ column block as in Equation 5 below, it may be simply expressed in the form of a sum as $P^{V_{ij}^{(1)}} + P^{V_{ij}^{(2)}}$, and its exponent matrix (or circular shift value matrix) may be expressed as in Equation 6. Referring to Equation 6, it can be seen that it is a matrix in which two integers correspond to the $i^{\text{th}}$ row and $j^{\text{th}}$ column corresponding to the row block and column block including the sum of the multiple circulant permutation matrices.

[Equation 5]

$$H = \begin{bmatrix} \square & \square & \square & \square \\ \square & P^{V_{i,j}^{(1)}} + P^{V_{i,j}^{(2)}} & \square & \square \\ \square & \square & \square & \square \\ \square & \square & \square & \square \end{bmatrix}$$

[Equation 6]

$$V(H) = \begin{bmatrix} \square & \square & \square & \square \\ \square & \left( V_{i,j}^{(1)}, V_{i,j}^{(2)} \right) & \square & \square \\ \square & \square & \square & \square \\ \square & \square & \square & \square \end{bmatrix}$$

As described in the above embodiment, a QC-LDPC code may typically have one or more circulant permutation matrices corresponding to a single row block and column block in the parity check matrix. For reference, a matrix of size $Z \times Z$ with multiple circulant permutation matrices overlapping in a single row block and column block is called a circulant matrix (or circular matrix). In general, a circulant matrix may have entries that are not only binary but also arbitrary numbers. However, in the disclosure, binary codes are described for convenience, so the circulant matrix herein refers to a binary circulant matrix. In addition, the algebraic structure and features of the disclosure may be similarly extended to non-binary codes, but detailed descriptions thereof will be omitted herein.

The base matrix (or mother matrix or base graph) for the parity check matrix and exponent matrix (or circular shift value matrix) of Equations 5 and 6 refers to a binary matrix obtained by replacing each circulant permutation matrix and 0-matrix with 1 and 0, respectively, similar to the definition used in Equation 3. A circulant matrix included in a single block (e.g., the sum of multiple circulant permutation matrices) may also be replaced with 1.

A simple example of the relationship among the parity check matrix, the exponent matrix (or circular shift value matrix), and the base matrix is shown in Equation 7 below.

[Equation 7]

$$H_1 = \begin{bmatrix} P^{159} & O & P^0 & P^0 & O & O \\ P^{117} & P^{109} & O & P^0 & P^0 & O \\ O & P^{225} & P^1 & O & P^0 & P^0 \\ P^{84} & P^{211} & P^0 & O & O & P^0 \end{bmatrix} \left( = \right.$$

$$\left. \begin{bmatrix} P^{159} & O & I & I & O & O \\ P^{117} & P^{109} & O & I & I & O \\ O & P^{225} & P^1 & O & I & I \\ P^{84} & P^{211} & I & O & O & I \end{bmatrix} \right),$$

$$M(H_1) = \begin{bmatrix} 1 & 0 & 1 & 1 & 0 & 0 \\ 1 & 1 & 0 & 1 & 1 & 0 \\ 0 & 1 & 1 & 0 & 1 & 1 \\ 1 & 1 & 1 & 0 & 0 & 1 \end{bmatrix},$$

$$V(H_1) = \begin{bmatrix} 159 & -1 & 0 & 0 & -1 & -1 \\ 117 & 109 & -1 & 0 & 0 & -1 \\ -1 & 225 & 1 & -1 & 0 & 0 \\ 84 & 211 & 0 & -1 & -1 & 0 \end{bmatrix}.$$

In the above [Equation 7], representing the exponent (or the shift value) of the 0-matrix of size $Z \times Z$ as -1 is merely an example, and it may be expressed in various ways. Furthermore, the matrix representation of [Equation 7] may be expressed in various other ways. As an example, the representation method of the parity check matrix of the LDPC code defined in 3GPP TS 38.212, the 3GPP 5G standard, may be used. In 3GPP TS 38.212, the parity check matrices of the LDPC code corresponding to BG1 (Base Graph 1) and BG2 (Base Graph 2) are so large that they are represented using a table. Applying this representation method to the matrices of [Equation 7] above results in the following [Table 1].

$H_{BG1}$ is a 4×8 matrix, and H_1 is a 4Z×8Z matrix. Entries of the base matrix (or base graph) and parity check matrices not represented in Table 1 below correspond to 0 or a 0-matrix of size Z×Z.

[Table 1]

| $H_{BG1}$ | | $V_{i,j}$ |
|---|---|---|
| Row index i | Column index j | |
| 0 | 0 | 159 |
| | 2 | 0 |
| | 3 | 0 |
| 1 | 0 | 117 |
| | 1 | 109 |
| | 3 | 0 |
| | 4 | 0 |

(continued)

| $H_{BG1}$ | | $V_{i,j}$ |
|---|---|---|
| Row index i | Column index j | |
| 2 | 1 | 225 |
| | 2 | 1 |
| | 4 | 0 |
| | 5 | 0 |
| 3 | 0 | 84 |
| | 1 | 211 |
| | 2 | 0 |
| | 5 | 0 |

If the base matrix and exponent matrix in [Equation 7] above are expressed using sequences, they may be expressed as follows.

$M(H_1)$:
023
0 1 3 4
1245
0 1 2 5
$V(H_1)$:
159 0 0
117 10900
225 1 0 0
8421100

As described above, when the exponent matrix $V(H_1)$ is expressed as a sequence, it may be conveniently named in various ways, such as shift sequence, shift value sequence, or LDPC sequence. In the sequence representation above, $M(H_1)$ indicates a method of listing the positions of non-zero columns for each row, while $V(H_1)$ indicates a method of listing the exponents or shift values of respective circulant permutation matrices, not a 0-matrix, for each row. From the above sequences, the exponent matrix (or shift value matrix) may be precisely defined, and if information about the Z value is obtained, the parity check matrix may also be precisely defined.

Another simple example of the relationship among the parity check matrix, the exponent matrix (or circular shift value matrix), and the base matrix is shown in [Equation 8]. The example in [Equation 8] illustrates a case where the parity check matrix includes a circulant matrix in which at least one Z×Z block corresponds to two or more circulant permutation matrices.

[Equation 8]

$$H_2 = \begin{bmatrix} P^{117} + P^{159} & P^{109} & P^0 & P^0 \\ P^{84} & P^{211} + P^{225} & P^1 + P^3 & P^0 \end{bmatrix},$$

$$M(H_2) = \begin{bmatrix} 1 & 1 & 1 & 1 \\ 1 & 1 & 1 & 1 \end{bmatrix},$$

$$V(H_2) = \begin{bmatrix} 117, 159 & 109 & 0 & 0 \\ 84 & 211, 225 & 1, 3 & 0 \end{bmatrix},$$

$$W(H_2) = \begin{bmatrix} 2 & 1 & 1 & 1 \\ 1 & 2 & 2 & 1 \end{bmatrix}.$$

For reference, in [Equation 8] above, $W(H_2)$ is a weight matrix for the base matrix, exponent matrix, or parity check matrix, and is a matrix that shows how many circulant permutation matrices correspond to the $i^{th}$ row and $j^{th}$ column in the base matrix and exponent matrix, or to the $i^{th}$ row block and $j^{th}$ column block in the parity check matrix. For example, $W(H_2)$ is a matrix that represents the number of circulant permutation matrices that include a $Z \times Z$ circulant matrix corresponding to the $i^{th}$ row block and $j^{th}$ column block in the parity check matrix, as entries of the $i^{th}$ row and $j^{th}$ column. That is, $W(H_2)$ is a matrix that represents the entries by 0 when a 0-matrix corresponds and w when w circulant permutation matrices correspond, respectively. (For reference, the 0-matrix may be broadly considered a circular matrix, but it is not a circular "permutation" matrix.)

When the base matrix, parity check matrix, or circular shift value matrix (or exponent matrix) defined in [Equation 8] is expressed by applying the method of representing parity check matrices of an LDPC code in 3GPP TS 38.212, as shown in [Table 1], it may be expressed as shown in [Table 2].

$H_{BG2}$ is a 2×4 matrix, and $H_2$ is a 2Z×4Z matrix. Entries of the base matrix (or base graph) and parity check matrices not represented in Table 2 correspond to 0 or a 0-matrix of size $Z \times Z$.

[Table 2]

| $H_{BG2}$ | | $V_{i,j}$ |
|---|---|---|
| Row index i | Column index j | |
| 0 | 0 | 117,159 |
| | 1 | 109 |
| | 2 | 0 |
| | 3 | 0 |
| 1 | 0 | 84 |
| | 1 | 211, 225 |
| | 2 | 1, 3 |
| | 3 | 0 |

When the base matrix and exponent matrix of [Equation 8] are expressed using sequences, they may be expressed as follows.

$M(H_2)$:
0 1 2 3
0 1 2 3
$V(H_2)$:
(117, 159) 109 0 0
84 (211, 225) (1, 3) 0

The weight matrix may be used to express the matrix using only sequences, as follows.

$M(H_2)$:
0 1 2 3
0 1 2 3
$W(H_2)$:
2 1 1 1
1 2 2 1
$V(H_2)$:
117 159 109 0 0
84 211 225 1 3 0

In the above representation, $M(H_2)$ is a method of listing the positions of non-zero columns for each row, $W(H_2)$ is a matrix defined based on the number of circulant permutation matrices that comprise the circulant matrices corresponding to the base matrix, exponent matrix, or parity check matrix, and $V(H_2)$ is a method of listing the exponents or shift values of each non-zero circulant matrix for each row. The exponent matrix may be precisely defined from the above sequences, and if information about the Z value is obtained, the parity check matrix may also be precisely defined.

Since the performance of an LDPC code depends on the parity check matrix, designing a parity check matrix is required to achieve high-performance LDPC codes. Furthermore, an LDPC encoding or decoding method capable of supporting various input lengths and code rates is required.

Lifting is not only used for the efficient design of QC-LDPC codes, but may also refer to a method used to generate parity check matrices of various lengths or LDPC codewords using a given base matrix and exponent matrix. In other words, lifting may be applied to efficiently design very large parity check matrices by setting the Z value, which determines the size of the circulant permutation matrix or 0-matrix from a given small matrix, according to specific rules. Alternatively, lifting may refer to a method for generating parity check matrices of various lengths or LDPC codewords by applying an appropriate Z value to a given exponent matrix or its corresponding sequence.

The characteristics of existing lifting methods and QC-LDPC codes designed using lifting are briefly described with reference to the following reference [Myung2006].

Reference [Myung2006]

S. Myung, K. Yang, and Y. Kim, "Lifting Methods for Quasi-Circular LDPC codes," IEEE Communications Letters. vol. 10, pp. 489-491, June 2006.

Given an LDPC code $C_0$, and it is assuming that S QC-LDPC codes to be designed using the lifting method are $C_1$, ..., $C_S$, and the values corresponding to the row and column block sizes of the parity check matrix of each QC-LDPC code are $L_k$. $C_0$ is the smallest LDPC code whose parity check matrix is the mother matrix of the $C_1$, ..., $C_S$ codes, and the value $Z_0$ corresponding to the row and column block sizes is 1. In addition, for convenience, the parity check matrix $H_k$ of each code $C_k$ has an exponent matrix $V(H_k) = \left( V_{ij}^{(k)} \right)$ of size m $\times$ $n$, and each exponent $V_{i,j}^{(k)}$ is selected as one of the values {-1, 0, 1, 2, ..., $Z_k$ - 1}.

The existing lifting method includes steps such as $C_0$ -> $C_1$ -> ...-> $C_S$ and has the characteristic of satisfying the condition $Z_{k+1} = q_{k+1}Z_k$ ($q_{k+1}$ is a positive integer, k = 0, 1, ..., S-1). Furthermore, due to the characteristics of the lifting process, if only the parity check matrix $H_S$ of $C_S$ is stored, all of the QC-LDPC codes $C_0, C_1, ..., C_S$ may be represented using the following Equation 9 or Equation 10, depending on the lifting method.

$$[\text{Equation 9}]$$

$$V(\text{H}_k) \equiv \left\lfloor \frac{Z_k}{Z_S} V(\text{H}_S) \right\rfloor$$

or

$$[\text{Equation 10}]$$

$$V(\text{H}_k) \equiv V(\text{H}_S) \ (\text{mod } Z_k)$$

As described above, in addition to designing larger QC-LDPC codes $C_1$, ..., $C_S$ from $C_0$, the method of generating smaller codes $C_i$ (i=k-1, k-2, ..., 1, 0) from larger codes $C_k$ using an appropriate method, as in Equation 9 or Equation 10, may also be called "lifting." For reference, 3GPP TS 38.212 allows LDPC codes of various lengths to be generated using the lifting method of Equation 10.

The lifting method of Equation 9 or 10 causes the $Z_k$ values, corresponding to the sizes of the row or column blocks in the parity check matrix of each QC-LDPC code $C_k$, to have a multiple relationship, and thus the exponent matrix is also selected using a specific method. Existing lifting methods described above facilitate the design of QC-LDPC codes with improved error floor characteristics by improving the algebraic or graph characteristics of each parity check matrix designed through lifting.

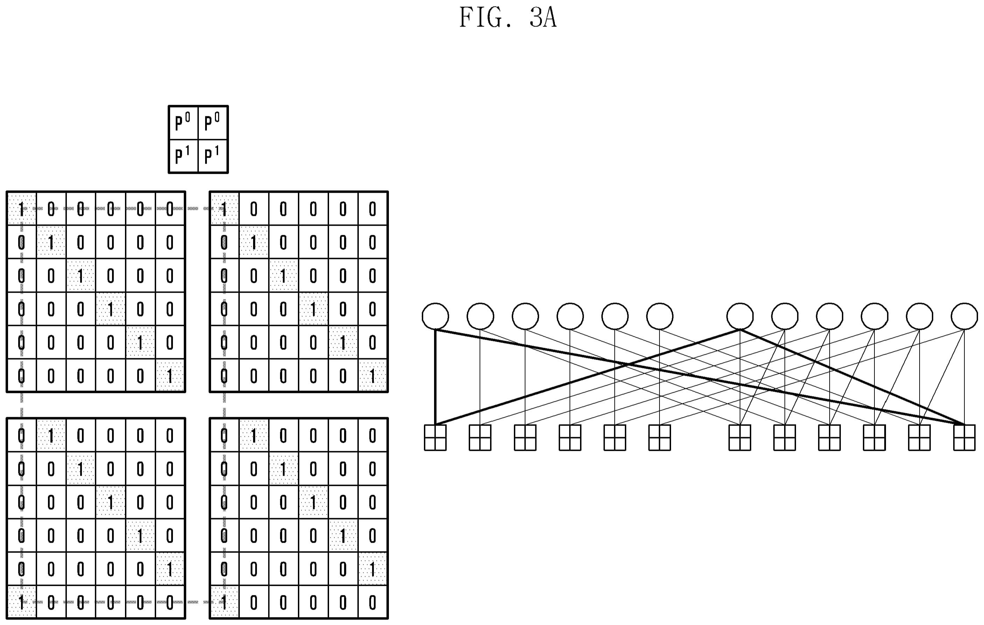

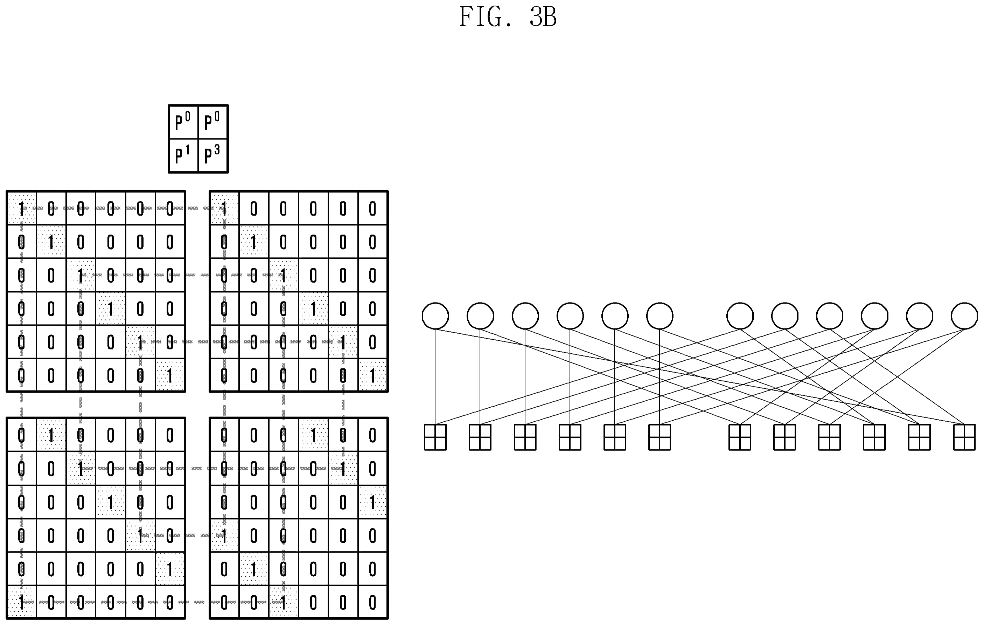

FIGS. 3A and 3B are diagrams that illustrating how the cycle characteristics may vary significantly depending on the exponent matrix of a QC-LDPC code according to various example embodiments.

FIG. 3A is a diagram illustrating the cycle characteristics of a QC-LDPC code according to various example embodiments.

The exponent matrix in FIG. 3A is $\begin{bmatrix} P^0 & P^0 \\ P^1 & P^1 \end{bmatrix}_{(Z=6)}$ , which may result in many 4-cycles in the Tanner graph. A code with many short cycles like this may result in severe decoding performance degradation.

FIG. 3B is a diagram illustrating the cycle characteristics of a QC-LDPC code according to various example embodiments.

The exponent matrix in FIG. 3B is $\begin{bmatrix} P^0 & P^0 \\ P^1 & P^3 \end{bmatrix}_{(Z=6)}$, which may result in the shortest cycle length in the Tanner graph being 12. As such, changing just one exponent of the circulant permutation matrix may significantly alter the cycle characteristics of the Tanner graph. Therefore, the selection of the exponent matrix plays a crucial role in improving the performance of LDPC codes. The lifting method may be regarded as one design method that considers these cycle characteristics.

In general, lifting may be thought of as using the exponent matrix of Equation 4 for LDPC encoding and decoding by changing the values of its entries for various Z values. For example, if the exponent matrix of Equation 4 is $V(H) = (V_{i,j})$, and the exponent matrix transformed using the Z value is $V(H(Z)) = (V_{i,j}(Z))$, the following transformation equation, as shown in Equation 11, may be applied.

[Equation 11]

$$V_{i,j}(Z) = \begin{cases} V_{i,j} & V_{i,j} < 0 \\ f(V_{i,j}, Z) & V_{i,j} \geq 0 \end{cases} \text{ or } V_{i,j}(Z) = \begin{cases} V_{i,j} & V_{i,j} \leq 0 \\ f(V_{i,j}, Z) & V_{i,j} > 0 \end{cases}$$

In the above Equation 11, $f(x,Z)$ may be defined in various forms. For example, the above [Equation 9] corresponds to $f(x, Z) = \left\lfloor \dfrac{Z}{Z_{\max}} x \right\rfloor$ $Z_{\max} = Z_S$, and the above [Equation 10] may correspond to $f(x,Z) = \text{mod}(x,Z)$ (mod(a,b) may refer to a modulo-b operation for a). In addition, $f(x,Z)$ may be defined in various ways, as shown in Equation 12 below.

[Equation 12]

$$f(x, Z) = \text{mod}(x, 2^{\lfloor \log_2 Z \rfloor})$$

or

$$f(x, Z) = \left\lfloor \frac{x}{2^{D - \lfloor \log_2 Z \rfloor}} \right\rfloor$$

or

$$f(x, Z) = \left\lfloor \frac{Z}{D} x \right\rfloor$$

In Equation 12 above, D is a constant, a predefined positive integer.

For reference, although the reference value for applying the transformation formula (or transformation function) f (or a reference value of $V_{i,j}$ to distinguish between the application of $V_{i,j}$ and $f(V_{i,j},Z)$) transformation Equation 11, this reference value may be set differently depending on the lifting size (Z) value to be supported or the method of representing the Z×Z 0-matrix. For example, if the Z×Z 0-matrix is defined not as a negative integer -1 but as a predetermined number or symbol, the reference value for applying the transformation formula f may be defined differently. Furthermore, when the representation of the exponent matrix or LDPC sequence is based on a method that excludes and does not represent the exponent corresponding to the 0-matrix from the beginning, the rule for values with exponents less than 0 in Equation 11 may be omitted. Since the transformation formula f is applied to a circulant permutation matrix or circulant matrix, not a 0-matrix, various methods for omitting transformations may be expressed for a 0-matrix of size Z × Z.

As an embodiment of the disclosure, a case where LDPC encoding and decoding are applied based on multiple exponent matrices or LDPC sequences based on a single determined base matrix will be described. For example, a single base matrix is fixed, and the exponent matrix, (circular) shift value matrix, or LDPC sequence of an LDPC code defined based on the base matrix may be determined. Furthermore, variable-length LDPC encoding and decoding are performed by applying lifting from the matrix or sequence to conform to the lifting sizes included in each lifting size group. This method has the characteristic that, while the entries or numbers of the exponent matrix or LDPC sequence of the LDPC code may have different values, the positions of the corresponding entries or numbers are exactly the same in the base matrix.

The LDPC code defined in TS 38.212, which is the 3GPP 5G standard, is also designed in the same way in which two base matrices $H_{BG}$ are defined, and for each base matrix, eight exponent matrices (or circular shift value matrices)

$$V\left(H_{i_{LS}}\right) = \left(V_{i,j}^{(i_{LS})}\right)$$ ($i_{LS}$= 0, 1, 2, ..., 7) are defined to be used for LDPC encoding. That is, according to the standard, the parity check matrix of various LDPC codes may be determined based on a total of two base matrices, 16 exponent matrices, and an appropriate lifting size Z. However, in TS 38.212, the matrix corresponding to $V(H_{i_{LS}})$ is named the parity check matrix, and the matrix corresponding to the typical parity check matrix is named matrix-H. Although $V(H_{i_{LS}})$ is a matrix including integers and a parity check matrix in a strict sense may be constructed only when a lifting size Z is given, $V(H_{i_{LS}})$ may also be referred to as a parity check matrix for convenience, as described above.

Hereinafter, although the LDPC code defined in the 3GPP 5G standard TS 38.212 and its representation will be used for convenience, conventional mathematical notations or other representations may also be used in some cases. The supported lifting sizes Z for determining the parity check matrix or matrix-H of an LDPC code are shown in [Table 3]. (The set index $i_{LS}$ for each lifting size set below is only an example and may be rearranged in a different order.)

[Table 3]

| Set index ($i_{LS}$) | Set of lifting sizes (Z) |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

In the disclosure, lifting sizes or block sizes are expressed in the same way as in [Table 3] above, but they may also be expressed in the way shown in [Table 4] below, and various other expression methods are also possible.

[Table 4]

| Set index ($i_{LS}$) | Set of lifting sizes (Z) |
|---|---|
| 0 | $2 \times 2^k$, $k$ = 0, 1, 2, ...,7 |
| 1 | $3 \times 2^k$, $k$ = 0, 1, 2, ..., 7 |
| 2 | $5 \times 2^k$, $k$ = 0, 1, 2, ..., 6 |
| 3 | $7 \times 2^k$, $k$ = 0, 1, 2, ..., 5 |
| 4 | $9 \times 2^k$, $k$ = 0, 1, 2, ..., 5 |
| 5 | $11 \times 2^k$, $k$ = 0, 1, 2, ..., 5 |
| 6 | $13 \times 2^k$, $k$ = 0, 1, 2, ..., 4 |
| 7 | $15 \times 2^k$, $k$ = 0, 1, 2, ..., 4 |

In 3GPP 5G, the lifting sizes or block sizes Z may be divided into multiple sets (or groups), as shown in [Table 3] or [Table 4], and then used. (Hereinafter, these will be referred to as lifting size sets (or groups) or block size sets (or groups) for convenience.)

In the 3GPP 5G standard, the parity check matrix or matrix-H is determined based on the exponent matrix V ($H_{i_{LS}}$ (Z)) $\equiv V(H_{i_{LS}})$ (mod Z), which may be obtained using the lifting method of [Equation 10]. This may refer to when

$$V\left(H_{i_{LS}}\right) = \left(V_{i,j}^{(i_{LS})}\right) \text{ and } V\left(H_{i_{LS}}(Z)\right) = \left(V_{i,j}^{(i_{LS})}(Z)\right), \ V_{i,j}^{(i_{LS})}(Z) = \text{mod}\left(V_{i,j}^{(i_{LS})}, Z\right) \text{ for each i, j. (For reference, in}$$

the 3GPP 5G standard TS 38.212, $V_{i,j}^{(i_{LS})}(Z)$ is simply expressed as $P_{i,j}$.)

Note that, as explained in [Equation 11] above, the disclosure does not apply any special transformation to the part of the base matrix and exponent matrix corresponding to the 0-matrix of size $Z \times Z$. For example, even in V $(H_{i_{LS}}(Z)) \equiv V$ $(H_{i_{LS}})$ (mod $Z$), unless otherwise specified, the part corresponding to the 0-matrix does not undergo any special transformation, and only the size of the 0-matrix may vary depending on the $Z$ value. As a specific example, in the representation used in the 3GPP 5G standard, as in [Table 1] and [Table 2], the part corresponding to the $Z \times Z$ 0-matrix is not initially represented. Therefore, if a predefined transformation, such as modulo, is appropriately performed only on $V_{i,j}$ included in [Table 1] or [Table 2], the part corresponding to the 0-matrix naturally does not undergo any transformation, which is identical to defining a 0-matrix with only a different size. The above representation is merely an example for the convenience of explanation, and various other representations may exist.

Since the parity check matrix or matrix-H for a given exponent matrix (or circular shift value matrix) may be transformed in various ways depending on the lifting sizes defined in [Table 3], the set of lifting sizes required may be defined differently depending on the system. For example, [Table 3] and [Table 4] are merely examples. All lifting size (Z) values included in the lifting size (or block size) groups (or sets) in [Table 3] and [Table 4] may be used, some appropriate lifting sizes may be selected and used depending on the system's requirements, or more lifting size values may be added as needed.

For example, when the minimum transport block size (TBS) is 24, $Z = 2, 3, 4, 5, 6, 9$, and 13 are practically never used in a system. In this case, some Z values may be excluded and defined, as shown in [Table 5].

[Table 5]

| Set index ($i_{LS}$) | Set of lifting sizes (Z) |
|---|---|
| 0 | {8, 16, 32, 64, 128, 256} |
| 1 | {12, 24, 48, 96, 192, 384} |
| 2 | {10, 20, 40, 80, 160, 320} |
| 3 | {7, 14, 28, 56, 112, 224} |
| 4 | {18, 36, 72, 144, 288} |
| 5 | {11, 22, 44, 88, 176, 352} |
| 6 | {26, 52, 104, 208} |
| 7 | {15, 30, 60, 120, 240} |

Since, in an LDPC code-based communication system that uses [Table 5] as the lifting sizes, the minimum lifting size is 7, each column block of the parity check matrix of the LDPC code used for LDPC encoding and decoding may include at least 7 columns.

If the minimum TBS value is 8 or higher for future scalability, and additional values such as 8 or 16 are used, the lifting size set (or block size group) may change as shown in [Table 6].

[Table 6]

| Set index ($i_{LS}$) | Set of lifting sizes (Z) |
|---|---|
| 0 | {4, 8, 16, 32, 64, 128, 256} |
| 1 | {6, 12, 24, 48, 96, 192, 384} |
| 2 | {(5,) 10, 20, 40, 80, 160, 320} |
| 3 | {7, 14, 28, 56, 112, 224} |
| 4 | {(9,) 18, 36, 72, 144, 288} |
| 5 | {11, 22, 44, 88, 176, 352} |
| 6 | {(13,) 26, 52, 104, 208} |
| 7 | {15, 30, 60, 120, 240} |

The above [Table 6] excludes cases where $Z = 2$ and 3 from [Table 3] or [Table 4]. This is due to the fact that the minimum Z value capable of being determined when TBS is 8 or greater is 4 or greater.

As another example of configuring a lifting size set, if the lifting size sets are classified into A sets $Z_1, Z_2, Z_3, ..., Z_A$,

the basic classification may be done in the following manner. (k=1, 2,...)

$$Z_1 = \{A, 2A, \ldots, 2^k A\}$$

$$Z_2 = \{(A+1), 2(A+1), \ldots, 2^k(A+1)\}$$

...

$$Z_i = \{(A+i-1), 2(A+i-1), \ldots, 2^k(A+i-1)\}$$

...

$$Z_A = \{2A-1, 2(2A-1), \ldots, 2^k(2A-1)\}$$

For example, examples for cases where A = 4 and A = 8 may be expressed as shown in [Table 7-1] and [Table 7-2]. (k=0, 1, 2,...)

[Table 7-1]

| Set of lifting sizes (Z) |
|---|
| 4, 8, 16, 32, ... (= 4 × $2^k$) |
| 5, 10, 20, 40, ... (= 5 × $2^k$) |
| 6, 12, 24, 48, ... (= 6 × $2^k$) |
| 7, 14, 28, 56, ... (= 7 × $2^k$) |

[Table 7-2]

| Set of lifting sizes (Z) |
|---|
| 8, 16, 32, 64, ... (= 8 × $2^k$) |
| 9, 18, 36, 72, ... (= 9 × $2^k$) |
| 10, 20, 40, 80, ... (= 10 × $2^k$) |
| 11, 22, 44, 88, ... (= 11 × $2^k$) |
| 12, 24, 48, 96, ... (= 12 × $2^k$) |
| 13, 26, 52, 108, ... (= 13 × $2^k$) |
| 14, 28, 56, 112, ... (= 14 × $2^k$) |
| 15, 30, 60, 120, ... (= 15 × $2^k$) |

When the lifting size set is defined as shown in [Table 7-1] and [Table 7-2] above, it has the advantage of establishing a relatively uniform distribution of Z values. The lifting size sets defined in [Table 7-1] and [Table 7-2] above all include the same number of Z values, but appropriate Z values may be added to or removed from each set as needed. For example, it is possible to define the lifting size sets in [Table 3] to [Table 6], based on the lifting size sets in [Table 7-2].
Furthermore, by appropriately configuring the range of k value in [Table 7-1] and [Table 7-2], Z values suitable for the system may be set. For example, configuring k as k = 0,1, ..., 6 yields a lifting size set with seven different Z values in each set, and configuring k as k = 3, 4, ..., 6 yields a lifting size set with four different Z values in each set. However, the k value is merely an example, and the example of k values does not limit the scope of the disclosure. Additionally, appropriate Z values may be added to or excluded from the lifting size sets, depending on the case. For example, if the maximum Z value set in the system is Zmax, all values greater than Zmax may be removed (e.g., Zmax = 768). Furthermore, if all Z values supported by the existing 3GPP 5G standard are included, at least part of the values such as 2, 3, 4, 5, 6, and 7 may be further included. In addition, even if 5G or 6G systems further support values such as TBS = 8 and 16, values such as Z = 2 and 3 are not used. Therefore, only values such as 4, 6, and 7 or 4, 5, 6, and 7 may be further included, and values not actually used in 5G may be excluded. [Table 8] below shows specific examples of lifting size sets. (The numbers in parentheses in Table 8 indicate values that may or may not be used as lifting sizes.)

[Table 8]

| Set index ($i_{LS}$) | Set of lifting sizes (Z) |
|---|---|
| 0 | {(2, 4,) 8, 16, 32, 64, 128, 256, 512} |
| 1 | {(3, 6,) 12, 24, 48, 96, 192, 384, 768} |
| 2 | {(5,) 10, 20, 40, 80, 160, 320, 640} |
| 3 | {7, 14, 28, 56, 112, 224, 448(, 896)} |
| 4 | {(9,) 18, 36, 72, 144, 288, 576} |
| 5 | {11, 22, 44, 88, 176, 352, 704} |
| 6 | {(13,) 26, 52, 104, 208, 416(, 832)} |
| 7 | {15, 30, 60, 120, 240, 480(, 960)} |

Lifting size sets may be defined in various ways, in addition to those shown in [Table 3] to [Table 8]. However, they must share the common characteristics where the multiple lifting size sets must not contain lifting sizes overlapping with each other, and the lifting sizes within each lifting size set must be multiples or divisors of each other. Although the above [Tables 3] to [Table 8] are consecutive multiples of $2^k$ ($k = 0, 1, 2,...$) for the smallest lifting size in each lifting size set, in general, it is also possible to be non-consecutive multiples such as $2^k$ ($k = 0, 1, 3, 5,...$), and multiples of integers other than multiples of 2 may also be included.

In new communication systems, including 6G systems, to support backward compatibility with existing systems (e.g., 5G systems), the existing lifting size sets may be maintained (e.g., [Table 3] or [Table 4]), while new lifting size sets may be added (e.g., [Table 5] to [Table 8]). If a single lifting size set is defined, but the TBS range used is determined differently in advance depending on system settings such as the application scenario or target BLER, the range of Z values used will also vary. For example, if a service applying a first target BLER has configured first minimum TBS and first maximum TBS values, and a service applying a second target BLER has a defined second minimum TBS and/or second maximum TBS values, the first minimum TBS and second minimum TBS values may differ, or the first maximum TBS and second maximum TBS values may differ (both the minimum and maximum values may differ).

Additionally, the applicable service scenario or target BLER may be determined based on higher-layer signaling information. For example, the CQI table or MCS table may typically be determined in consideration of target service scenarios or BLERs. (For example, the first target service or BLER may use the first CQI table and/or the first MCS table, the second target service or BLER may use the second CQI table and/or the second MCS table, the third target service or BLER may use the third CQI table and/or the third MCS table, etc.)

As a result, the range of lifting sizes to be used or the set of lifting sizes to be used may be determined based on higher-layer signaling information, and intermediate operations may vary depending on the system. Furthermore, the lifting size set to be used may be indicated through physical layer signaling or higher-layer signaling. A parity check matrix may be determined based on the indicated lifting size set and the determined lifting size (Z) values.

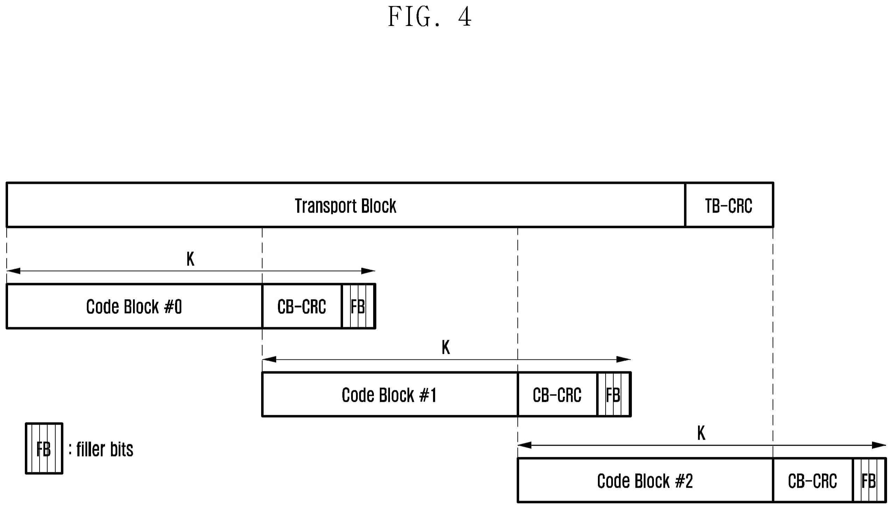

FIG. 4 is a diagram illustrating an example transport block structure according to various example embodiments.

Referring to FIG. 4, L bits of CRC bits (TB-CRC bits) are added to a transport block of A bits, and one transport block may become one code block. If the value B = A + L is greater than a specific threshold value, the transport block may be divided into multiple code blocks through an appropriate segmentation process. In this case, the code blocks are all of the same size K. To this end, specific bits, called null bits or filler bits, may be added to each code block. While the null bits or filler bits typically correspond to a value of 0, this limitation is not required and any specific predetermined bits may be included. The operation of adding predetermined bits, such as null bits or fillers, is commonly called shortening because it reduces the size of the actual pure information bits, and if the values are 0, it may also be called zero-padding.

After determining the transport block size (TBS) to be transmitted, one of the two different base matrices of LDPC codes used for LDPC encoding or decoding may be determined based on the TBS size and a code rate indicated by the MCS using a method such as the [basic-matrix determination method] below.

[Basic-matrix Determination Method]

The LDPC base matrix for LDPC encoding and decoding of a transport block having a TBS = A may be determined based on the TBS size and the code rate indicated by the MCS, as follows.

If $A \leq 292$ (or 288), $A \leq 3824$ and $R \leq 0.67$, or $R \leq 0.25$, LDPC encoding may be performed using LDPC base matrix 2.

Otherwise, LDPC encoding may be performed using LDPC base matrix 1. For reference, base matrix 1 $M(\text{H}_{\text{BG1}})$ and base matrix 2 $M(\text{H}_{\text{BG2}})$ defined in the 3GPP 5G standard are as follows.

$$M(\text{H}_{\text{BG1}})$$

0 1 2 3 5 6 9 10 11 12 13 15 16 18 19 20 21 22 23

0 2 3 4 5 7 8 9 11 12 14 15 16 17 19 21 22 23 24

0 1 2 4 5 6 7 8 9 10 13 14 15 17 18 19 20 24 25

0 1 3 4 6 7 8 10 11 12 13 14 16 17 18 20 21 22 25

0 1 26

0 1 3 12 16 21 22 27

0 6 10 11 13 17 18 20 28

0 1 4 7 8 14 29

0 1 3 12 16 19 21 22 24 30

0 1 10 11 13 17 18 20 31

1 2 4 7 8 14 32

0 1 12 16 21 22 23 33

0 1 10 11 13 18 34

0 3 7 20 23 35

0 12 15 16 17 21 36

0 1 10 13 18 25 37

1 3 11 20 22 38

0 14 16 17 21 39

1 12 13 18 19 40

0 1 7 8 10 41

0 3 9 11 22 42

1 5 16 20 21 43

0 12 13 17 44

1 2 10 18 45

0 3 4 11 22 46

1 6 7 14 47

0 2 4 15 48

1 6 8 49

0 4 19 21 50

1 14 18 25 51

0 10 13 24 52

1 7 22 25 53

0 12 14 24 54

1 2 11 21 55

0 7 15 17 56

1 6 12 22 57

0 14 15 18 58

1 13 23 59

0 9 10 12 60

1 3 7 19 61

0 8 17 62

1 3 9 18 63

0 4 24 64

1 16 18 25 65

0 7 9 22 66

1 6 10 67

$M(\mathrm{H_{BG2}})$

0 1 2 3 6 9 10 11

0 3 4 5 6 7 8 9 11 12

0 1 3 4 8 10 12 13

1 2 4 5 6 7 8 9 10 13

0 1 11 14

0 1 5 7 11 15

0 5 7 9 11 16

1 5 7 11 13 17

0 1 12 18

1 8 10 11 19

0 1 6 7 20

0 7 9 13 21

1 3 11 22

0 1 8 13 23

1 6 11 13 24

0 10 11 25

1 9 11 12 26

1 5 11 12 27

0 6 7 28

0 1 10 29

1 4 11 30

0 8 13 31

1 2 32

0 3 5 33

1 2 9 34

0 5 35

2 7 12 13 36

0 6 37

1 2 5 38

0 4 39

2 5 7 9 40

1 13 41

0 5 12 42

2 7 10 43

0 12 13 44

1 5 11 45

0 2 7 46

10 13 47

1 5 11 48

0 7 12 49

2 10 13 50

1 5 11 51

The sizes of the base matrix 1 $M(H_{BG1})$ and base matrix 2 $M(H_{BG2})$ are 46×68 and 42×52, respectively, and the sizes of the parity check matrices determined from the base matrices are 46Z×68Z and 42Z×52Z.

The number of CRC bits ($L_{TB}$) to be added to the transport block may be determined based on the determined TBS, as follows.

[Method for Determining the Number of Transport Block CRC Bits]

The $L_{TB}$ value, the CRC bit size for a transport block having a TBS = A, may be configured differently depending on the TBS value, as follows.

If A > 3824, $L_{TB}$ = 24; otherwise, $L_{TB}$ = 16.

Based on the TBS size (A) determined in this manner or the total number of bits (B = A + L) after adding a CRC to the transport block, an appropriate code block may be determined from the transport block, thereby performing LDPC encoding and decoding on each code block. The process of determining the code block length (code block size (CBS)) will be described in more detail below.

[CBS Determination Method]

The input bit sequence for code block segmentation may be expressed as $b_0$, $b_1$, ..., $b_{B-1}$. (B > 0) If B is greater than the maximum code block size $K_{cb}$, segmentation of the input bit sequence is performed, and a CRC of L = 24 bits is further added to each code block. For LDPC base matrix 1, the maximum code block size is $K_{cb}$ = 8448, and for LDPC base matrix 2, the maximum code block size is $K_{cb}$ = 3840.

Example steps are as follows.

Step 1: The number of code blocks, C, may be determined.

If $B \leq K_{cb}$, then $L = 0$, C = 1, and $B' = B$.

Otherwise, $L = 24$, $C = \lceil B/(K_{cb} - L) \rceil$, and, $B' = B + C \times L$.

Step 2: Let the bits output from code block segmentation be $c_{r0}$, $c_{r1}$,..., $cr_{(Kr-1)}$, where r represents the code block number ($0 \leq r < C$), and Kr (= K) represents the number of bits of the code block for code block number r. Here, K, the number of bits included in each code block, may be calculated as follows.

$$K' = B'/C$$

For LDPC base matrix 1, $K_b$ =

For LDPC base matrix 2,

$$\text{If } B > 640, K_b = 10;$$

$$\text{If } 560 < B \leq 640, K_b = 9;$$

$$\text{If } 192 < B \leq 560, K_b = 8;$$

$$\text{If } B \leq 192, K_b = 6.$$

Step 3: Among the Z values in Table 3, the minimum $Z_c$ that satisfies $K_b \cdot Z_c \geq K'$ may be determined. For LDPC base matrix 1, $K = 22Z_c$, and for LDPC base matrix 2, $K = 10Z_c$.

In step 2 in the above [CBS Determination Method], the $K_b$ value is a value corresponding to a column or column block corresponding to LDPC information bits in the base matrix (or base graph) or parity check matrix of the LDPC code, and may correspond to the maximum value of LDPC information bits (= $K_bZ_c$) without shortening or zero padding. For example, even if the number of columns (or column blocks) corresponding to information bits in LDPC base matrix 2 or the parity check matrix corresponding to base matrix 2 is 10, if $K_b = 6$ is configured, LDPC encoding/decoding is substantially performed on the information bits of up to $6Z_c$ bits, and the information bits corresponding to at least $(10 - K_b)Z_c = Z_c$ columns in the parity check matrix are shortened or zero-padded. Here, shortening or zero padding may refer, for example, to assigning a predetermined bit value, such as 0, between the transmitter and receiver, or may refer, for example, to not using the corresponding part of the parity check matrix.

The lifting size (Z) value for LDPC encoding and decoding may be determined based on the lifting size sets shown in [Table 3] to [Table 8], or on lifting size sets with specific lifting size values added or removed. Respective Z values are included in a predetermined set depending on the index $i_{LS}$. When the Z value is determined in Step 3 of the [CBS Determination Method], the set corresponding to the Z value or the index $i_{LS}$ value of the set may be determined, and the parity check matrix of the LDPC code corresponding to each index or a sequence corresponding thereto may also be determined. The determined parity check matrix of the LDPC code or its corresponding sequence is converted by applying a modulo operation based on the lifting size Z thereto, thereby supporting encoding and decoding of LDPC codes of various lengths. In the 3GPP 5G standard, each number included in the parity check matrix or sequence of an LDPC code represents a value corresponding to a circulant permutation matrix.

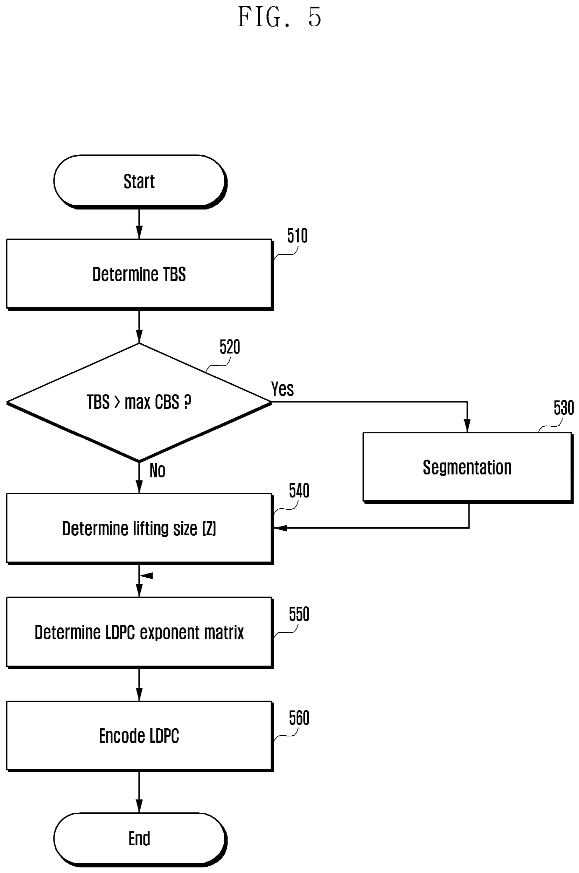

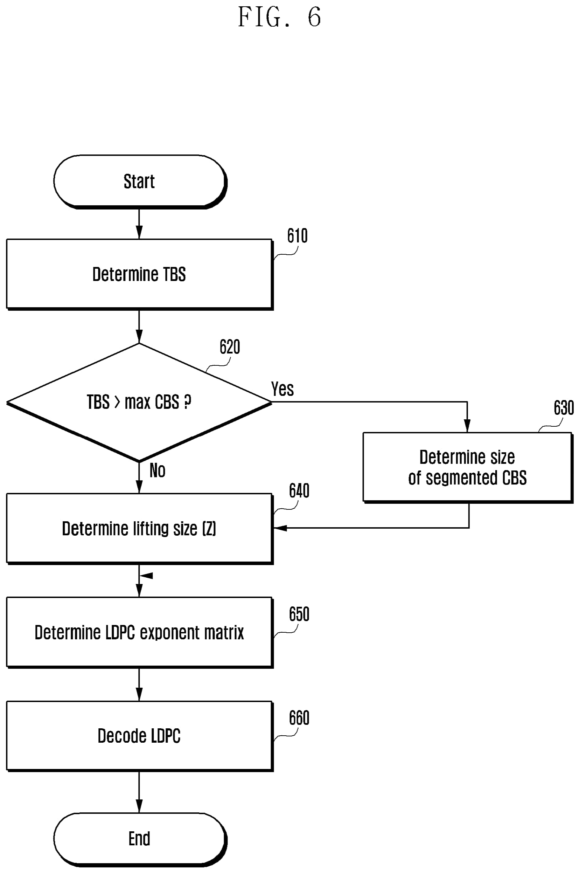

A flowchart illustrating an example of an LDPC encoding and decoding process based on the designed base matrix or exponent matrix is shown in FIGS. 5 and 6.

FIG. 5 is a flowchart illustrating an example of the LDPC encoding process according to various example embodiments.

The transmitter determines the transport block size (TBS) to be transmitted in operation 510. In operation 520, the transmitter determines whether the TBS is greater than, less than, or equal to the max CBS.

If the TBS is greater than the max CBS, the transmitter may segment the transport block to determine the CBS in operation 530. If the TBS is less than or equal to the max CBS, the transmitter skips the segmentation operation and determines the TBS as the CBS.

In operation 540, the transmitter determines a lifting size (Z) value to be applied to LDPC encoding, based on the CBS.

In operation 550, the transmitter determines the parity check matrix or sequence, based on the TBS, CBS, or lifting size (Z) value. The transmitter may determine an LDPC exponent matrix or sequence that has an algebraically identical effect to the parity check matrix.

In operation 560, the transmitter performs LDPC encoding, based on the parity check matrix or sequence. The transmitter may perform LDPC encoding, based on the exponent matrix or sequence in operation 560. Furthermore, the transmitter may perform LDPC encoding, based on the lifting size and the exponent matrix or sequence in operation 560.

For reference, operation 550 may, in some cases, include a process of converting the determined LDPC exponent matrix or sequence based on the determined lifting size. It is apparent that the LDPC exponent matrix, sequence, or parity check matrix for LDPC encoding may be determined in various ways, depending on the system, based on the TBS or CBS. For example, the transmitter may first determine the base matrix via the TBS and then determine the LDPC exponent matrix or sequence parity check matrix, based on the determined base matrix and CBS, and various other methods may also be applied. For reference, additional operations may be included between operations 520 and 540 or between operations 530 and 540 depending on the system. For example, in the case of a 3GPP 5G system using base matrix 2 ($M(H_{BG2})$), a process may be included to determine a $K_b$ value, which represents the number of columns actually used in the base matrix or the number of column blocks used in the parity check matrix, depending on the TBS size. (Note that the column blocks of the parity check matrix corresponding to ($10\text{-}K_b$) base matrix columns are shortened.)

The LDPC decoding process may be similarly represented, as shown in FIG. 6.

FIG. 6 is a flowchart illustrating an example LDPC decoding process according to various example embodiments.

If the TBS is determined in operation 610, the receiver determines, in operation 620, whether the TBS is greater than, less than the max CBS.

If the TBS is greater than the max CBS, the receiver determines the size of the CBS to which segmentation is applied in operation 630. If the TBS is determined to be less than or equal to the max CBS, the TBS is determined to be equal to the CBS.

The receiver determines the lifting size (Z) value to be applied to LDPC decoding in operation 640.

The receiver determines the parity check matrix or sequence, based on the TBS, CBS, or lifting size (Z) value, in operation 650. The transmitter may determine an exponent matrix or sequence that has an algebraically identical effect to the parity check matrix.

The receiver may perform LDPC decoding based on the parity check matrix or sequence in operation 660. The receiver may perform LDPC decoding using the exponent matrix or sequence in operation 660. For reference, operation 650 may also include a process of converting the determined LDPC exponent matrix or sequence, based on the determined lifting size. It is apparent that the LDPC exponent matrix, sequence, or parity check matrix for LDPC decoding may be determined in various ways, depending on the system, based on the TBS or CBS. For example, the receiver may first determine the base matrix via the TBS and then determine the LDPC exponent matrix or sequence parity check matrix, based on the determined base matrix and CBS, and various other methods may also be applied.

According to the above examples, although the process of determining the exponent matrix or sequence of the LDPC code in operations 550 and 650 in FIGS. 5 and 6 has been described for cases where the exponent matrix or sequence is determined by one of the TBS, CBS, or lifting size (Z), various other methods may also exist. Depending on the system, additional operations may be included between operations 620 and 640 or between operations 630 and 640 in FIG. 6. For example, in the case of a 3GPP 5G system using base matrix 2 ($M(H_{BG2})$), a process may be included to determine a $K_b$ value, which represents the number of columns actually used in the base matrix or the number of column blocks used in the parity check matrix, depending on the TBS size. For reference, since the receiver may recognize that the bits corresponding to the column blocks of the parity check matrix corresponding to the ($10\text{-}K_b$) columns of the base matrix have been shortened at the transmitter, the receiver may further perform appropriate operations on the shortened bits before performing LDPC decoding.

In an embodiment of the LDPC encoding and decoding process based on the base matrix and exponent matrix (or LDPC sequence) of the LDPC code in FIGS. 5 and 6, LDPC encoding and decoding with various code rates and lengths may be supported by appropriately shortening or puncturing some of the information bits of the LDPC code and by puncturing and repeating some of the codeword bits. For example, as in the 3GPP 5G standard technology, various information word lengths (or code block lengths) and code rates may be supported by applying shortening to some of the information bits, puncturing the information bits corresponding to the first two columns of the base matrix, r.g., the first $2Z_c$ columns of the parity check matrix, and puncturing some of the parity or repeating some of the LDPC codewords in the LDPC encoding process in FIG. 5.

When given input bits or code block bits are $i_0,i_1,i_2,...,i_{K-1}$ and the encoded bits are represented as $d_0,d_1,d_2,...,d_{N-1}$ (where $N = 66Z_c$ for base matrix 1 and $N = 50Z_c$ for base matrix 2), a portion of the encoding process may be defined as shown in [Table 9] below.

$$[\text{Table 9}]$$
$$\text{for } k = 2Z_c \text{ to } K - 1$$
$$\text{if } i_k \neq\ < NULL >$$
$$d_{k-2Z_c} = i_k$$
$$\text{else}$$
$$i_k = 0;$$
$$d_{k-2Z_c} = < NULL >;$$
$$\text{end if}$$
$$\text{end for}$$

According to the encoding process above, the first $2Z_c$ bits $i_0,i_1,i_2,...,i_{2Zc}$-1 among the input bits or code block bits are not included in the encoded bits. That is, the $2Z_c$ bits are punctured at the transmitter and not transmitted to the receiver. Note that puncturing some of the information bits may indicate that the transmitter does not transmit a portion of the information word 102 in FIG. 1, and thus the receiver may perform decoding while processing the non-transmitted information bits as being erased. In other words, since the punctured bits are considered erased and have an equal probability of being 0 or 1, the receiver may insert the corresponding value to perform decoding.

The information bits punctured during the encoding process may not always be transmitted, even in retransmission. When a circular buffer is used for rate matching, and rate matching and retransmission are performed without storing the punctured information bits in the circular buffer, the punctured information bits may not always be transmitted.

On the other hand, in the case of an initial transmission, some of the information bits may be punctured, and in the case of a retransmission, all or some of the punctured information bits may be transmitted. All information bits may be stored in the circular buffer, and in the case of an initial transmission, the redundancy value (RV) may be appropriately configured so that some of the information bits are punctured (e.g., RV0 is configured to exclude the information bits to be punctured). Even if some of the information bits are punctured in the initial transmission, the bit values are still stored in the circular buffer. Therefore, in the case of a retransmission, some or all of the punctured information bits may be transmitted depending on the circular buffer rate matching operation and the selection of an appropriate RV value.

In [Table 9], $d_0,d_1,d_2,...,d_{N-1}$ are referred to as encoded bits for convenience, but the definition of encoded bits may be changed for convenience of explanation. For example, although the bit sequences after puncturing some of the information bits such as $d_0,d_1,d_2,...,d_{N-1}$ in [Table 9] may be defined as encoded bits, since the input bits or code block bits $i_0,i_1,i_2,...,i_{K-1}$ are used to generate the parity bit vector $\underline{w}$ during the actual encoding process,

$$\left(\underline{i},\underline{w}\right) = \left(i_0, i_1, i_2, ..., i_{K_{ldpc}-1}, w_0, w_1, w_2, ..., w_{N_{ldpc}-K_{ldpc}-1}\right)$$

may be defined as the encoded bits based on the information bits before puncturing. The bit sequences $e_0,e_1,e_2,...,e_{E-1}$ with rate matching applied based on allocated resources may be defined as the encoded bits, and the bit sequences $f_0,f_1,f_2,...,f_{E-1}$ with interleaving applied to the rate-matched bit sequences may also be defined as the encoded bits. The encoded bit columns may be defined in various ways for convenience of explanation. Typically, although the bit columns related to actual transmission in the system are $d_0,d_1,d_2,...,d_{N-1}$, $(\underline{i},\underline{w})$ related to the encoding process may be defined as the encoded bits.

In the LDPC decoding process in FIG. 6, decoding may be performed by adding appropriate operations for shortened information bits and punctured bits or repeated bits, corresponding to the transmitter operation described above. Typically, since shortened information bits are 0, the receiver may perform decoding by excluding the columns corresponding to the shortened bits from the parity check matrix, or by configuring a preset value in the system for the shortened bits. (Since it is certain to be 0, the highest value corresponding to 0 set in the system is typically configured.) The punctured parity bits are considered erased and have an equal probability of being 0 or 1, the receiver may insert a corresponding value to perform decoding or, depending on the structure of the parity check matrix, may perform decoding without using at least part of the rows corresponding to the punctured parity bits. In general, puncturing parity bits corresponding to the order-1 columns allows the LDPC decoder to perform decoding without using some or all of the corresponding portion of the parity check matrix, thereby reducing decoding complexity.

When supporting variable information word lengths or variable code rates using LDPC code shortening or zero padding, code performance may be improved depending on the shortening sequence or method. When a shortening sequence is configured, encoding performance may be improved by appropriately rearranging some or all of the given base matrix. Performance may also be improved by appropriately determining the lifting size or the number of column blocks to which shortening is applied for a specific information word length (or code block length CBS). The performance of LDPC code may be improved by adjusting the puncturing order of parity bits or the transmission order of generated LDPC codewords. For example, appropriately puncturing some of the information bits and the parity bits may provide better performance than simply puncturing the parity bits to support variable code rates. Furthermore, LDPC encoding performance may be improved by appropriately determining the order of repetition of some of the LDPC codewords to support lower code rates.

Typically, during the LDPC encoding process, the transmitter first determines the size of the input bits (or code block) to which LDPC encoding is to be applied, determines, based on that size, the lifting size $Z$ to which the LDPC encoding is to be applied, determines an appropriate LDPC exponent matrix or sequence, based on the lifting size, and then performs LDPC encoding, based on the lifting size $Z$ and the determined exponent matrix or LDPC sequence. At this time, the LDPC exponent matrix or sequence may be applied to LDPC encoding without transformation, and, in some cases, the LDPC exponent matrix or sequence may be appropriately transformed based on the lifting size $Z$, thereby performing LDPC encoding.

Similarly, during the LDPC decoding process, the receiver determines the size of the input bits (or code block) for the transmitted LDPC codeword, determines, based on that size, the lifting size $Z$ to which the LDPC decoding is to be applied, determines an appropriate LDPC exponent matrix or sequence, based on the lifting size, and then performs LDPC decoding, based on the lifting size $Z$ and the determined exponent matrix or LDPC sequence. At this time, the LDPC exponent matrix or sequence may be applied to LDPC decoding without transformation, and, in some cases, the LDPC exponent matrix or sequence may be appropriately transformed based on the lifting size $Z$, thereby performing LDPC decoding.

In the parity check matrix, the submatrix corresponding to the parity bits often has a special structure for efficient encoding. In this case, lifting may alter the encoding method or complexity. Therefore, to maintain the same encoding method or complexity, lifting may not be applied to a portion of the exponent matrix for the submatrix corresponding to the parity in the parity check matrix, or a lifting method, which is different from the lifting method applied to the exponent matrix for the submatrix corresponding to the information bits, may be applied. In other words, the lifting method applied to the sequence corresponding to the information bits may be configured differently from the lifting method applied to the sequence corresponding to the parity bits within the exponent matrix. In some cases, lifting may not be applied to some or all of the sequence corresponding to the parity bits so that a fixed value may be used without sequence conversion.

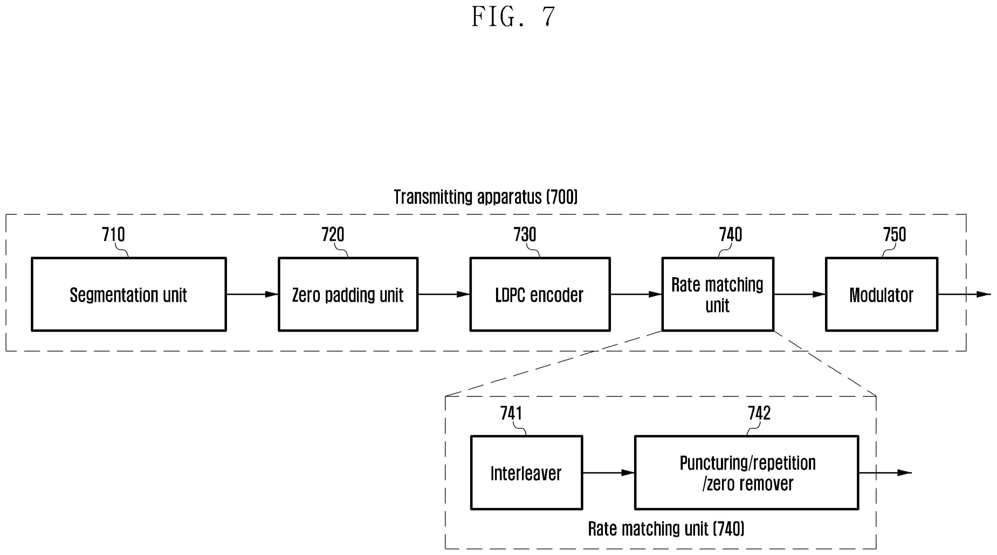

FIG. 7 is a block diagram illustrating an example configuration of a transmitting apparatus according to various example embodiments.

As shown in FIG. 7, the transmitting apparatus 700 may include a segmentation unit 710, a zero padding unit 720, an LDPC encoder 730, a rate matching unit 740, and a modulator 750 in order to process variable-length input bits. The rate matching unit 740 may include an interleaver 741 and a puncturing/repetition/zero remover 742.

The components illustrated in FIG. 7 are components for performing encoding and modulation on variable-length input bits, and these are merely examples. In some cases, some of the components illustrated in FIG. 7 may be omitted or changed, and other components may be further added.

The transmitting apparatus 700 may determine necessary parameters (e.g., at least one of an input bit length, a modulation and code rate (ModCod), parameters for zero padding (or shortening), a code rate/codeword length of an LDPC code, parameters for interleaving, parameters for repetition and puncturing, and a modulation method), encode the input bits based on the determined parameters, and transmit them to the receiving apparatus 800.

Since the number of input bits is variable, if the number of input bits is greater than a preconfigured value, the input bits may be segmented to have a length less than or equal to the preconfigured value. Furthermore, each segmented block may correspond to one LDPC coded block. However, if the number of input bits is less than or equal to the preconfigured value, the input bits are not segmented and may correspond to one LDPC coded block.

The transmitting apparatus 700 may store various parameters used for encoding, interleaving, and modulation. The parameters used for encoding may include at least one piece of information regarding the code rate, codeword length, and parity check matrix of the LDPC code. The parameters used for interleaving may include information regarding the interleaving rule, and the parameters used for modulation may include information regarding the modulation method. The information regarding puncturing may include the puncturing length. Information regarding repetition may include the repetition length. Information regarding the parity check matrix may include the exponent value of the circulant matrix or values algebraically identical thereto when using the parity matrix presented in the disclosure.

In this case, the respective components of the transmitting apparatus 700 may perform operations using these parameters.

Although not shown, the transmitting apparatus 700 may further include a controller (not shown) for controlling the operation of the transmitting apparatus 700.

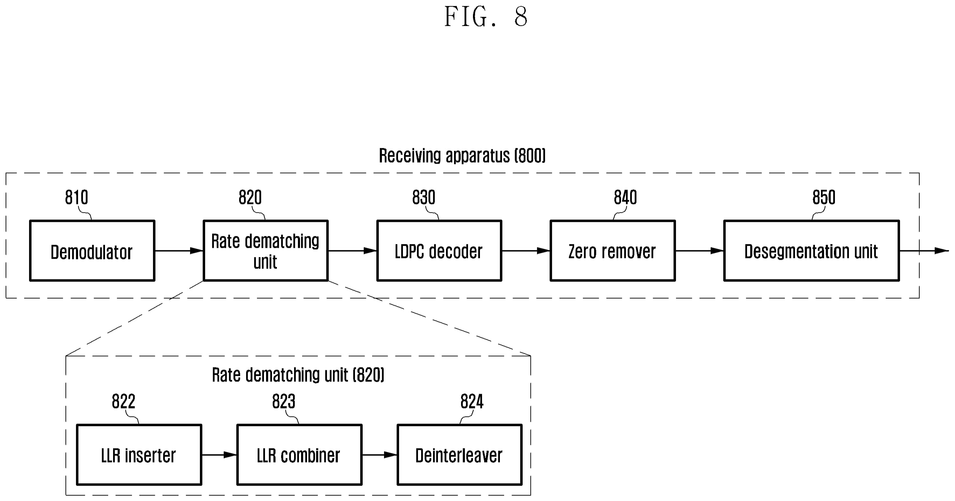

FIG. 8 is a block diagram illustrating an example configuration of a receiving apparatus according to various example embodiments.

As shown in FIG. 8, the receiving apparatus 800 may include a demodulator 810, a rate dematching unit 820, an LDPC decoder 830, a zero remover 840, and a desegmentation unit 850 to process variable-length information. The rate dematching unit 820 may include a log likelihood ratio (LLR) inserter 822, an LLR combiner 823, and a deinterleaver 824.

The components illustrated in FIG. 8 are components for performing functions corresponding to those illustrated in FIG. 8, and these are merely examples. In some cases, some of the components may be omitted or changed, and other components may be further added.

The parity check matrix in the disclosure may be read from memory, provided in advance to the transmitting apparatus or receiving apparatus, or generated directly by the transmitting apparatus or receiving apparatus. The transmitting apparatus may store or generate a sequence or exponent matrix corresponding to the parity check matrix, or a value algebraically identical thereto, and apply it for encoding. The receiving apparatus may store or generate a sequence or exponent matrix corresponding to the parity check matrix, or a value algebraically identical thereto, and apply it for decoding.

Hereinafter, the receiver operation will be described in detail below with reference to FIG. 8.

The demodulator 810 demodulates the signal received from the transmitting apparatus 700.

For example, the demodulator 810 is a component corresponding to the modulator 750 of the transmitting apparatus 700, and may demodulate the signal received from the transmitting apparatus 700 to generate values corresponding to the bits transmitted by the transmitting apparatus 700.

To this end, the receiving apparatus 800 may determine parameters required for demodulation and decoding (e.g., at least one of an input bit length, a modulation and code rate (ModCod), parameters for zero padding (or shortening), a code rate/codeword length of an LDPC code, parameters for interleaving, parameters for repetition and puncturing, and a modulation method), and the demodulator 810, based on the determined parameters, may demodulate the signal received from the transmitting apparatus 700 according to the mode, thereby performing a decoding process to generate values corresponding to LDPC codeword bits.

The values corresponding to the bits transmitted from the transmitting apparatus 700 may be likelihood ratio (LR) values or log likelihood ratio (LLR) values.

For example, the LR value may represent the ratio of the probability of bits transmitted from the transmitting apparatus 700 being 0 to the probability of being 1, and the LLR value may be represented as the logarithm of the ratio of the probability of bits transmitted from the transmitting apparatus 700 being 0 to the probability of being 1. The LR or LLR value may be hard-decided based on the probability, probability ratio, or logarithm of the probability ratio, and represented as the bit value itself. The LR or LLR value may be represented as a predefined representative value based on the range within which the probability, probability ratio, or logarithm of the probability ratio falls. An example of a method for determining a predefined representative value based on the range within which the probability, probability ratio, or logarithm of the probability ratio falls includes a method that considers quantization. Various other values corresponding to the probability, probability ratio, or logarithm of the probability ratio may be utilized.

In the disclosure, although the receiving method and the operation of the apparatus have been described based on LLR values for the convenience, the disclosure is not limited thereto.

The demodulator 810 includes a function for performing multiplexing (not shown) on LLR values. For example, the muxer (not shown) is a component corresponding to the bit demuxer (not shown) of the transmitting apparatus 700 and may perform operations corresponding to the bit demuxer (not shown).

To this end, the receiving apparatus 800 may store information regarding parameters used by the transmitting apparatus 700 for demultiplexing and block interleaving. Accordingly, the muxer (not shown) may reverse the demultiplexing and block interleaving operations performed by the bit demuxer (not shown) on the LLR values corresponding to cell words (information representing received symbols for LDPC codewords as vector values), thereby multiplexing the LLR values corresponding to cell words in units of bits.

The rate dematching unit 820 may further insert LLR values into the LLR values output from the demodulator 810. In this case, the rate dematching unit 820 may insert pre-arranged LLR values between the LLR values output from the demodulator 810.

For example, the rate dematching unit 820 is a component corresponding to the rate matching unit 740 of the transmitting apparatus 700, and may perform operations corresponding to the interleaver 741, and the zero removal and puncturing/repetition/zero remover 742.

The rate dematching unit 820 performs deinterleaving to correspond to the interleaver 741 of the transmitter. The LLR inserter 822 may insert LLR values corresponding to zero bits into the positions of the output values of the deinterleaver 824 where zero bits were padded in the LDPC codeword. In this case, the LLR values corresponding to the padded zero bits, e.g., the shortened zero bits, may be ∞ or -∞. However, ∞ or -∞ are theoretical values, and in practice, they may be the maximum or minimum values of the LLR values used by the receiving apparatus 800.

To this end, the receiving apparatus 800 may store information regarding the parameters used by the transmitting apparatus 700 to pad the zero bits. Accordingly, the rate dematching unit 820 may determine the positions where zero bits were padded in the LDPC codeword and insert the LLR values corresponding to the shortened zero bits into those positions.

The LLR inserter 822 of the rate dematching unit 820 may insert the LLR values corresponding to the punctured bits in the LDPC codeword into the positions of the punctured bits. In this case, the LLR values corresponding to the punctured bits may be 0 or another predetermined value. In general, when parity bits with order 1 are punctured, there is no effect on performance during LDPC decoding. Therefore, some or all of the corresponding puncturing positions may not be used during LDPC decoding without LLR insertion. However, to improve the efficiency of the LDPC decoding process based on parallel processing, the LLR inserter 822 may insert predetermined LLR values into the positions corresponding to some or all of the puncturing bits with order 1, regardless of the decoding performance improvement.

To this end, the receiving apparatus 800 may store information about the parameters used for puncturing in the transmitting apparatus 700. Accordingly, the LLR inserter 822 may insert, into the punctured positions of the LDPC information bits or parity bits, the LLR values (e.g., LLR = 0) corresponding thereto. However, this process may be omitted for some punctured parity bits.

The LLR combiner 823 may combine, e.g., summate, the LLR values output from the LLR inserter 822 and the demodulator 810. For example, the LLR combiner 823 is a component corresponding to the puncturing/repetition/zero remover 742 of the transmitting apparatus 700 and may perform operations corresponding to the repetition unit 742. The LLR combiner 823 may combine the LLR values corresponding to the repeated bits with other LLR values. Other LLR values may be LLR values for the bits that formed the basis for generating the repeated bits in the transmitting apparatus 700, e.g., the LDPC information bits or parity bits selected as repetition targets.

For example, as described above, the transmitting apparatus 700 selects LDPC encoded bits, repeats them between the LDPC information bits and the LDPC parity bits, and transmits them to the receiving apparatus 800. Accordingly, the LLR values for the LDPC encoded bits may be include LLR values for the repeated LDPC encoded bits and LLR values for the non-repeated LDPC encoded bits. The LLR combiner 823 may combine LLR values for the same LDPC encoded bits.

To this end, the receiving apparatus 800 may store information about the parameters used for repetition in the transmitting apparatus 700. Accordingly, the LLR combiner 823 may determine the LLR values for the repeated LDPC encoded bits and combine them with the LLR values for the LDPC encoded bits that formed the basis of the repetition.

The LLR combiner 823 may combine the LLR values corresponding to the retransmitted or incremental redundancy (IR) bits with other LLR values. Other LLR values may be LLR values for some or all of the LDPC codeword bits that formed the basis for generating the retransmitted or IR bits in the transmitting apparatus 700.

As described above, when a NACK occurs for HARQ, the transmitting apparatus 700 may transmit some or all of the codeword bits to the receiving apparatus 800.

Accordingly, the LLR combiner 823 may combine the LLR values for the bits received via retransmission or IR with the LLR values for the LDPC codeword bits received via the previous frame.

To this end, the receiving apparatus 800 may store information about parameters used by the transmitting apparatus 700 to generate the retransmission or IR bits. Accordingly, the LLR combiner 823 may determine the LLR values for the number of retransmission or IR bits and combine them with the LLR values for the LDPC encoded bits that formed the basis for generating the retransmission bits.

The deinterleaver 824 may deinterleave the LLR values output from the LLR combiner 823.

For example, the deinterleaver unit 824 is a component corresponding to the interleaver 741 of the transmitting apparatus 700 and may perform operations corresponding to the interleaver 741.

To this end, the receiving apparatus 800 may store information regarding parameters used by the transmitting apparatus 700 for interleaving. Accordingly, the deinterleaver 824 may reverse the interleaving operation performed by the interleaver 741 on the LLR values corresponding to the transmitted LDPC encoded bits, thereby deinterleaving the LLR values corresponding to the transmitted LDPC encoded bits.

The LDPC decoder 830 may perform LDPC decoding based on the LLR values output from the rate dematching unit 820.

For example, the LDPC decoder 830 is a component corresponding to the LDPC encoder 730 of the transmitting apparatus 700 and may perform operations corresponding to the LDPC encoder 730.

To this end, the receiving apparatus 800 may pre-store information about parameters used by the transmitting apparatus 700 to perform LDPC encoding according to the mode. Accordingly, the LDPC decoder 830 may perform LDPC decoding based on the LLR values output from the rate dematching unit 820 according to the mode.

For example, the LDPC decoder 830 may perform LDPC decoding based on the LLR values output from the rate dematching unit 820 according to an iterative decoding method based on the sum-product algorithm, and output bits with errors corrected according to the LDPC decoding. The LDPC decoder 830 performs LDPC decoding on the LDPC codeword, based on the parity check matrix or the corresponding exponent matrix or sequence. LDPC decoding may be performed using parity-check matrices defined differently depending on the code rate (e.g., the code rate of the LDPC code). The LDPC decoder 830 may perform LDPC decoding by passing the LLR values corresponding to the LDPC codeword bits through an iterative decoding algorithm, thereby generating information bits. The LLR values are channel values corresponding to the LDPC codeword bits and may be expressed in various ways.

The zero remover 840 may remove zero bits from the bits output from the LDPC decoder 830.

For example, the zero remover 840 is a component corresponding to the zero padding unit 720 of the transmitting apparatus 700 and may perform operations corresponding to the zero padding unit 720.

To this end, the receiving apparatus 800 may pre-store information regarding the parameters used to pad zero bits in the transmitting apparatus 700. Accordingly, the zero remover 840 may remove zero bits, which have been padded by the zero padding unit 720, from the bits output from the LDPC decoder 830.

The desegmentation unit 850 is a component corresponding to the segmentation unit 710 of the transmitting apparatus 700 and may perform operations corresponding to the segmentation unit 710.

To this end, the receiving apparatus 800 may pre-store information about the parameters used by the transmitting apparatus 700 for segmentation. Accordingly, the desegmentation unit 850 may combine the bits output from the zero remover 840, e.g., segments for variable-length input bits, to restore the bits before segmentation.

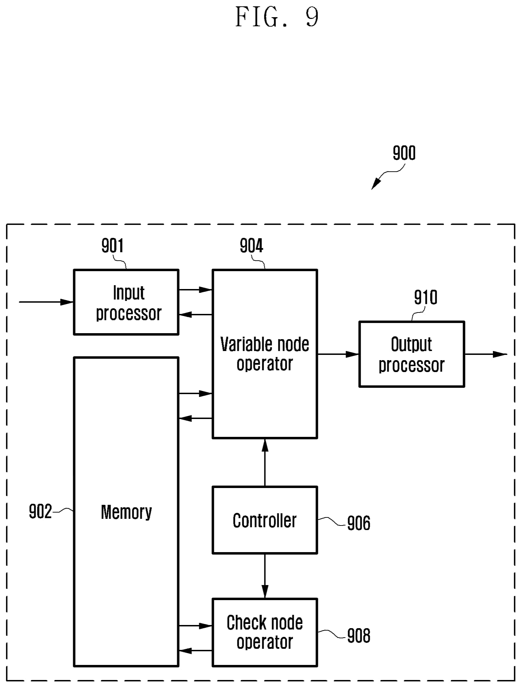

FIG. 9 is a block diagram illustrating an example structure of an LDPC decoder according to various example embodiments.

As described above, the LDPC decoder 830 may perform LDPC decoding using an iterative decoding algorithm, and in this case, the LDPC decoder 830 may be configured in a structure similar to that shown in FIG. 9. However, the detailed configuration illustrated in FIG. 9 is also merely an example.

According to FIG. 9, the decoding apparatus 900 includes an input processor 901, a memory 902, a variable node operator 904, a controller 906, a check node operator 908, and an output processor 910.

The input processor 901 stores input values. For example, the input processor 901 may store the LLR values of reception signals received through a channel.

The controller 904 determines the number of values input to the variable node operator 904 and the address values in the memory 902, the number of values input to the check node operator 908 and the address values in the memory 902, etc., based on the block size (e.g., codeword length) of the reception signal received through the channel and the parity check matrix corresponding to the code rate.

The memory 902 stores input data and output data of the variable node operator 904 and the check node operator 908.

The variable node operator 904 receives data from the memory 902 and performs variable node operations, based on the address information of the input data and the number information of the input data received from the controller 906. The variable node operator 904 stores the variable node operation results in the memory 902, based on the address information of the output data and the number information of the output data received from the controller 906. The variable node operator 904 inputs the variable node operation results to the output processor 910, based on the data received from the input processor 901 and the memory 902. The variable node operation has been described above with reference to FIG. 6.

The check node operator 908 receives data from the memory 902 and performs a check node operation, based on the address information of the input data and the number information of the input data received from the controller 906. The check node operator 908 stores the check node operation results in the memory 902, based on the address information of the output data and the number information of the output data received from the controller 906. The check node operation has been described above with reference to FIG. 6.

The output processor 910 makes a hard decision whether the information bits of the codeword at the transmitter are 0 or 1, based on the data received from the variable node operator 904, and then outputs the result of the hard decision, so that the output value of the output processor 910 becomes the final decoded value. In this case, the hard decision may be made based on the sum of all message values input to a single variable node (the initial message value and all message values input from the check node) in FIG. 6.

The memory 902 of the decoding apparatus 900 may store information about the LDPC code rate, codeword length, and parity check matrix, and the LDPC decoder 810 may use this information to perform LDPC encoding. However, this is merely an example, and the relevant information may also be provided from the transmitting side.

For reference, although the disclosure focuses on LDPC codes as a forward error correction (FEC) technique for communication systems, FEC encoding and decoding in communication systems may generally be subdivided into concatenated codes, such as outer and inner codes. Depending on the definition of outer and inner codes, the transmitter performs inner encoding after outer encoding, while the receiver performs outer decoding after performing inner decoding.

For outer codes, algebraic codes that enable relatively simple error detection or correction, such as cyclic redundancy check (CRC) codes, Bose-Chaudhuri-Hocquenghem (BCH) codes, and Reed-Solomon (RS) encoding, are often used, but the disclosure is not necessarily limited thereto, and multiple codes may also be applied overlappingly.

For inner codes, relatively complex but highly error-correcting encoding methods such as LDPC codes, Turbo codes, and Polar codes are widely used, but the disclosure is not necessarily limited to these. (For example, tail-biting convolutional codes or other algebraic codes may be used, and the overlapping application of multiple codes is also possible.) For reference, in 3GPP 5G systems, CRC codes are used for outer codes, LDPC codes are used for inner codes for data channels, and Polar codes are used for inner codes for control channels.

Various broadcasting and communication systems use LDPC codes optimized for each system. The disclosure describes a system using LDPC codes, which are defined based on a parity check matrix with the same structure as the LDPC codes used in 3GPP 5G systems, but is not necessarily limited thereto. Communication systems, including 5G or 6G systems, may apply rate matching at the transmitter and rate dematching at the receiver in order to support various code rates and code lengths. However, in systems that perform encoding/decoding based on fixed LDPC codes, such as some broadcasting systems, not only rate matching or rate dematching but also all or some of other operations may be omitted.

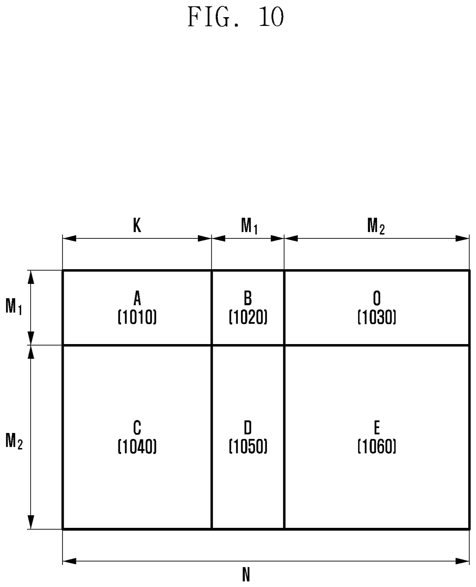

FIG. 10 is a diagram illustrating an example general structure of the parity check matrix of the LDPC code, which is an inner code applied to the FEC encoder (not shown) and FEC decoder (not shown) according to various example embodiments.

The parity check matrix illustrated in FIG. 10 has N columns and $(M_1 + M_2)$ rows (where $M_1$, $M_2 \geq 0$ and $M_1 + M_2 > 0$). In general, when the parity check matrix has full rank, the number of columns corresponding to information bits in the parity check matrix is equal to the value obtained by subtracting the total number of rows from the total number of columns. For example, if the parity check matrix in FIG. 10 has the full rank $(M_1 + M_2)$, then the number of information bits K becomes $N - (M_1 + M_2)$. For convenience, the disclosure only describes the case where the parity check matrix in FIG. 10 has the full rank, but the disclosure is not necessarily limited thereto.

The parity check matrix in FIG. 10 may be divided into a first part of the parity check matrix including submatrices A 1010 and B 1020, and a second part of the parity check matrix including submatrices C 1040, D 1050, and E 1060. (However, if either $M_1$ or $M_2$ is 0, the first and second parts may not be distinguished.) Submatrix O 1030 refers to a 0-matrix of size $(M_1 \times M_2)$. Since the submatrix O 1030 is a 0-matrix of size $(M_1 \times M_2)$, even if it is included in the first part of the parity check matrix, it has no effect on the matrix operations. For this reason, in the disclosure, for convenience, the first part of the parity check matrix is defined as a matrix of submatrices A 1010 and B 1020, excluding the 0-matrix of size $(M_1 \times M_2)$, but the first part of the parity check matrix may also include a 0-matrix of size $(M1 \times M_2)$ as necessary.

If the parity check matrix in FIG. 10 above is defined as a QC LDPC code with a lifting size or block size of Z, the parity check matrix in FIG. 10 above may correspond to a base matrix or weight matrix having a size of $m_b \times n_b$ for $k_b = KZ$ and $n_b = NZ$, $m_b = M_1 + M_2)/Z = m_{b1} + m_{b2}$ ($m_{b1} = M_1/Z$, $m_{b2} = M_2/Z$). Similarly, the first part of the parity check matrix of submatrices A 1010 and B 1020 corresponds to a submatrix of the base matrix or weight matrix of size $\left(\frac{M_1}{Z}\right) \times \left(\frac{K+M_1}{Z}\right)$ or $m_{b1} \times (k_b + m_{b1})$, and the second part of the parity check matrix including submatrices C 1040, D 1050 and E 1060 corresponds to a submatrix of the base matrix or weight matrix of size $\left(\frac{M_2}{Z}\right) \times \left(\frac{K+M_1+M_2}{Z}\right)$ or $m_{b2} \times (k_b + m_{b1} + m_{b2}) = m_{b2} \times n_b$.

For convenience, assuming that the parity check matrix in FIG. 10 is H, the information bits (or information bits vector) corresponding to the submatrix A 1010 or C 1040 are $i = (i_0, i_1, i_2, ..., i_{K-1})$, the first parity bits (or the first parity bits vector) corresponding to the submatrix B 1020 or D 1050 are $w_1 = (w_{1,0}, w_{1,1}, w_{1,2}, ..., w_{1,M_1-1})$, and the second parity bits (or the second parity bits vector) corresponding to the submatrix $\overline{E}$ 1060 are $\underline{w_2} = (w_{2,0}, w_{2,1}, w_{2,2}, ..., w_{2,M_2-1})$, then the following Equation 13 may be obtained from Equation 1.

[Equation 13]

$$H \cdot c^T = H \cdot \begin{bmatrix} \underline{i}^T \\ \underline{w}_1^T \\ \underline{w}_2^T \end{bmatrix} = \begin{bmatrix} A & B & O \\ C & D & E \end{bmatrix} \cdot \begin{bmatrix} \underline{i}^T \\ \underline{w}_1^T \\ \underline{w}_2^T \end{bmatrix}$$

$$= \begin{cases} A \cdot \underline{i}^T + B \cdot \underline{w}_1^T = 0 \\ C \cdot \underline{i}^T + D \cdot \underline{w}_1^T + E \cdot \underline{w}_2^T = 0 \end{cases}$$

Referring to the Equation 13 above, the first parity vector $w_1$ may be obtained (or calculated or determined) based on the information bits vector i and the first part of the parity check matrix. After obtaining the parity vector $w_1$, the parity vector $w_2$ may be obtained (or calculated or determined) based on the information bits vector i, the parity vector $w_1$, and the second part of the parity check matrix.

In the disclosure, the first part of the parity check matrix of A 1010 and B 1020, which is necessary to generate the first parity vector $w_1$ based on the information bits vector i, may be conveniently referred to as a core part or core matrix, a kernel part or kernel matrix, or a precoding part or matrix. The second part of the parity check matrix, which includes C 1040, D 1050, and E 1060 required to generate the second parity vector $w_2$ based on the information bits vector i and/or the first parity vector $w_1$, may be called an extension part or a single parity-check extension part.

As an example, the core matrix parts of base matrix 1 $M(H_{BG1})$ and base matrix 2 $M(H_{BG2})$ defined in the 3GPP 5G standard described above are represented, respectively, as follows.

Core matrix of $M(H_{BG1})$:

0 1 2 3 5 6 9 10 11 12 13 15 16 18 19 20 21 22 23

0 2 3 4 5 7 8 9 11 12 14 15 16 17 19 21 22 23 24

0 1 2 4 5 6 7 8 9 10 13 14 15 17 18 19 20 24 25

0 1 3 4 6 7 8 10 11 12 13 14 16 17 18 20 21 22 25

Core matrix of $M(H_{BG2})$:

0 1 2 3 6 9 10 11

0 3 4 5 6 7 8 9 11 12

0 1 3 4 8 10 12 13

1 2 4 5 6 7 8 9 10 13

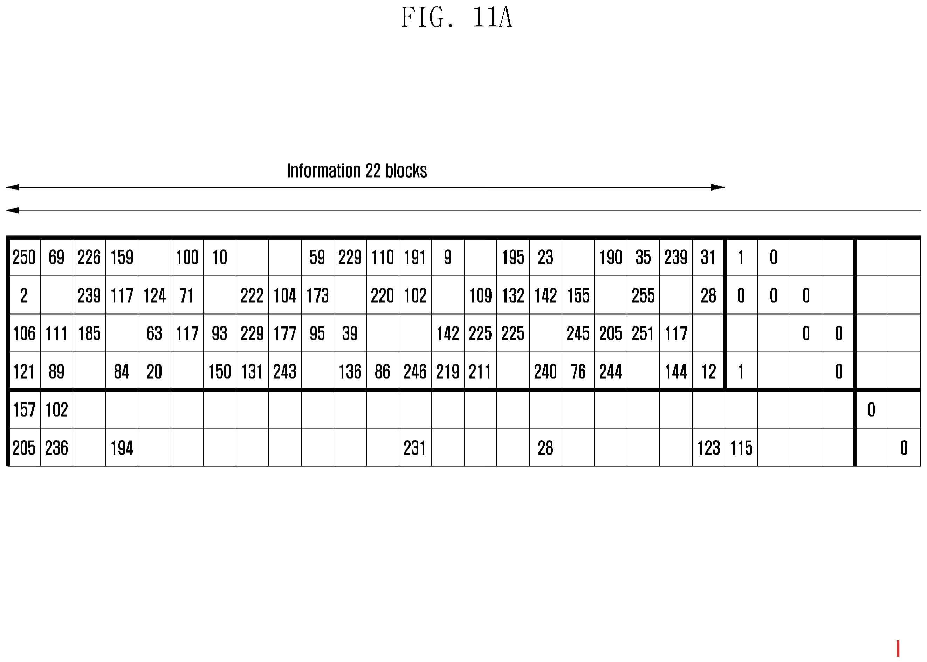

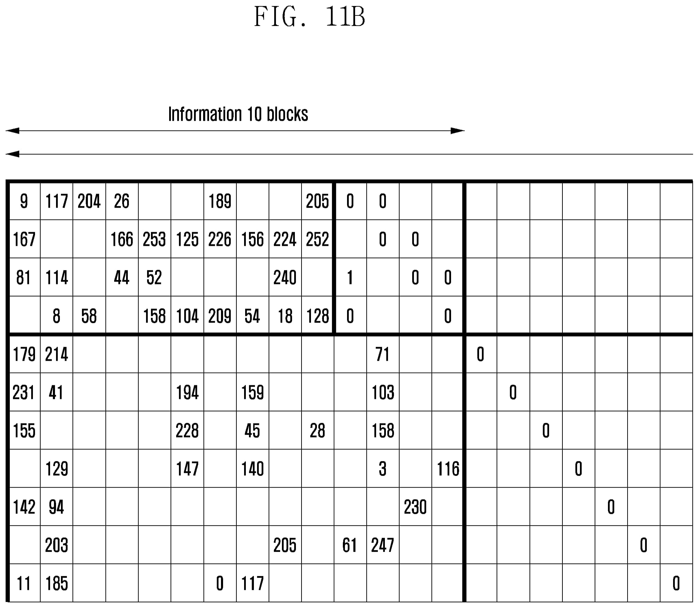

The core matrix of $M(H_{BG1})$ is 4×26, and the core matrix of $M(H_{BG2})$ is 4×14. Furthermore, the core matrix sizes for the parity check matrix are 4Z×26Z and 4Z×14Z, respectively. As a specific example, a portion of the exponent matrix of the LDPC code defined in the 3GPP 5G standard TS 38.212 for the case where the lifting size set index $i_{LS}$ = FIGS. 11A and 11B. The portions corresponding to the core matrix of the base matrix or parity check matrix in FIGS. 11A and 11B are as follows.

Core matrix for $V(H_1)$, $i_{LS} = 0$:

250 69 226 159 100 10 59 229 110 191 9 195 23 190 35 239 31 1 0

2 239 117 124 71 222 104 173 220 102 109 132 142 155 255 28 0 0 0

106 111 185 63 117 93 229 177 95 39 142 225 225 245 205 251 117 0 0

121 89 84 20 150 131 243 136 86 246 219 211 240 76 244 144 12 1 0

Core matrix for $V(H_2)$, $i_{LS} = 0$:

9 117 204 26 189 205 0 0

167 166 253 125 226 156 224 252 0 0

81 114 44 52 240 1 0 0

8 58 158 104 209 54 18 128 0 0

In the disclosure, a parity check matrix based on the following conditions may be considered for the parity check matrix corresponding to FIG. 10 above.

Submatrix A 1010 and submatrix B 1020 may be referred to as a first submatrix and a second submatrix, respectively. The circulant permutation matrix may refer to a circulant permutation matrix having a size of Z × Z determined based on the lifting size Z, and may be configured, for example, as in Equation 5 or Equation 6. In the disclosure, the circulant matrix may refer to a matrix in which circulant permutation matrices are overlapped.

Condition 1(a): In the parity check matrix for the QC-LDPC code in FIG. 10, if submatrix B 1020 does not include a circulant matrix in which circulant permutation matrices of size Z × Z are overlapped, the weights of all column blocks of the submatrix B 1020 are 2 or greater, and at least one column block whose weight is an odd number of 3 or greater may be included in the submatrix B 1020. The weights of all columns of the base matrix M(B) corresponding to the submatrix B 1020 are 2 or greater, and at least one column whose weight is an odd number of 3 or greater may be included in the base matrix $M$(B).

Condition 1(b): In the parity check matrix for the QC-LDPC code in FIG. 10, if the submatrix B 1020 includes at least one circulant matrix in which circulant permutation matrices of size Z × Z are overlapped, the weights of all column blocks of the submatrix B 1020 are 2 or greater, and at least one column block whose weight is an odd number of 3 or greater is included in the submatrix B 1020. In addition, in the weight matrix $W$(B) corresponding to the submatrix B 1020, the sum of the entries of all columns is 2 or greater, and at least one column whose sum of the entries of the columns is an odd number of 3 or greater is included in the weight matrix $W$(B). (The weight of the column block including the circulant matrix in which the above Z×Z circulant permutation matrices are overlapped may be 2 or 3 or more.)

Condition 2: All column and row weights of the submatrix E 1060 in FIG. 10 are 1. Both the column weight and the row weight of the submatrices of the base matrix and the weight matrix corresponding to the submatrix E 1060 are all 1. Therefore, E 1060 and the submatrices of the base matrix and the weight matrix corresponding to E 1060 are either identity matrices or matrices that may be converted to identity matrices by applying appropriate column permutations or row permutations. (That is, E 1060 is either an identity matrix or a matrix having identical algebraic characteristics.) If the parity check matrix in FIG. 10 is defined as a quasi-circular parity check matrix, the submatrix E may be divided into multiple Z×Z identity matrices.

FIGS. 11A and 11B above illustrate examples of parity check matrices that satisfy at least one of Condition 1(a), Condition 1(b), or Condition 2. As briefly described above, FIG. 11A illustrates an example of the case where K = 22*Z, $M_1$ = 4*Z, and $M_2$ = 2*Z in FIG. 10, and FIG. 11B illustrates an example of the case where K = 10*Z, $M_1$ = 4*Z, and $M_2$ = 7*Z in FIG. 10. Note that the code rate of the LDPC code corresponding to the parity check matrices in FIGS. 10, 11A, and 11B is K/N, so as $M_2$ decreases, codewords with lower code rates may be generated. In other words, according to the disclosure, LDPC encoding and decoding may be performed based on a parity check matrix that supports a lower code rate by further expanding the columns with order 1, including FIGS. 11A and 11B.

If a set of lifting sizes is used for LDPC encoding or decoding for the parity check matrix of a quasi-circular LDPC code, the number of columns of one column block of the parity check matrix must be greater than or equal to the minimum lifting size. For example, if the values in Table 6 are used as the lifting sizes, the number of columns of one column block of the parity check matrix may be at least 4 or more. Therefore, in a communication system where the lifting sizes of Table 6 are practically applied to the parity check matrix of an LDPC code having the structure like FIGS. 10, 11A, and 11B that satisfies at least one of Condition 1(a), Condition 1(b), or Condition 2, this may indicate that the number of columns with order 3 in the submatrix B 1020 is at least 4 or more.

For reference, the core matrix in the parity check matrix, base matrix, or weight matrix may also be defined as satisfying at least one of Condition 1(a), Condition 1(b), or Condition 2 by adding one or two additional rows, as follows. However, for convenience, in the disclosure, the parity check matrix [A 1010 B 1020], which includes the submatrix B that satisfies only Condition 1(a) or Condition 1(b), is considered the core matrix (or kernel matrix or precoding matrix).

Core matrix of $M(\mathrm{H}_{\mathrm{BG1}})$:

0 1 2 3 5 6 9 10 11 12 13 15 16 18 19 20 21 22 23

0 2 3 4 5 7 8 9 11 12 14 15 16 17 19 21 22 23 24

0 1 2 4 5 6 7 8 9 10 13 14 15 17 18 19 20 24 25

0 1 3 4 6 7 8 10 11 12 13 14 16 17 18 20 21 22 25

0 1 26

Core matrix of $M(\mathrm{H}_{\mathrm{BG2}})$:

0 1 2 3 6 9 10 11

0 3 4 5 6 7 8 9 11 12

0 1 3 4 8 10 12 13

1 2 4 5 6 7 8 9 10 13

0 1 11 14

As an example of the disclosure, a method for improving the performance of LDPC codes and the decoding convergence speed according to the weight matrix will be described.

The core matrix of the base matrix 2 $M(\mathrm{H}_{\mathrm{BG2}})$ defined in [Base matrix Determination Method] is configured as four rows, which may also be expressed as a weight matrix as in Equation 14. Since the LDPC code defined by the base matrix 1 $M(\mathrm{H}_{\mathrm{BG1}})$ or base matrix 2 $M(\mathrm{H}_{\mathrm{BG2}})$ is defined such that one circulant permutation matrix corresponds to one $Z \times Z$ block, the base matrix and the weight matrix are essentially the same.

[Equation 14]

$$W(\mathrm{H}_{\mathrm{BG2}}) = \begin{bmatrix} 1 & 1 & 1 & 1 & 0 & 0 & 1 & 0 & 0 & 1 & 1 & 1 & 0 & 0 \\ 1 & 0 & 0 & 1 & 1 & 1 & 1 & 1 & 1 & 1 & 0 & 1 & 1 & 0 \\ 1 & 1 & 0 & 1 & 1 & 0 & 0 & 0 & 1 & 0 & 1 & 0 & 1 & 1 \\ 0 & 1 & 1 & 0 & 1 & 1 & 1 & 1 & 1 & 1 & 1 & 0 & 0 & 1 \end{bmatrix}$$

LDPC code, which is designed so that at most one circulant permutation matrix corresponds to one $Z \times Z$ block, is a structure suitable for performing layered decoding in units of one row block during decoding. In other words, the structure of LDPC code is suitable for performing decoding using a Z-unit parallel processing processor.

This layered decoding method typically performs parallel processing on a single row block as the basic unit. Therefore, when decoding is performed for the total number of row blocks, one iteration of decoding may be determined to be completed. This may indicate that, if sufficient parallel processing processors are available, the decoding throughput through layered decoding is inversely proportional to the number of row blocks. However, in the case where the same code length is supported using a parity check matrix with a smaller number of row blocks, the lifting size Z value increases further, thus increasing the number of parallel processing processors required to simultaneously decode a single row block.

For example, the above weight matrix $W(\mathrm{H}_{\mathrm{BG2}})$ includes 4 rows and 14 columns, and the weights of the respective columns are 3, 3, 2, 3, 3, 2, 3, 2, 3, 3, 3, 2, 2, 2. The weight matrix $W(\mathrm{H}'_{\mathrm{BG2}})$ including 3 rows and 13 columns and having a similar weight distribution to $W(\mathrm{H}_{\mathrm{BG2}})$, and the weight matrix $W(\mathrm{H}''_{\mathrm{BG2}})$ of 2 rows and 12 columns and having a similar weight distribution to $W(\mathrm{H}_{\mathrm{BG2}})$ may be configured as follows.

$$W(\mathrm{H}'_{\mathrm{BG2}}) = \begin{bmatrix} 1 & 1 & 1 & 1 & 1 & 1 & 1 & 0 & 1 & 1 & 1 & 1 & 0 \\ 1 & 1 & 0 & 1 & 1 & 1 & 1 & 1 & 1 & 1 & 1 & 1 & 1 \\ 1 & 1 & 1 & 1 & 1 & 0 & 1 & 1 & 1 & 1 & 1 & 0 & 1 \end{bmatrix},$$

$$W(\mathrm{H}''_{\mathrm{BG2}}) = \begin{bmatrix} 2 & 1 & 1 & 2 & 1 & 1 & 2 & 1 & 1 & 2 & 1 & 1 \\ 1 & 2 & 1 & 1 & 2 & 1 & 1 & 1 & 2 & 1 & 2 & 1 \end{bmatrix}.$$

If LDPC codes with the same code length may be generated using the respective weight matrices $W(\mathrm{H}_{BG2})$, $W(\mathrm{H}'_{BG2})$, and $W(\mathrm{H}''_{BG2})$, and the lifting sizes corresponding to the respective parity-check matrices are $Z_1$, $Z_2$, and $Z_3$, then there is a relationship of $Z_3 = \frac{14}{12}Z_1$ and $Z_2 = \frac{13}{12}Z_1$. If $Z_i$ parallel processing processors are allowed in the LDPC decoder, the approximate decoding information throughput of $W(\mathrm{H}'_{BG2})$ may be 1.5 times that of $W(\mathrm{H}_{BG2})$, and the throughput of $W(\mathrm{H}''_{BG2})$ may be 2 times that of $W(\mathrm{H}_{BG2})$.

As described above, when sufficient parallel processing processors are allowed, reducing the number of row blocks may increase the decoding information throughput inversely. Therefore, in systems requiring very high decoding information throughput, it is advantageous, if more parallel processing processors may be applied, to keep the number of rows of the base matrix or weight matrix, e.g., the number of row blocks of the parity check matrix, small.

Although keeping the number of rows of the base matrix or weight matrix, e.g.,, the number of row blocks of the parity check matrix, small may be good from the perspective of decoding information throughput, when the number of row blocks is configured too small, it may cause serious limitations on algebraic characteristics such as the cycle characteristics or minimum distance characteristics of the LDPC code, resulting in performance degradation. Therefore, the base matrix or weight matrix must be determined by simultaneously considering the target information throughput and target error correction capability of the system.

According to an embodiment of the disclosure, a method for improving code performance while increasing decoding information throughput is provided. The disclosure provides algebraic characteristics that the core matrix part of the base matrix or weight matrix, which is closely related to the maximum decoding throughput or peak data rate of the system, must satisfy. When the parity check matrix does not include the second part of the parity check matrix, of submatrices C 1040, D 1050, and E 1060 in FIG. 10, the core matrix may be identical to the base matrix or weight matrix.

One of the conditions that the core matrix of the parity check matrix must satisfy is that when two columns with only one non-zero entry are selected from the weight matrix corresponding to the core matrix, only one row should not include non-zero entries, such as $\begin{bmatrix} 0 & 0 \\ \vdots & \vdots \\ w_1 & w_2 \\ \vdots & \vdots \\ 0 & 0 \end{bmatrix} (w_1, w_2 \geq 1)$. Simple examples are $\begin{bmatrix} w_1 & w_2 \\ 0 & 0 \end{bmatrix}$, $\begin{bmatrix} 0 & 0 \\ w_1 & w_2 \end{bmatrix}$, $\begin{bmatrix} w_1 & w_2 \\ 0 & 0 \\ 0 & 0 \end{bmatrix}$, or $\begin{bmatrix} 0 & 0 \\ w_1 & w_2 \\ 0 & 0 \end{bmatrix}$. Since the minimum distance of a parity check matrix corresponding to a weight matrix including such a structure or to a core matrix thereof is equal to or less than $w_1 + w_2$, an error floor phenomenon is highly likely to occur. Therefore, in any two columns with only one non-zero entry, the non-zero entries must be located in different rows as shown in $\begin{bmatrix} w_1 & 0 \\ 0 & w_2 \end{bmatrix}$, $\begin{bmatrix} w_1 & 0 \\ 0 & w_2 \\ 0 & 0 \end{bmatrix}$, or $\begin{bmatrix} w_1 & 0 \\ 0 & 0 \\ 0 & w_2 \end{bmatrix}$. This also indicates that, in the base matrix, all non-zero entries located in columns having a weight of 1 are located in different rows from each other. The above description may be defined as Conditions 3(a) and 3(b) below.

Condition 3(a): All columns of the base matrix or the weight matrix corresponding to the core matrix have weights 2 or greater, or the number of columns with weight 1 is at most 1.

Condition 3(b): If there are two or more columns with weight 1 among the columns of the base matrix or weight matrix corresponding to the core matrix, the non-zero entries included in the columns with weight 1 are located in different rows.

Conditions 3(a) and 3(b) above may indicate that when the number of column blocks of only one circulant permutation matrix or circulant matrix included in the core matrix is at most 1, or when two or more column blocks of only one circulant permutation matrix or circulant matrix are included in the core matrix, the $Z \times Z$ circulant permutation matrices or circulant matrices are necessarily included in different row blocks. Conditions 3(a) and 3(b) above have structures designed to prevent severe error floor phenomena, and the following Condition 4 may be added to achieve even better error floor characteristics. As described above, the circulant permutation matrix or circulant matrix may have a $Z \times Z$ size.

Condition 4: The weight of the column corresponding to the information bits (or input bits or code block) in the parity check matrix corresponding to the core matrix is 3 or greater.

Condition 4 above prevents the column corresponding to the information bits from having a weight of 2, as in the parity check matrix corresponding to the base matrix $2 M(\mathrm{H}_{BG2})$ of Equation 14, thereby reducing encoding gain, but it may be applied when attempting to improve the error floor phenomenon.

Condition 4 above may indicate that, in the parity check matrix for the QC-LDPC code, if the submatrix A 1010 does not include a circulant matrix in which $Z \times Z$ circulant permutation matrices are overlapped, the weights of all column blocks of the submatrix A 1010 is 3 or greater, and the weights of all columns of the base matrix M(A) corresponding to the submatrix A 1010 is 3 or greater. In the parity check matrix for the QC-LDPC code, if the submatrix A 1010 includes at least one circulant matrix in which $Z \times Z$ circulant permutation matrices are overlapped, the weights of all column blocks of the submatrix A 1010 are 3 or greater, and the sum of the entries of all columns of the weight matrix W(A) corresponding to the submatrix A 1010 is 3 or greater.

Another condition that the core matrix of the parity check matrix must satisfy is that the weight matrix corresponding to the core matrix does not include any entries equal to or greater than 3. In general, if the core matrix of the weight matrix includes an entry that is an integer equal to or greater than 3, it may indicate that three or more circulant permutation matrices correspond to that position. However, if three or more circulant permutation matrices comprising a $Z \times Z$ circulant matrix overlap, the maximum cycle length is limited to 6, regardless of the Z value. When the cycle length is short, the performance improvement effect of iterative decoding is reduced. Therefore, a parity check matrix corresponding to a weight matrix or core matrix including entries with values equal to or greater than 3 is appropriate for use when the code length is short or the code rate is relatively high. Since this disclosure covers the design of LDPC codes that support various code rates and code lengths, the core matrix of the weight matrix must not include entries with values equal to or greater than 3. (However, the portion corresponding to the single parity check extension part may include entries with values equal to or greater than 3.) The above may be defined as Condition 5 below.

Condition 5: The weight matrix corresponding to the core matrix must include solely of 0 and 1, or 0, 1, and 2.

Another condition that the core matrix must satisfy is that the submatrix B 1020 in FIG. 10, corresponding to the first parity vector $w_1$, must have the full rank to enable efficient encoding, and to prevent significant degradation of cycle characteristics, a restrictive structure, as described below, is desirable.

Condition 6(a): If the weight matrix corresponding to the core matrix includes four rows, then the submatrix corresponding to B 1020 in the weight matrix and base matrix is one of the following:

$$\begin{bmatrix} 1 & 1 & 0 & 0 \\ 1 & 1 & 1 & 0 \\ 0 & 0 & 1 & 1 \\ 1 & 0 & 0 & 1 \end{bmatrix}, \begin{bmatrix} 1 & 1 & 0 & 0 \\ 0 & 1 & 1 & 0 \\ 1 & 0 & 1 & 1 \\ 1 & 0 & 0 & 1 \end{bmatrix}, \begin{bmatrix} 1 & 1 & 0 & 0 \\ 1 & 1 & 1 & 0 \\ 0 & 0 & 1 & 1 \\ 1 & 0 & 1 & 1 \end{bmatrix}, \begin{bmatrix} 1 & 1 & 0 & 0 \\ 0 & 1 & 1 & 0 \\ 1 & 1 & 1 & 1 \\ 1 & 0 & 1 & 1 \end{bmatrix}$$

$$\begin{bmatrix} 1 & 1 & 0 & 0 \\ 0 & 1 & 1 & 0 \\ 1 & 1 & 1 & 1 \\ 1 & 0 & 1 & 1 \end{bmatrix}, \begin{bmatrix} 1 & 1 & 0 & 0 \\ 0 & 1 & 1 & 0 \\ 1 & 0 & 1 & 1 \\ 1 & 1 & 1 & 1 \end{bmatrix}.$$

Condition 6(b): If the weight matrix corresponding to the core matrix includes three rows, then the submatrix of the base matrix corresponding to the submatrix B 1020 is $\begin{bmatrix} 1 & 1 & 0 \\ 1 & 1 & 1 \\ 1 & 0 & 1 \end{bmatrix}$, and the weight matrix is one of the following:

$$\begin{bmatrix} 1 & 1 & 0 \\ 1 & 1 & 1 \\ 1 & 0 & 1 \end{bmatrix}, \begin{bmatrix} 1 & 1 & 0 \\ 0 & 1 & 1 \\ 2 & 0 & 1 \end{bmatrix}, \begin{bmatrix} 2 & 1 & 0 \\ 0 & 1 & 1 \\ 1 & 0 & 1 \end{bmatrix}, \begin{bmatrix} 1 & 2 & 0 \\ 0 & 1 & 1 \\ 2 & 0 & 1 \end{bmatrix}, \begin{bmatrix} 1 & 2 & 0 \\ 0 & 1 & 2 \\ 2 & 0 & 1 \end{bmatrix}.$$

Condition 6(c): If the weight matrix corresponding to the core matrix includes two rows, the submatrix of the base matrix corresponding to submatrix B 1020 is $\begin{bmatrix} 1 & 1 \\ 1 & 1 \end{bmatrix}$, and the weight matrix is one of the following: $\begin{bmatrix} 1 & 1 \\ 2 & 1 \end{bmatrix}, \begin{bmatrix} 1 & 2 \\ 2 & 1 \end{bmatrix}.$

For reference, Condition 6(a) above shows the case where the weight matrix and the base matrix are identical, and Condition 6(b) shows that the weight matrix has the same form as the base matrix only when $\begin{bmatrix} 1 & 1 & 0 \\ 1 & 1 & 1 \\ 1 & 0 & 1 \end{bmatrix}$. In the base matrix or weight matrix shown in Conditions 6(a), 6(b), and 6(c), 0 represents a $Z \times Z$ 0-matrix, and 1 represents a $Z \times Z$ identity matrix $I = (P^0)$ or circulant permutation matrix $P^v$ (v > 0). In addition, 2 denotes a $Z \times Z$ circular matrix $(P^{v1} + P^{v2})$ ($v_1$,

$v_2 \geq 0$, $v_1 \neq v_2$).

In general, an upper bound on the cycle length may be estimated from the base matrix or weight matrix, but the cycle characteristics of the parity check matrix corresponding to the base matrix or weight matrix are unknown. For example, if the submatrix B 1020 is $\begin{bmatrix} I & I \\ P^{v_1} + P^{v_2} & I \end{bmatrix}$ or $\begin{bmatrix} I & I & 0 \\ P^{v_1} & I & I \\ P^{v_2} & 0 & I \end{bmatrix}$, then in each case, regardless of the values of v1 and v2, the base matrix or weight matrix is the same as $\begin{bmatrix} 1 & 1 \\ 2 & 1 \end{bmatrix}$ or $\begin{bmatrix} 1 & 1 & 0 \\ 1 & 1 & 1 \\ 1 & 0 & 1 \end{bmatrix}$, but the cycle characteristics differ significantly. In the case of $\begin{bmatrix} I & I \\ P^{v_1} + P^{v_2} & I \end{bmatrix}$, if at least one of v1 or v2 is 0 or $v_1 \equiv v_2 \left( \mathrm{mod} \frac{Z}{2} \right)$ (or $v_1 - v_2 \equiv \frac{Z}{2} (\mathrm{mod}\ Z)$ ), a large number of 4-cycles are generated. Therefore, by default, v1 and v2 are set to integers satisfying $v_1, v_2 (\mathrm{mod}\ Z) > 0$, $v_1 \not\equiv v_2 \left( \mathrm{mod} \frac{Z}{2} \right)$ (or $v_1 - v_2 \not\equiv \frac{Z}{2} (\mathrm{mod}\ Z)$ ). Similarly, in the case of $\begin{bmatrix} I & I & 0 \\ P^{v_1} & I & I \\ P^{v_2} & 0 & I \end{bmatrix}$, since a large number of 4-cycles are generated when v1 = 0, v1 is set to an integer satisfying $v_1 \ (\mathrm{mod}\ Z) \geq 1$, and v2 is set to an integer satisfying $v_2 (\mathrm{mod}\ Z) \geq 0$ by default. The above description is only for a method for eliminating 4-cycles, and the values of v1 and v2 may be restricted in various ways to obtain longer cycles.

If the communication system applies the puncturing of information bits described in [Table 9], the following conditions that the core matrix must satisfy may be added.

Condition 7: In an LDPC encoding system where puncturing of information bits is applied, the submatrix of the core matrix, which includes only columns corresponding to the punctured information bits, must have at least one row having a row weight of 1.

Since bits punctured at the receiver are considered as bits erased during the reception process, the probabilities of the punctured bits being 0 and 1 are considered to be equal. This typically indicates 1 when performing decoding using LR values and 0 when performing decoding using LLR values. However, it may be determined in different ways based on the values used during the decoding process. When LDPC decoding is performed based on a parity check matrix that does not satisfy Condition 7, the punctured information bits may not be decoded unless maximum likelihood (ML) decoding or pseudo-ML decoding is used. Since ML or pseudo-ML decoding methods are not commonly used due to their complexity, the parity check matrix may be determined to satisfy Condition 7 to ensure decoding success.

If the LDPC code is a QC-LDPC code, the parity check matrix may be expressed based on the lifting size Z value and the base matrix, weight matrix, and/or exponent matrix. Therefore, it may be expressed as in Condition 8 below.

Condition 8: In a QC-LDPC encoding system where information bits are punctured by lifting size Z or its multiples, a submatrix of the base matrix, including only a columns corresponding to a submatrix of a core matrix including only a*Z columns corresponding to the punctured a*Z (a: integer greater than or equal to 1) information bits, has at least one row of weight 1. Furthermore, a submatrix of the weight matrix, including only columns corresponding to a submatrix of a core matrix including only a*Z columns, has at least one row having a weight of 1 and an entry of 1.

For example, in a QC-LDPC encoding system where information bits of 2Z bits are always punctured, Condition 8 implies that a = 2.

In the disclosure, at least one of the above conditions may be used to construct a parity check matrix. For example, the parity check matrix may be determined to satisfy one of the above conditions or a combination of at least two of the above conditions.

According to an embodiment of the disclosure, a method for improving the error floor performance of an LDPC code is proposed. In general, the error floor phenomenon of an LDPC code is significantly affected by the cycle characteristics of the Tanner graph. However, in the case of a QC LDPC code, since the cycle characteristics of the Tanner graph are determined by the relationship in the exponent or circular shift value between the base matrix and the circulant permutation matrix, not only the position of the circulant permutation matrix of the parity check matrix, but also the circular shift value must be appropriately selected.

The disclosure provides algebraic characteristics that the submatrix B 1020 corresponding to the first parity bits (or the first parity bit vector) $w_1 = (w_{1,0}, w_{1,1}, w_{1,2}, \ldots, w_{1,M_1-1})$ in the first part of the parity check matrix including submatrices A 1010 and B 1020 in FIG. 10 must satisfy.

The size of the submatrix B 1020 is $M_1 \times M_1$ (or $m_{b1}Z \times m_{b1}Z$), and the submatrix B 1020 corresponds to a base matrix or weight matrix of size $\left( \frac{M_1}{Z} \right) \times \left( \frac{M_1}{Z} \right)$ (or $m_{b1} \times m_{b1}$). The first column block of the submatrix B 1020 includes three circulant permutation matrices. In this case, the circulant permutation matrix may include an identity matrix. For example, in the disclosure, the circulant permutation matrix is defined as a matrix in which the respective entries of the identity matrix are circularly shifted by i. When the value of i is 0, the circulant permutation matrix may be an identity matrix. This may be applied throughout the detailed description of the disclosure. The remaining column blocks of submatrix B 1020 include two circulant permutation matrices or identity matrices. For convenience, the disclosure only expresses the remaining column blocks when the identity matrix is structured in a double diagonal structure, but this need not generally be so limited.

Equation 15 illustrates a specific example of the submatrix B 1020. Submatrix B 1020 may be determined based on at least one of the matrices included in Equation 15 below. However, the disclosure is not limited thereto, and various matrices satisfying the above characteristics (the first column block includes three circulant permutation matrices, and the remaining column blocks including two circulant permutation matrices or identity matrices) may be considered.

[Equation 15]

$$B_1 = \begin{bmatrix} P^a & I & O \\ P^b & I & I \\ P^c & O & I \end{bmatrix}, B_{2,1} = \begin{bmatrix} P^a & I & O & O \\ P^b & I & I & O \\ O & O & I & I \\ P^c & O & O & I \end{bmatrix}$$

$$B_{2,2} = \begin{bmatrix} P^a & I & O & O \\ O & I & I & O \\ P^b & O & I & I \\ P^c & O & O & I \end{bmatrix}, B_3 = \begin{bmatrix} P^a & I & O & O & O \\ O & I & I & O & O \\ P^b & O & I & I & O \\ O & O & O & I & I \\ P^c & O & O & O & I \end{bmatrix}$$

$$M(B_1) = \begin{bmatrix} 1 & 1 & 0 \\ 1 & 1 & 1 \\ 1 & 0 & 1 \end{bmatrix}, M(B_{2,1}) = \begin{bmatrix} 1 & 1 & 0 & 0 \\ 1 & 1 & 1 & 0 \\ 0 & 0 & 1 & 1 \\ 1 & 0 & 0 & 1 \end{bmatrix}$$

$$M(B_{2,2}) = \begin{bmatrix} 1 & 1 & 0 & 0 \\ 0 & 1 & 1 & 0 \\ 1 & 0 & 1 & 1 \\ 1 & 0 & 0 & 1 \end{bmatrix}, M(B_3) = \begin{bmatrix} 1 & 1 & 0 & 0 & 0 \\ 0 & 1 & 1 & 0 & 0 \\ 1 & 0 & 1 & 1 & 0 \\ 0 & 0 & 0 & 1 & 1 \\ 1 & 0 & 0 & 0 & 1 \end{bmatrix}$$

$$V(B_{2,1}) = \begin{bmatrix} a & 0 & -1 & -1 \\ b & 0 & 0 & -1 \\ -1 & -1 & 0 & 0 \\ c & -1 & -1 & 0 \end{bmatrix}, V(B_3) = \begin{bmatrix} a & 0 & -1 & -1 & -1 \\ -1 & 0 & 0 & -1 & -1 \\ b & -1 & 0 & 0 & -1 \\ -1 & -1 & -1 & 0 & 0 \\ c & -1 & -1 & -1 & 0 \end{bmatrix}$$

In Equation 15 above, $B_1$, $B_{2,1}$, $B_{2,2}$, and $B_3$ have the first column block including three different circulant permutation matrices $P^a$, $P^b$, $P^c$. addition, Equation 15 only shows the cases where $m_{b1}$ values are 3, 4, and 5 for convenience, but the submatrix B 1020 may be similarly defined for integers greater than that. Matrices that may be transformed into a submatrix B 1020 in the above form through an appropriate invertible transform process may be considered algebraically identical matrices.

The disclosure provides a method to improve the cycle characteristics not only for $B_1$, $B_{2,1}$, $B_{2,2}$, and $B_3$ of Equation 15, but also for larger submatrix B 1020 of similar form. For convenience, detailed descriptions of a method for analyzing the cycle characteristics of QC LDPC codes and some algebraic characteristics are omitted from this disclosure, but reference is made to [Myung2005].

[Myung2005]

S. Myung, K. Yang, and J. Kim, "Quasi-Circular LDPC Codes for Fast Encoding," IEEE Transactions on Information Theory, vol. 51, No. 8, pp. 2894-2901, Aug. 2005.

If, as in Equation 15, the remaining column blocks, excluding the first column block, in submatrix B 1020 have a dual diagonal structure including identity matrices, at least two of the exponents (or circular shift values) a, b, and c of the circulant permutation matrix of the first column block were previously set to the same value for encoding convenience. In this case, the $Z \times Z$ $\phi$ matrix used in the encoding process becomes the identity matrix $I$ or a simple circulant permutation matrix $P^x$, so that the inverse matrix $\phi^{-1}$ of $\phi$ is simplified to identity matrix $I$ or $P^{-x}$, encoding process for QC LDPC codes, see [Myung2005].) As a specific example, when a = c is set, $\phi$ becomes $P^b$, and $\phi^{-1}$ becomes $P^{-b}$, enabling efficient encoding. Similarly, when a = b is set, $\phi$ becomes $P^c$, and $\phi^{-1}$ becomes $P^{-c}$, enabling efficient encoding.

However, in the case where $a = c \neq b$, there are always Z cycles of length $2m_{b1}$ on a Tanner graph due to the structure shown in Equation 16 below. In other words, if the value of $m_{b1}$ is fixed, a cycle of length $2m_{b1}$ always exists, regardless of the lifting size Z and the exponent a(=c). (For a detailed description of the cycle characteristics of QC LDPC codes, see [Myung2005].)

$$[\text{Equation 16}]$$

$$\begin{bmatrix} P^a & I & * & * & * \\ * & I & I & * & * \\ * & * & \ddots & \ddots & * \\ * & * & * & I & I \\ P^a & * & * & * & I \end{bmatrix}$$

In the case of a = b, due to the structure shown in Equation 17 below, there is always a cycle shorter than $2m_{b1}$ regardless of the lifting size Z and the exponent a(=b) value.

$$[\text{Equation 17}]$$

$$\begin{bmatrix} P^a & I & * \\ P^b & I & * \\ * & * & * \end{bmatrix}, \begin{bmatrix} P^a & I & * & * \\ * & I & I & * \\ P^b & * & I & * \\ * & * & * & * \end{bmatrix}$$

If the value of $m_{b1}$ is appropriately large, the cycle characteristics of the Tanner graph corresponding to structures such as Equations 16 and 17 may not significantly affect the performance of the LDPC code. However, if the value of $m_{b1}$ is relatively small, the BLER may increase due to the error floor phenomenon, which becomes a significant problem as the target BLER of the system decreases.

To address this issue, the disclosure provides a method for improving cycle characteristics by restricting the exponents (or circular shift values) a, b, and c of the circulant permutation matrices of the first column block of submatrix B 1020, which has a structure as shown in Equation 15, to satisfy specific algebraic conditions. The disclosure demonstrates that the method improves cycle characteristics while reasonably increasing the computational complexity associated with the $\phi^{-1}$ matrix required for LDPC encoding.

If the parity check matrix of the QC LDPC code has a lifting size Z of $Z = p \cdot 2^L$ (p is an odd integer and L is an integer greater than or equal to 0), then the exponents (or circular shift values) a, b, and c of the circulant permutation matrices comprising the first column block of submatrix B 1020 are different integers and satisfy at least part or all of the following conditions.

Exponent Condition 1a: At least one of the differences between two exponents (circular shift values) is a value whose greatest common divisor with the lifting size Z is 1 or is the smallest of divisors of Z greater than 1. (e.g., it is relatively prime to Z, or has a greatest common divisor with Z that is the smallest divisor of Z greater than 1.)

Exponent Condition 1b: Two of the differences between two exponents are values whose greatest common divisor with a lifting size Z is 1 or are the smallest of divisors of Z greater than 1.

Exponent Condition 2a: At least one of the differences between two exponents is $\frac{Z}{2^i}$ $(0 \leq i \leq L)$.

Exponent Condition 2b: At least one of the differences between two exponents is $(1 \leq i < L)$ when $p$ is 1 and L>1, and $\frac{Z}{2^i}$ $(1 \leq i \leq L)$ when $p$ is an odd integer greater than or equal to 3 and L>0.

For reference, the differences between exponents used in the above exponent conditions refer to |a - b|, |b - c|, |c - a|, etc.

According to Exponent Condition 1a, when the difference between two exponents is relatively prime to Z, the length of the cycle determined by the circulant permutation matrix associated with the two exponents is maximized. For example, when the value of |a - b| is relatively prime to Z, the length of the cycle on the Tanner graph determined by $\begin{bmatrix} P^a & I & * \\ P^b & I & * \\ * & * & * \end{bmatrix}$ in Equation 17 is 4Z. If the greatest common divisor of |a - b| and Z is D, the cycle length becomes 4Z/D. As a result, as the value of Z increases, the cycle length also increases.

As another example, if the value of |a - c| is relatively prime to Z, the cycle length determined by the structure of Equation 16 becomes $2m_{b1}Z$. If the greatest common divisor of |a - c| and Z is D, the cycle length becomes $2m_{b1}Z/D$. Consequently, the cycle length is not fixed regardless of the value of Z, but rather increases as the value of Z increases. Considering only the cycle characteristics, it is desirable for the difference between the exponents to be relatively prime to Z. However, depending on the situation, the exponents may be selected so that the greatest common divisor D is small (for example, so that it is the smallest divisor of Z greater than 1) based on other conditions. For example, if the characteristic of the difference between the exponents being relatively prime to Z cannot be satisfied, it is desirable to select an exponent that makes the greatest common divisor D small.

Exponent Condition 1b is a condition that further improves the cycle characteristics by restricting the exponent conditions more than exponent condition 1a. For example, when the values of |a - b| and |b - c| are relatively prime to Z, not only is the cycle characteristic related to the exponents a and b improved, as in $\begin{bmatrix} P^a & I & * \\ P^b & I & * \\ * & * & * \end{bmatrix}$, but the cycle characteristic related to the exponents b and c, as in $\begin{bmatrix} * & * & * \\ P^b & * & I \\ P^c & * & I \end{bmatrix}$, is also improved. (This is also applied to Equation 15 and other forms of submatrix B extended based on Equation 15.)

For Equation 15 and other forms of submatrix B extended based on Equation 15, when a, b, and c are all different, the $\phi$ matrix required in the encoding process is defined as $\phi = P^a + P^b + P^c$. $\phi\phi^{-1}$, but also often has a high density of weights, rather than a low density. That is, the $\phi$ matrix with a low density characteristic may not guarantee the low density characteristic of the $\phi^{-1}$ matrix. Since this high density of the $\phi^{-1}$ matrix increases encoding complexity, it is desirable for the density of the $\phi^{-1}$ matrix to be as low as possible, and for the $\phi^{-1}$ matrix to have a simple structure.

Exponent Conditions 2a and 2b above are conditions for simplifying the $\phi^{-1}$ matrix as much as possible for efficient LDPC encoding. For example, in the above Exponent Condition 2a, if $|a - c| = \frac{Z}{2^i}$,

$$\phi^{2^i} = P^{2^i a} + P^{2^i b} + P^{2^i c} = P^{2^i a}\left(I + P^{2^i(c-a)}\right) + P^{2^i b} = P^{2^i \cdot b}$$

and then $\phi^{-1} = P^{-2^i b} \cdot \phi^{2^i - 1}$. Here, $\phi^{2^i-1}$ is as follows.

$$\phi^{2^i-1} = \phi^{2^{i-1}} \cdot \phi^{2^{i-2}} \cdot \cdots \cdot \phi^2 \cdot \phi = \left(P^{2^{(i-1)}a} + P^{2^{(i-1)}b} + P^{2^{(i-1)}c}\right)\left(P^{2^{(i-2)}a} + \right.$$

$$\left. P^{2^{(i-2)}b} + P^{2^{(i-2)}c}\right) \cdot \cdots \cdot (P^{2a} + P^{2b} + P^{2c}) \cdot (P^a + P^b + P^c)$$

Accordingly, $\phi^{-1}$ may be determined relatively easily, but the computational complexity due to $\phi^{-1}$ increases as the value of i increases. Therefore, the value of i may be appropriately restricted depending on the allowable complexity of the system. Normally, it is desirable to use the value of $i$ in the range $0 \leq i \leq 4$, but a larger value may be used depending on the allowable range of the system.

For reference, the operation $P^x \cdot \underline{v}^T$, which multiplies an arbitrary bit string $\underline{v}^T$ of length Z by a Z×Z circulant permutation matrix $P^x$, a circular shift of x bits on the bit string $\underline{v}^T$ rather than an actual matrix multiplication operation. That is, since it may actually be implemented as a bit shift operation rather than a matrix multiplication operation, the above operation may refer to a calculation or operation with very low complexity. In the process of calculating $\phi^{2^i-1} \cdot \underline{v}^T$, the computational complexity may be minimized through step-by-step calculations such as $\phi^{2^i-1}\underline{v}^T = \phi^{2^i-1}\left(\cdots(\phi^2(\phi \cdot \underline{v}^T))\right)$ rather than expanding and calculating each term of $\phi^{2^i-1}$. As a simple example, the operation may be performed in the following way:

$$\left(P^{2a} + P^{2b} + P^{2c}\right) \cdot \left(P^a + P^b + P^c\right) \cdot \underline{v}^T = P^{3a}\left(I + P^{2(b-a)} + P^{2(c-a)}\right) \cdot \left(I + P^{b-a} + P^{c-a}\right) \cdot \underline{v}^T = P^{3a}\left(I + P^{2(b-a)} + P^{2(c-a)}\right) \cdot \left(\underline{v}^T + P^{b-a} \cdot \underline{v}^T + P^{c-a} \cdot \underline{v}^T\right) = P^{3a}\left(I + P^{2(b-a)} + P^{2(c-a)}\right) \cdot \underline{v}_1^T = P^{3a}\left(\underline{v}_1^T + P^{2(b-a)} \cdot \underline{v}_1^T + P^{2(c-a)} \cdot \underline{v}_1^T\right) = P^{3a} \cdot \underline{v}_2^T..$$

In Exponent Condition 2a above, encoding may be performed by determining $\phi^{-1}$ in the same manner even when $|a - b| = \frac{Z}{2^i}$ or $|b - c| = \frac{Z}{2^i}$ . However, if all differences between two exponents are of the form $\frac{Z}{2^i}$, the cycle characteristics are likely to deteriorate. Therefore, for efficient encoding and good cycle characteristics, a method may be considered in which at least one of the differences between the two exponents satisfies the property $\frac{Z}{2^i}$ $(0 \le i \le L)$, and the remaining exponent differences satisfy either Exponent Condition 1a or Exponent Condition 1b. Furthermore, if the difference between the two exponents is $\frac{Z}{2^i}$ and at least one of Exponent Condition 1a or Exponent Condition 1b is satisfied, the above exponents may be selected.

Exponent Condition 2b is a more restrictive condition than Exponent Condition 2a, enabling efficient encoding while further improving cycle characteristics. When Exponent Condition 2b is satisfied, encoding complexity increases slightly compared to existing 5G LDPC codes, but cycle characteristics are improved. If Exponent Condition 2b is not satisfied, the exponents may be determined by considering Exponent Condition 2a. For reference, it may be seen that, except for cases where $\frac{Z}{2^i} = 1$ is satisfied under Exponent Condition 2a, the difference between the two exponents is always non-prime to Z. That is, the difference between Z and the two exponents has a common divisor greater than 1. The existence of an i satisfying $\frac{Z}{2^i} = 1$ implies that $Z = 2^L$, which requires Exponent Condition 2b to be satisfied, so that the difference between Z and the two exponents is not relatively prime and has $2^{L-i}$ as the common divisor by the condition $1 \le i < L$.

As an example of the disclosure, a more specific example of constructing submatrix B 1020 in FIG. 10 using the above exponent conditions will be described.

A communication or broadcasting system, such as 5G, is considered in which a set of lifting sizes is defined, as shown in Tables 3 to 8, and only the lifting sizes included in the lifting size set may be applied. A separate parity check matrix or exponent matrix may be defined for each lifting size set. For example, in the cases shown in Tables 3 to 8, parity-check matrices or exponent matrices may be defined for eight set indexes, respectively.

It is assumed that a, b, and c are determined in Equations 15 and a different form of submatrix B extended based on 15 as follows. In general, the exponents a, b, and c for submatrix B of the parity check matrix corresponding to $i_{LS} = k$ (k = 0, 1, 2, ...) may all be different, so, for convenience, they are expressed as $a_k$, $b_k$, $c_k$.

Exponent Selection Example 1 ($i_{LS} = k$

- $a_k$ is any integer.
- $b_k$ is $b_k = a_k + s_k$ , where $s_k$ is an integer satisfying gcd($s_k$, $Z_k$) = 1 . That is, among the exponents corresponding to submatrix B, $a_k$ and $b_k$ are integers satisfying gcd($|a_k - b_k|$, $Z_k$) = 1 . Here, gcd(x,y) denotes the greatest common divisor of x and y, and $Z_k$ denotes any lifting size within the lifting size set corresponding to $i_{LS} = k$.
- $c_k$ is $c_k = a_k + t_k$, where $t_k$ is one of the lifting sizes, included in the lifting size set corresponding to $i_{LS} = k$, $Z_{k,max}$.

If the difference of exponents for submatrix B determined through Exponent Selection Example 1 above is obtained, Exponent Condition 1a is satisfied because $|a_k - b_k| = |s_k|$ for any lifting size $Z_k$, and since $t_k$ is one of the $Z_k$ values in $|b_k - c_k| = |s_k - t_k|$ while the respective $Z_k$ values are multiples of each other ($2^i$ multiple relationship), according to the definition of $s_k$, gcd$s_k$, $Z_k$) = gcd($s_k$ - $Z_k$, $Z_k$) $s_k$ - $t_k$, $Z_k$) is established, thereby also satisfying Exponent Condition 1b. However, since $|c_k - a_k| = t_k = \frac{Z_{max}}{2^i} = p \cdot 2^{(L-i)}$, whether or not Exponent Conditions 2a and 2b are satisfied depends on the lifting size $Z_k$. $Z_k > t_k$, Exponent Conditions 2a and 2b are always satisfied. However, when $Z_k \le t_k$, $c_k = a_k + t_k \equiv a_k$ (mod $Z_k$) is established, so the circulant permutation matrices $P^{a_k}$ and $P^{c_k}$ of size $Z_k \times Z_k$ become substantially identical, and thus Exponent Conditions 2a and 2b may not be satisfied. In other words, when $Z_k \le t_k$, the structure is as in Equation 16, which may indicate that the cycle characteristics are not improved. In conclusion, to improve cycle characteristics for lifting sizes of various lengths, it is desirable to configure $t_k$ as small as possible.

However, if the lifting size $Z_k$ for LDPC encoding is relatively large compared to $t_k$ (e.g., if the value of $i$ is large in $\frac{Z_k}{t_k} = 2^i$), encoding complexity is likely to increase significantly due to operations involving the $\phi^{-1}$ matrix. Therefore, the

value of $t_k$ may be selected by considering both cycle characteristics and encoding complexity. When considering only cycle characteristics improvement, the smallest lifting size may be selected as $t_k$ from among the lifting size values included in the lifting size set corresponding to $i_{LS} = k$. considering a limited increase in encoding complexity, from among the lifting size values included in the lifting size set corresponding to $i_{LS} = k$, larger than the smallest lifting size and smaller than the largest lifting size may be selected as $t_k$. Typically, when the lifting sizes included in the lifting size set are $Z_1 = p \cdot 2^{j_1}$, $Z_2 = p \cdot 2^{j_2}$, ..., $Z_{max} = p \cdot 2^{j_{max}}$ ($j_1 < j_2 < \cdots < j_{max}$), the $t_k$ value may be set as $t_k = p^i$ ($j_1 < i < j_{max}$). In general, if the values of $j_1$, $j_2$, ..., $j_{max}$ are not consecutive integers, the value of $i$ may be selected as an integer other than $j_1, j_2, ...$. In addition to the above embodiment, $t_k$ may also be selected based on various conditions as described above in various embodiments, but a detailed description may be omitted for convenience.

As an example of exponent selection methods, an example of exponent selection when a = 1, e.g., $P^a = P^1$, is set for convenience is shown below.

Exponent Selection Example 2 ($i_{LS} = k$)

- $a_k = 1$ ($\rightarrow P^a = P$
- When $b_k = 0$ $s_k = -1$) is configured, gcd($|a_k - b_k|$, $Z_k$) = 1 ($P^b = I$)
- $c_k$ is $c_k = 1 + t_k$ (or $c_k = 1 - t_k$), where $t_k$ is one of the lifting sizes smaller than the largest lifting size $Z_{k,max}$ among the lifting size values included in the lifting size set corresponding to $i_{LS} = k$.

If the difference of exponents for submatrix B determined through Exponent Selection Example 2 above is obtained, $|a_k - b_k| = 1$ so that gcd($|a_k - b_k|$, $Z_k$) = 1 is always established for any lifting size $Z_k$, and $|b_k - c_k| = 1 + t_k$ so that 1 = gcd(1, $Z_k$) = gcd(1 + $Z_k$, $Z_k$) = gcd(1 + $t_k$, $Z_k$) is established, thereby satisfying Exponent Condition 1a and Exponent Condition 1b. As in Exponent Selection Example 2, when $b_k = 0$, Exponent Condition 1a and Exponent Condition 1b may be satisfied not only for $a_k = 1$ but also for any $a_k$ that generally satisfies gcd($a_k$, $Z_k$) = 1. That is, for an integer $a$ such that gcd($a_k$, $Z_k$) = 1, submatrix B, where $a_k = a$, $b_k = 0$, and $c_k = a + t_k$, satisfies Exponent Conditions 1a and 1b. Furthermore, since $\left| c_k - a_k \right| = t_k = \frac{Z_{max}}{2^i} = p \cdot 2^{(L-i)}$ , whether Exponent Conditions 2a and 2b are satisfied depends on the lifting size $Z_k$. explained, $t_k$ (or $c_k$) may be selected based on various conditions, taking into account cycle characteristics and encoding complexity.

An example related to Exponent Selection Example 2 is described below.

Given a set of lifting sizes as shown in Table 8, a specific example of submatrix B is shown in Equation 18 below. Equation 18 shows an example of submatrix B in the parity check matrix for $i_{LS}$ = in Table 8. (This is an example of setting the matrices ($P^a$, $P^b$, $P^c$) of Equation 15.) The submatrix B may be determined based on at least one of the matrices included in Equation 18 below. However, the disclosure is not limited to this. For example, the following example illustrates a case where 32 is selected from among the lifting sizes, but any of the lifting sizes included in Table 8 above may be selected. Therefore, various matrices may be considered based on c determined according to the lifting size.

[Equation 18]

- a = 1, b = 0, c = 1 + 32 = 33 (32 is selected among the lifting sizes)

$$B_1 = \begin{bmatrix} P^1 & I & 0 \\ I & I & I \\ P^{33} & 0 & I \end{bmatrix}, B_{2,1} = \begin{bmatrix} P^1 & I & 0 & 0 \\ I & I & I & 0 \\ 0 & 0 & I & I \\ P^{33} & 0 & 0 & I \end{bmatrix}, B_{2,2} =$$

$$\begin{bmatrix} P^1 & I & 0 & 0 \\ 0 & I & I & 0 \\ I & 0 & I & I \\ P^{33} & 0 & 0 & I \end{bmatrix}, B_3 = \begin{bmatrix} P^1 & I & 0 & 0 & 0 \\ 0 & I & I & 0 & 0 \\ I & 0 & I & I & 0 \\ 0 & 0 & 0 & I & I \\ P^{33} & 0 & 0 & 0 & I \end{bmatrix}, \qquad B_{4,1} =$$

$$\begin{bmatrix} P^1 & I & 0 & 0 & 0 & 0 \\ 0 & I & I & 0 & 0 & 0 \\ 0 & 0 & I & I & 0 & 0 \\ I & 0 & 0 & I & I & 0 \\ 0 & 0 & 0 & 0 & I & I \\ P^{33} & 0 & 0 & 0 & 0 & I \end{bmatrix},$$

$$B_{4,2} = \begin{bmatrix} P^1 & I & 0 & 0 & 0 & 0 \\ 0 & I & I & 0 & 0 & 0 \\ I & 0 & I & I & 0 & 0 \\ 0 & 0 & 0 & I & I & 0 \\ 0 & 0 & 0 & 0 & I & I \\ P^{33} & 0 & 0 & 0 & 0 & I \end{bmatrix}.$$

In the case of Equation 18, if the lifting size Z value in the Oth lifting size set is selected as 32 or less, such as 8, 16, or 32, then $P^{33} = P^1$ from $33 \equiv 1 \pmod{Z}$, so that the $\phi$ matrix actually becomes the identity matrix $I$, and $\phi^{-1}$ also becomes the identity matrix $I$. This simplifies the encoding process, but has the disadvantage of not improving the cycle characteristics. If the cycle characteristics are improved while considering the limited increase in encoding complexity, the following combinations are possible for the exponent pairs (a, b, c) corresponding to $(P^a, P^b, P^c)$ in the submatrix having the structure of Equation 18.

[Table 10]

| Set exponent (iLS) | (a, b) | c |
|---|---|---|
| 0 | | 17 or 33 or 65 (or 129) |
| 1 | | 25 or 49 or 97 (or 193) |
| 2 | | 21 or 41 or 81 (or 161) |
| 3 | | 15 or 29 or 57 (or 113) |
| 4 | (a, b) = (1,0) | 19 or 37 or 73 (or 145) |
| 5 | | 23 or 45 or 89 (or 177) |
| 6 | | 27 or 53 (or 105) |
| 7 | | 31 or 61 (or 121) |

Table 10 above is only an example, and in general, $c = t + 1$ may be determined by selecting t from among the lifting size values smaller than Zmax.

As an example of the disclosure, the c value may be determined based on the largest lifting size among the lifting sizes smaller than a specific reference value. Specifically, if the reference value is set to 96, in a system using lifting size sets as shown in [Table 3] to [Table 8], the numbers less than or equal to 96 in each lifting size set are, in order, 64, 96, 80, 56, 72, 88, 52, and 60. Therefore, if the c value corresponding to the parity check matrix defined according to each lifting size set index is determined based on the reference value given in each lifting size set, the c values may be defined as, in order, 65, 97, 81, 57, 73, 89, 53, and 61 according to each lifting size set index. If the reference value is set to 48, the c values may be defined as 33, 49, 41, 29, 37, 45, 27, and 31, in that order, according to each lifting size set index. For reference, when using the lifting size sets, excluding the numbers in parentheses in [Table 3] or [Table 8], if the ith largest lifting size among the lifting sizes included in the lifting size set with $i_{LS}$ = the c value corresponding to the parity check matrix defined according to each lifting size set index is determined as an integer obtained by adding 1 to the ith largest lifting size among the lifting sizes in each set.

For uniformity of the encoding method, the ith largest lifting size may be selected from each lifting size set (i = 2, 3, 4, ...). For example, in a system using the lifting size sets shown in [Table 3], the fifth largest numbers in the respective lifting size sets are 16, 24, 20, 14, 18, 22, 13, and 15. Therefore, if the c value corresponding to the parity check matrix defined according to each lifting size set index is determined based on the fifth largest number in each lifting size set (i=5), the c values may be defined as 17, 25, 21, 15, 19, 23, 14, and 16, in that order, based on each lifting size set index. Similarly, if the c value corresponding to the parity check matrix defined according to the lifting size set index is determined based on the fourth largest number in each lifting size set (i=4), the c values may be defined as 33, 49, 41, 29, 37, 45, 27, and 31, in that order, based on each lifting size set index. Similarly, if the c value corresponding to the parity check matrix defined according to the lifting size set index is determined based on the third largest number in each lifting size set (i=3), the c values may be defined as 65, 97, 81, 57, 73, 89, 53, and 61, in that order, according to the lifting size set index. Similarly, if the c value corresponding to the parity check matrix defined according to the lifting size set index is determined based on the second largest number in each lifting size set (i=2), the c values may be defined as 129, 193, 161, 113, 145, 177, 105, and 121, in that order, according to the lifting size set index.

In a system that uses a lifting size set of values, excluding the values in parentheses in [Table 8], the fifth largest numbers in the respective lifting size sets are 32, 48, 40, 28, 36, 44, 26, and 30. Therefore, if the c value corresponding to the parity check matrix defined according to each lifting size set index is determined based on the fifth largest number in each lifting size set (i=5), the c values may be defined as 33, 49, 41, 29, 37, 45, 27, and 31, in that order, based on the lifting size set index. Similarly, if the c value corresponding to the parity check matrix defined according to the lifting size set index is determined based on the fourth largest number in each lifting size set (i=4), the c values may be defined as 65, 97, 81, 57, 73, 89, 53, and 61, in that order, based on the lifting size set index. Similarly, if the c value corresponding to the parity check matrix defined according to the lifting size set index is determined based on the third largest number in each lifting size set (i=3), the c values may be defined as 129, 193, 161, 113, 145, 177, 105, and 121, in that order, based on the lifting size set index. Similarly, if the c value corresponding to the parity check matrix defined according to the lifting size set index is determined based on the second largest number in each lifting size set (i=2), the c values may be defined as 257, 385, 321, 225, 289, 353, 209, and 241, in that order, based on the lifting size set index.

According to the pair $(P^a, P^b, P^c) = (P, I, P^c)$ shown in the above Equation 18, the above table 10, and the corresponding embodiments, the $\phi$ matrix becomes $\phi = P + I + P^c$, and when the lifting size $Z_k$ value is less than or equal to (c - 1) according to the Exponent Selection Example 2 above, $c \equiv 1 \pmod{Z_k}$ is established, and thus, since $P^a = P = P^c$, the cycle characteristics are not improved, but efficient LDPC encoding is possible by utilizing the establishment of $\phi = I + P + P^c = I = \phi^{-1}$. When the lifting size $Z_k$ value is greater than (c - 1), there exists an $i$ that satisfies $(P)^{2i} = (P^c)^{2i}$ ($i \geq 1$), so $\phi^{2i} = I$. Therefore, although the encoding complexity increases using $\phi^{-1} = \phi^{2i-1} = \phi^{2i-1} \cdot \phi^{2i-2} \cdot \cdots \cdot \phi^2 \cdot \phi$, efficient LDPC encoding is possible. Here, the cycle length determined by $P^a$ and $P^c$ increases from the original $2m_{b1}$ to $2M_{b1} \cdot Z/D = 2m_{b1} \cdot 2^i = 2^{i+1} \cdot m_{b1}$. The cycle length determined by $P^a$ and $P^b$, or $P^b$ and $P^c$, increases significantly in proportion to the value of Z because it satisfies Exponent Conditions 1a and 1b.

As an example of the exponent selection method, for convenience, when $a = 0$, e.g., $P^a = I$,

Exponent Selection Example 3 ($i_{LS} = k$)

- $a_k = 0$ ($\rightarrow P^a = I$)
- $b_k = 1$ (If $S_k = 1$, gcd($|a_k - b_k|$, $Z_k$)=1, $P^b = P$)
- $c_k$ is $c_k = t_k$ (or $c_k = -t_k$), where $t_k$ is one of the lifting sizes smaller than the largest lifting size $Z_{k,max}$ among the lifting size values included in the lifting size set corresponding to $i_{LS} = k$.

If the difference of exponents for submatrix B determined through Exponent Selection Example 3 above is obtained, $|a_k - b_k| = 1$ so that gcd($|a_k - b_k|$, $Z_k$) = 1 is always established for any lifting size $Z_k$, and $|b_k - c_k| = t_k - 1$ gcd(1, $Z_k$) = gcd($Z_k - 1$, $Z_k$) = gcd($t_k - 1$, $Z_k$) is established, thereby satisfying Exponent Condition 1a and Exponent Condition 1b. As in Exponent Selection Example 3, when $a_k$ = satisfied not only for $b_k = 1$ but also for any $b_k$ that generally satisfies gcd($b_k$, $Z_k$) = 1. That is, for an integer $b$ such that gcd($b_k$, $Z_k$) = 1, submatrix B, where $a_k = 0$, $b_k = b$, and $c_k = t_k$, satisfies Exponent Conditions 1a and 1b. Furthermore, since $|c_k - a_k| = t_k = \frac{Z_{max}}{2^i} = p \cdot 2^{(L-i)}$, whether Exponent Conditions 2a and 2b are satisfied depends on the lifting size $Z_k$. $t_k$ (or $c_k$) may be selected based on various conditions, taking into account cycle characteristics and encoding complexity.

An example related to Exponent Selection Example 3 will be described below.

Given a set of lifting sizes as shown in Table 8, an example of submatrix B is shown in Equation 19 below. Equation 19 shows an example of a submatrix B in the parity check matrix for $i_{LS} = 0$ in Table 8. (This is an example of setting the matrices ($P^a$, $P^b$, $P^c$) of Equation 15.) The submatrix B may be determined based on at least one of the matrices included in Equation 19 below. However, the disclosure is not limited thereto. That is, the following example illustrates a case where 32 is selected from among the lifting sizes, but any of the lifting sizes included in Table 8 above may be selected. Therefore, various matrices may be considered based on c determined according to the lifting size.

For example, the following illustrates an example in which 32 is selected among the lifting sizes, but any one of the lifting sizes included in Table 8 above may be selected. Therefore, various matrices may be considered based on c determined according to the lifting size.

[Equation 19]

$$-\ a = 0,\ b = 1,\ c = 32 \text{ (32 is selected from among the lifting sizes)}$$

$$B_1 = \begin{bmatrix} I & I & O \\ P & I & I \\ P^{32} & O & I \end{bmatrix}, B_{2,1} = \begin{bmatrix} I & I & O & O \\ P & I & I & O \\ O & O & I & I \\ P^{32} & O & O & I \end{bmatrix}, B_{2,2} =$$

$$\begin{bmatrix} I & I & O & O \\ O & I & I & O \\ P & O & I & I \\ P^{32} & O & O & I \end{bmatrix}, B_3 = \begin{bmatrix} I & I & O & O & O \\ O & I & I & O & O \\ P & \square & I & I & O \\ O & O & O & I & I \\ P^{32} & O & O & O & I \end{bmatrix}, B_{4,1} = \begin{bmatrix} I & I & O & O & O & O \\ O & I & I & O & O & O \\ O & O & I & I & O & O \\ P & O & O & I & I & O \\ O & O & O & O & I & I \\ P^{32} & O & O & O & O & I \end{bmatrix},$$

$$B_{4,2} = \begin{bmatrix} I & I & O & O & O & O \\ O & I & I & O & O & O \\ P & O & I & I & O & O \\ O & O & O & I & I & O \\ O & O & O & O & I & I \\ P^{32} & O & O & O & O & I \end{bmatrix}.$$

In the case of Equation 19, if the lifting size Z value in the Oth lifting size set is selected as 32 or less, such as 8, 16, or 32, then $P^{32} = P^0 = I$ from $33 \equiv 0 \pmod{Z}$, so that the $\phi$ matrix actually becomes a circulant permutation matrix $P$, and $\phi^{-1}$ also becomes a circulant permutation matrix $P^{-1}$. This simplifies the encoding process, but has the disadvantage of not improving the cycle characteristics. If the cycle characteristics are improved while considering the limited increase in encoding complexity, the following combinations are possible for the exponent pairs ($a$, $b$, $c$) corresponding to ($P^a$, $P^b$, $P^c$) in the submatrix having the structure of Equation 18 above.

[Table 11]

| Set exponent (iLS) | (a, b) | c |
|---|---|---|
| 0 | | 16 or 32 or 64 (or 128) |
| 1 | | 24 or 48 or 96 (or 192) |
| 2 | | 20 or 40 or 80 (or 160) |
| 3 | (a, b) = (0,1) | 14 or 28 or 56 (or 112) |
| 4 | | 18 or 36 or 72 (or 144) |
| 5 | | 22 or 44 or 88 (or 176) |
| 6 | | 26 or 52 (or 104) |
| 7 | | 30 or 60 (or 120) |

Table 11 above is only an example, and in general, $c = t$ may be determined by selecting t from among the lifting size values smaller than Zmax.

As an example of the disclosure, the c value may be determined based on the largest lifting size among the lifting sizes smaller than a specific reference value. Specifically, if the reference value is set to 96, in a system using lifting size sets as shown in [Table 3] to [Table 8], the numbers less than or equal to 96 in each lifting size set are, in order, 64, 96, 80, 56, 72, 88, 52, and 60. Therefore, if the c value corresponding to the parity check matrix defined according to each lifting size set index is determined based on the reference value given in each lifting size set, the c values may be defined as, in order, 64, 96, 80, 56, 72, 88, 52, and 60 according to each lifting size set index. If the reference value is set to 48, the c values may be defined in the same manner as 32, 48, 40, 28, 36, 44, 26, and 30, in that order, according to each lifting size set index. When using the lifting size sets, excluding the numbers in parentheses in [Table 3] or [Table 8], if the $i^{th}$ largest lifting size among the lifting sizes included in the lifting size set with $i_{LS}$ = the c value corresponding to the parity check matrix defined according to each lifting size set index is determined as the $i^{th}$ largest lifting size in each set.

For uniformity of the encoding method, the $i^{th}$ largest lifting size may be selected from each lifting size set ($i$ = 2, 3, 4, 5, 6, ...). For example, in a system using the lifting size sets shown in [Table 3], the fifth largest numbers in the respective lifting size sets are 16, 24, 20, 14, 18, 22, 13, and 15. Therefore, if the c value corresponding to the parity check matrix defined according to each lifting size set index is determined based on the fifth largest number in each lifting size set (i=5), the c values may be defined as 16, 24, 20, 14, 18, 22, 13, and 15, in that order, based on each lifting size set index. Similarly, if the c value corresponding to the parity check matrix defined according to the lifting size set index is determined based on the fourth largest number in each lifting size set (i=4), the c values may be defined as 32, 48, 40, 28, 36, 44, 26, and 30, in that order, based on each lifting size set index. Similarly, if the c value corresponding to the parity check matrix defined according to the lifting size set index is determined based on the third largest number in each lifting size set (i=3), the c values may be defined as 64, 96, 80, 56, 72, 88, 52, and 60, in that order, according to the lifting size set index. Similarly, if the c value corresponding to the parity check matrix defined according to the lifting size set index is determined based on the second largest number in each lifting size set (i=2), the c values may be defined as 128, 192, 160, 112, 144, 176, 104, and 120, in that order, according to the lifting size set index.

In a system that uses a lifting size set of values, excluding the values in parentheses in [Table 8], the fifth largest numbers in the respective lifting size sets are 32, 48, 40, 28, 36, 44, 26, and 30. Therefore, if the c value corresponding to the parity check matrix defined according to each lifting size set index is determined based on the fifth largest number in each lifting size set (i=5), the c values may be defined as 32, 48, 40, 28, 36, 44, 26, and 30, in that order, based on the lifting size set index. Similarly, if the c value corresponding to the parity check matrix defined according to the lifting size set index is determined based on the fourth largest number in each lifting size set (i=4), the c values may be defined as 64, 96, 80, 56, 72, 88, 52, and 60, in that order, based on the lifting size set index. Similarly, if the c value corresponding to the parity check matrix defined according to the lifting size set index is determined based on the third largest number in each lifting size set (i=3), the c values may be defined as 128, 192, 160, 112, 144, 176, 104, and 120, in that order, based on the lifting size set index. Similarly, if the c value corresponding to the parity check matrix defined according to the lifting size set index is determined based on the second largest number in each lifting size set (i=2), the c values may be defined as 256, 384, 320, 224, 288, 353, 208, and 240, in that order, based on the lifting size set index.

According to the pair $(P^a, P^b, P^c) = (P, I, P^c)$ shown in the above Equation 19, the above table 11, and the corresponding embodiment, the $\phi$ matrix becomes $\phi = P + I + P^c$, $Z_k$ value is less than or equal to c according to the Exponent Selection Example 3 above, $c \equiv 0 \pmod{Z_k}$ is established, and thus, since $P^a = I = P^c$, the cycle characteristics are not improved, but efficient LDPC encoding is possible by utilizing the establishment of $\phi = P$, $\phi^{-1} = P^{-1}$. When the lifting size $Z_k$ value is greater than c, there exists an $i$ that satisfies $(p^c)^{2^i} = I$ ($i \geq 1$), so $\phi^{2^i} = I$. Therefore, although the encoding complexity increases using $\phi^{-1} = \varphi^{2^i-1} = \phi^{2^i-1} \cdot \phi^{2^i-2} ..... \phi^2 \cdot \phi$, efficient LDPC encoding is possible. Here, the cycle length determined by $P^a$ and $P^c$ increases from the original $2m_{b1}$ to $2m_{b1} \cdot Z/D = 2m_{b1} \cdot 2^i = 2^{i+1} \cdot m_{b1}$. The cycle length determined by $P^a$ and $P^b$, or $P^b$ and $P^c$, proportion to the value of Z because it satisfies Exponent Conditions 1a and 1b.

The above Exponent Selection Examples 1, 2, and 3 are methods for selecting exponents for some circulant permutation matrices comprising submatrix B 1020 in the parity check matrix in FIG. 10, while simultaneously considering both cycle characteristic improvement and encoding complexity. The above exponent selection examples provide a method in which when the lifting size is small and the code length is short, the cycle characteristic is not improved, but encoding complexity is very low, and in which as the lifting size increases, encoding complexity increases somewhat, but the cycle characteristic is improved. In general, LDPC codes are more susceptible to the error floor phenomenon due to cycle characteristics as the length increases. Therefore, the above methods, which further improve cycle characteristics as the lifting size increases and the code length increases together, may be considered methods for improving the error floor phenomenon appropriately for the LDPC code length.

When the lifting size is small and the code length is short, the cycle characteristic does not significantly affect the error floor phenomenon. However, these methods for improving cycle characteristics may also be applied even when the lifting size is small.

As an example of the disclosure, a method for improving cycle characteristics when the code length is short will be described.

Exponent Selection Example 4 ($i_{LS}$ = k)

- $a_k$ is any integer
- $b_k$ is $b_k = a_k + s_k$, $s_k$ is an integer satisfying gcd($s_k$, $Z_k$)=1. That is, among the exponents corresponding to submatrix B, $a_k$ and $b_k$ are integers satisfying gcd($| a_k - b_k|$, $Z_k$)=1. Here, gcd(x,y) denotes the greatest common divisor of x and y, and $Z_k$ denotes an arbitrary lifting size belonging to the set of lifting sizes corresponding to $i_{LS}$ = k. $Z_k = p_k \cdot 2^{L_k}$, $p_k$ is odd, $L_k \geq$ 0)

-

$$- \ c_k \ \text{is} \ c_k = a_k + \frac{Z_k}{2^{\min(J,L_k)}} = a_k + p_k \cdot 2^{L_k - 2^{\min(J,L_k)}}$$

or

$$c_k = \begin{cases} a_k + p_k, & L_k < J \\ a_k + \frac{Z_k}{2^J}, & L_k \geq J \end{cases} \left( = \begin{cases} a_k + p_k, & L_k < J \\ a_k + p_k \cdot 2^{L_k - J}, & L_k \geq J \end{cases} \right).$$

If the size of $Z_k$ supported by the system is always equal to or greater than $p_k \cdot 2^J$, it may be simply expressed as $c_k = a_k + \frac{Z_k}{2^J} (= a_k + p_k \cdot 2^{L_k - J})$ .

Exponent Selection Example 4 above describes a method in which each exponent of the circulant permutation matrix ($P^a$, $P^b$, $P^c$) is not fixed but is determined variably based on at least one lifting size Z. Therefore, the method provided in the disclosure may be applied not only to the lifting size sets in [Table 3] to [Table 8] but also to other various lifting size sets defined.

If $Z_k = p_k \cdot 2^{L_k}$ and $L_k < J$, $\frac{Z_k}{2^J}$ is not an integer, so in the above example, $c_k = a_k + p_k$ may be set. That is, the $c_k$ value may be determined variably depending on the $Z_k$ values supported by the system and the given J values. If the $Z_k$ value supported by the system is greater than or equal to $p_k \cdot^J$, since $\frac{Z_k}{2^J}$ is always an integer, it may be determined using a single method such as $c_k = a_k + \frac{Z_k}{2^J}$ .

The method of Exponent Selection Example 4 above satisfies Exponent Conditions 1a and 1b, and whether Exponent Conditions 2a and 2 are satisfied varies depending on the lifting size $Z_k$. $Z_k$ values is greater than or equal to $p_k \cdot 2^J$, Exponent Conditions 2a and 2b are satisfied, but if it is less than $p_k \cdot 2^J$, they are not satisfied.

According to the above Exponent Selection Example 4, when $Z_k \geq p_k \cdot 2^J$ (or $L_k \geq J$), the cycle length determined by $P^a$ and $P^c$ increases from the existing $2m_{b1}$ to $2^{J+1} \cdot m_{b1}$, and when $Z_k < p_k \cdot 2^J$ (or $L_k < J$), it increases to $2^{L_k}+1 \cdot m_{b1}$. (It does not increase when $L_k = 0$.) The cycle length determined by $P^a$ and $P^b$ or $P^b$ and $P^c$ greatly increases in proportion to the Z value because it satisfies the Exponent Condition 1a and the Exponent Condition 1b.

In addition, if $Z_k \geq p_k \cdot 2^J$ (or $L_k \geq J$), the $\phi$ matrix is

$$\phi = P^{a_k} + P^{a_k + s_k} + P^{a_k + \frac{Z}{2^J}} = P^{a_k} \left( I + P^{s_k} + P^{\frac{Z}{2^J}} \right).$$

Therefore,

$$\phi^{2^J} = P^{a_k \cdot 2^J} \cdot \left( I + P^{s_k \cdot 2^J} + P^Z \right) = P^{(a_k + s_k) \cdot 2^J}$$

$$\phi^{-1} = P^{-(a_k + s_k) \cdot 2^J} \cdot \phi^{2^J - 1} = P^{-(a_k + s_k) \cdot 2^J} \cdot \phi^{2^{J-1}} \cdot \phi^{2^{J-2}} \cdot \cdots \cdot \phi^2 \cdot \phi$$

may be used to perform LDPC encoding. If $Z_k < p_k \cdot 2^J$ (or $L_k < J$), the $\phi$ matrix is

$$\phi = P^{a_k} + P^{a_k + s_k} + P^{a_k + p_k} = P^{a_k} (I + P^{s_k} + P^{p_k}),$$

so there exists an integer $j$ ($j < J$) that satisfies

$$\phi^{2^j} = P^{a_k \cdot 2^j}\left(I + P^{s_k \cdot 2^j} + P^Z\right) = P^{(a_k + s_k) \cdot 2^j}.$$

Therefore, LDPC encoding is possible in a similar manner.

The method of Exponent Selection Example 4 above has the disadvantage that the maximum cycle length, which may be improved depending on the J value, is fixed regardless of the lifting size Z, but has the advantage of improving cycle characteristics even when the lifting size Z is small. In other words, rather than the respective exponents of the circulant permutation matrix ($P^a$, $P^b$, $P^c$) being fixed integer values, at least one of the exponents of the circulant permutation matrix is determined variably based on the lifting size Z, thereby improving cycle characteristics for various lifting sizes.

As an example of Exponent Selection Example 4 above, for convenience, an example of exponent selection when $a = 1$, e.g., $P^a = P^1$, is shown below.

Exponent Selection Example 5 ($i_{LS} = k$)

- 

$$a_k = 1 \; (P^a = P)$$

- 

$$b_k = 0 \; (P^b = I)$$

- 

$$c_k \text{ is } c_k = 1 + \frac{Z_k}{2^{\min(J, L_k)}} = 1 + p_k \cdot 2^{L_k - 2^{\min(J, L_k)}}$$

or

$$c_k = \begin{cases} 1 + p_k, & L_k < J \\ 1 + \frac{Z_k}{2^J}, & L_k \geq J \end{cases} \left( = \begin{cases} 1 + p_k, & L_k < J \\ 1 + p_k 2^{L_k - J}, & L_k \geq J \end{cases} \right).$$

If the size of $Z_k$ supported by the system is always equal to or greater than $p_k \cdot 2^J$, it may be simply expressed as

$$c_k = 1 + \frac{Z_k}{2^J} \left( = 1 + p_k \cdot 2^{L_k - J} \right).$$

As in the above Exponent Selection Example 5, when $b_k = 0$, not only $a_k = 1$ but also any $a_k$ satisfying $\gcd(a_k, Z_k) = 1$ satisfies Exponent Conditions 1a and 1b. That is, for an integer $a$ such that $\gcd(a, Z_k)=1$, the submatrix B set as $a_k = a$, $b_k$

$=c_k = 1 + p_k \cdot 2^{\max(L_k - J, 0)}$ (or $c_k = \begin{cases} a + p_k, & L_k < J \\ a + \frac{Z_k}{2^J}, & L_k \geq J \end{cases}$ ) satisfies Exponent Condition 1a and Exponent Condition 1b.

According to the method of Exponent Selection Example 5 above,

$$\phi^{2^J} = P^{a \cdot 2^J} + I + P^{a \cdot 2^J + Z} = I,$$

so efficient encoding is possible using $\phi^{-1} = \phi^{2^{J-1}} \cdot \phi^{2^{J-2}} \cdot \; \cdots \; \cdot \phi^2 \cdot \phi$.

As a more specific example of the above Exponent Selection Example 4, for convenience, an example of exponent selection when $a = 0$, e.g., $P^a = I$, below.

Exponent Selection Example 6 ($i_{LS} = k$)

- 

$$a_k = 0 \; (P^a = I)$$

-

$$b_k = 1 \ (P^b = P)$$

-

$$c_k \ \text{is} \ c_k = \frac{z_k}{2^{\min(J,L_k)}} = p_k \cdot 2^{L_k - 2^{\min(J,L_k)}}$$

or

$$c_k = \begin{cases} p_k, & L_k < J \\ \frac{z_k}{2^J}, & L_k \geq J \end{cases} = \begin{cases} p_k, & L_k < J \\ p_k \cdot 2^{L_k - J}, & L_k \geq J \end{cases}$$

If the size of $Z_k$ supported by the system is always greater than or equal to $p_k \cdot 2^J$, then it may be simply expressed as $c_k = \frac{z_k}{2^J} (= p_k \cdot 2^{L_k - J})$ .

As in the above Exponent Selection Example 6, when $a_k = 0$, not only $b_k = 1$ but also any $b_k$ satisfying $\gcd(b_k, Z_k) = 1$ satisfies Exponent Condition 1a and Exponent Condition 1b. That is, for an integer b such that $\gcd(b, Z_k) = 1$, submatrix B set as $a_k = 0$, $b_k = $ b, $c_k = p_k \cdot 2^{\max(L_k - J, 0)}$ (or $c_k = \begin{cases} p_k, & L_k < J \\ \frac{z_k}{2^J}, & L_k \geq J \end{cases}$ ) satisfies Exponent Condition 1a and Exponent Condition 1b.

According to the method of the above Exponent Selection Example 6, efficient encoding is possible based on

$$\phi^{2^J} = I + P^{b \cdot 2^J} + P^Z = P^{b \cdot 2^J}$$

$$\phi^{-1} = P^{-b \cdot 2^J} \cdot \phi^{2^J - 1} = P^{-b \cdot 2^J} \cdot \phi^{2^{J-1}} \cdot \phi^{2^{J-2}} \cdots \cdot \phi^2 \cdot \phi.$$

The exponent selection methods of the above Exponent Selection Examples 4, 5, and 6 allow the cycle length to be improved to a maximum of $2^{J+1} \cdot m_{b1}$ when efficient encoding is considered. If the $m_{b1}$ value is relatively large, the cycle characteristics may be sufficiently improved even if the J value is not large. Typically, the J value is determined by considering the parameter $m_{b1}$, indicates the number of rows in the core matrix part of the parity check matrix provided by the system, and the target BLER values. For example, if the target BLER is relatively high or the $m_{b1}$ value of the core matrix is large, J = 1 or 2 may be sufficient. However, if the target BLER is relatively low or the $m_{b1}$ value of the core matrix is small, it is preferable to configure J = 2, 3, 4, etc.

In general, since the degree to which a code's performance is affected by its cycle characteristics varies depending on the code length, it is also possible to configure the J value differently depending on the lifting size. For example, at least one of the exponents is determined based on the lifting size. In this case, when the lifting size is relatively small, the $J_1$ value may be configured to be small, and when the lifting size is relatively large, the $J_2$ value may be configured to be large ($J_1 < J_2$). When configuring the J value differently depending on the lifting size, a reference lifting size and appropriate $J_1$ and $J_2$ values must be determined.

Various possible exponent selection methods, including Exponent Selection Examples 1 through 6, may be variably applied depending on the target BLER and/or lifting size of the system. For example, if the target BLER of the system is high, the cycle characteristics do not significantly affect the code decoding performance, so that encoding may be performed using existing methods with the highest encoding efficiency even without improving the cycle characteristics. However, if the target BLER is low, the exponent selection methods provided in the disclosure may be applied. Here, the high and low target BLERs may be determined relatively when multiple target BLERs are applicable in the system. For example, if the first target BLER is $10^{-1}$ and the second target BLER is $10^{-5}$, the first target BLER may be considered higher than the second target BLER. If the first target BLER is $10^{-1}$, the second target BLER is $10^{-5}$, and the third target BLER is $10^{-6}$ (or $10^{-7}$), the first target BLER may be determined to be higher than the second and third target BLERs, and the first and second target BLERs may also be determined to be higher than the third target BLER. In this way, when multiple target BLERs are applicable in the system, it may be determined whether the BLER is high or low based on a specific BLER value, and then the exponent selection method provided in the disclosure may be variably applied based on the determination.

However, this is merely an embodiment, and the exponent selection methods provided in the disclosure may be variably applied when the target BLER is high, or regardless of the target BLER, based on other factors. Since the exponent selection method described throughout the disclosure refers to a method for selecting the exponent of the circulant permutation matrix included in a submatrix of the parity check matrix (specifically, submatrix B), the exponent selection method of the disclosure may be described as a method for determining the parity check matrix or a method for determining a submatrix included in the parity check matrix. Since the lifting size is closely related to the code length or TBS, all processes, in the disclosure, that are determined based on the lifting size may be modified to be determined based on the code length or TBS. In the above Exponent Selection Examples 1 to 6, although the lifting size $Z_k$ has been conveniently expressed as "$Z_k = p_k \cdot 2^{L_k}, L_k \geq 0, p_k$ is an odd number," in general, even when $p_k$ is not restricted to an odd number, as in [Table 7-1] or [Table 7-2], such as "$Z_k = p_k \cdot 2^{L_k}, L_k \geq 0, p_k$ is the smallest lifting size in the $k^{th}$ lifting size set," the exponent selection methods may be applied in the same manner.

As an example of the application of the J value in Exponent Selection Examples 4 to 6, if the system target BLER is determined to be high, the J value may be set to a small value such as $J_1$, and if the system target BLER is determined to be low, the J value may be set to a relatively large value $J_2$ ($J_1 < J_2$). The method of selecting the exponent or the decision on the J value may also be determined by considering the lifting size together. Typically, A reference BLERs and/or lifting sizes are configured, and a total of (A+1) different J values may be distinguished. For example, if there are a first reference value, a second reference value, etc., the J value may be subdivided as $J_1 < J_2$, $J_1 < J_2 < J_3$, etc. In general, J may also be set to 0, in which $P^a = P^c$, representing the existing method that allows for the simplest encoding without improving cycle characteristics.

Note that the method for determining the target BLER at the UE or base station may vary depending on the system. For example, the system target BLER may be directly indicated by higher layer signaling, such as configured RRC (radio resource control) information, the target BLER may also be indirectly indicated based on a configured CQI table or MCS table, or the target BLER may also be indirectly indicated based on a configured service scenario.

According to an embodiment, a method for variably applying puncturing to reduce decoding delay at the UE or base station in a system that transmits and receives data by puncturing information bits corresponding to some columns of a base matrix or parity check matrix, as in the 3GPP 5G standard, will be described.

A technique in which some of the input bits or code block bits are punctured by the transmitter and not transmitted to the receiver is typically used to achieve high encoding gain. Unlike the conventional method of puncturing some of the parity bits corresponding to the columns of relatively low weight in the parity check matrix, the input bits or code block bits to be punctured correspond to the columns of high weight. For example, as shown in [Table 9], during the encoding process in a 5G NR system, the first $2Z_c$ bits $i_0, i_1, i_2, ..., i_{2Z_c-1}$ of the input bits or code block bits are not transmitted, the first two columns of the base matrix $M(H_{BG1})$ or $M(H_{BG2})$ corresponding to the punctured information bits have relatively high weight in the entire base matrix. For example, in the parity check matrix, the weight of the $Z_c$ columns corresponding to the first column of the base matrix $M(H_{BG1})$ is 30, the weight of the $Z_c$ columns corresponding to the second column is 28, and in the parity check matrix, the weight of the $Z_c$ columns corresponding to the first column of the base matrix $M(H_{BG2})$ is 22, and the weight of the $Z_c$ columns corresponding to the second column is 23. As described above, the first $2Z_c$ columns of the parity check matrix corresponding to the base matrix $M(H_{BG1})$ or $M(H_{BG2})$ are columns with significantly higher weights than other columns in the entire parity check matrix.

Typically, the information bits to be punctured correspond to the columns with the highest weights in the base matrix or parity check matrix. To obtain a high encoding gain, the weights of the corresponding columns are typically at least three times the average column weight of the parity check matrix. In some cases, the weighs exceeding five or six times the average column weight may be considered. The optimal constraints on the weights of columns corresponding to the information bits to be punctured may vary depending on the code rate. Although columns with the highest weights or orders in the base matrix or parity check matrix are conveniently placed at the front, this is not a requirement, and they may be placed in the middle or back of the parity check matrix depending on system requirements.

Typically, when parity bits corresponding to columns with weight or degree 1 in the base matrix or parity check matrix of an LDPC code are punctured, this has no effect on the decoding process. Therefore, decoding is performed by excluding the columns corresponding to the parity bits and the rows directly connected to those columns, thereby reducing decoding complexity. However, even if punctured information bits are not actually transmitted from the transmitter to the receiver, the receiver treats the punctured information bits as erased bits and necessarily performs decoding, which does not reduce decoding complexity.

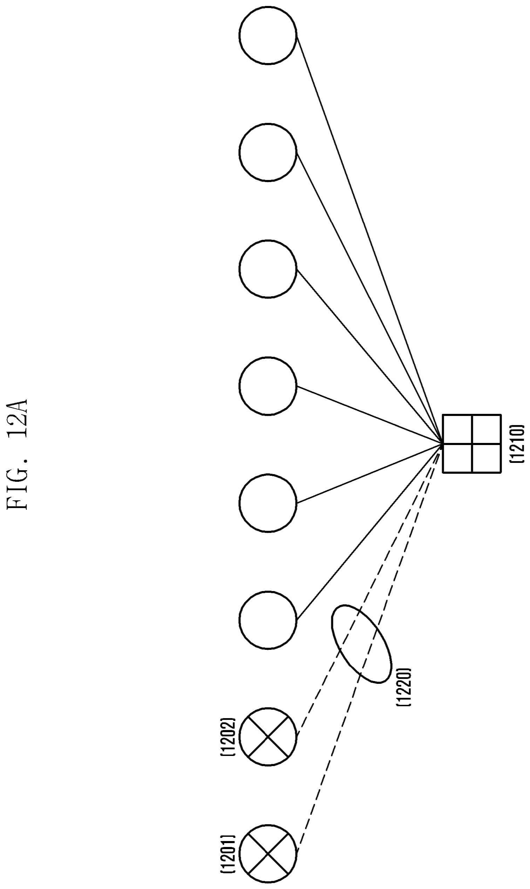

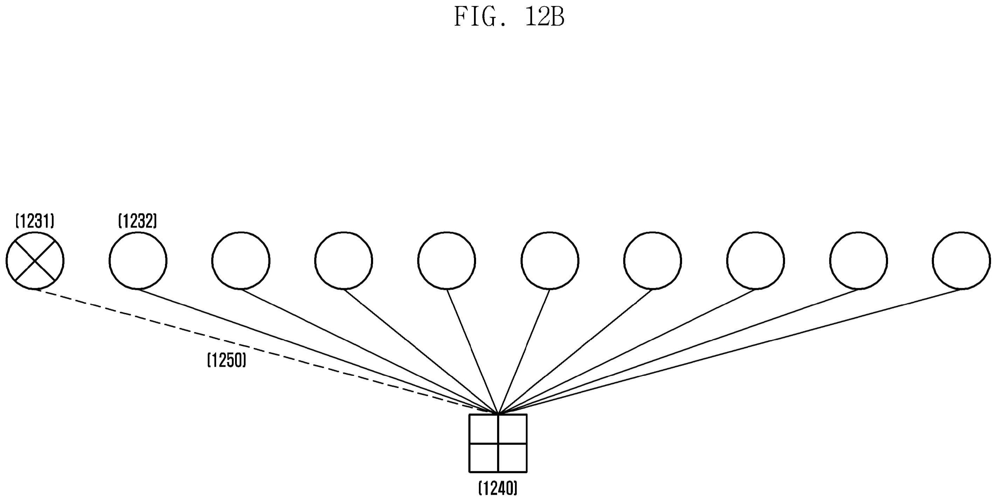

When performing LDPC decoding in a system to which the puncturing of the information bits is applied, decoding convergence speed may be affected depending on the decoding method. To illustrate this issue, the characteristics of the decoding process when LDPC encoding and decoding are performed using a portion of the base matrix of Equation 20, with information bits or a portion of the code block punctured, are briefly illustrated in FIGS. 12A and 12B. For reference, Equation 20 is a base matrix obtained by selecting the top six rows of the base matrix $M(H_{BG2})$, and it is assumed that the information bits corresponding to the first two columns are not transmitted. The method of not transmitting the information bits corresponding to the two columns may be performed through rate matching, or by puncturing the LDPC encoded bits separately from rate matching.

[Equation 20]

$$\begin{bmatrix} 1 & 1 & 1 & 1 & 0 & 0 & 1 & 0 & 0 & 1 & 1 & 1 & 0 & 0 & 0 & 0 \\ 1 & 0 & 0 & 1 & 1 & 1 & 1 & 1 & 1 & 1 & 0 & 1 & 1 & 0 & 0 & 0 \\ 1 & 1 & 0 & 1 & 1 & 0 & 0 & 0 & 1 & 0 & 1 & 0 & 1 & 1 & 0 & 0 \\ 0 & 1 & 1 & 0 & 1 & 1 & 1 & 1 & 1 & 1 & 1 & 0 & 0 & 1 & 0 & 0 \\ 1 & 1 & 0 & 0 & 0 & 0 & 0 & 0 & 0 & 0 & 0 & 1 & 0 & 0 & 1 & 0 \\ 1 & 1 & 0 & 0 & 0 & 1 & 0 & 1 & 0 & 0 & 0 & 1 & 0 & 0 & 0 & 1 \end{bmatrix}$$

FIGS. 12A and 12B are diagrams illustrating example cases where one and two punctured bits are connected to a single check node, respectively according to various example embodiments.

FIG. 12A is a diagram illustrating a Tanner graph corresponding to the first row of the base matrix of Equation 20. Although FIG. 12A illustrates eight variable nodes and one check node 1210 for convenience, since the base matrix of Equation 20 represents a quasi-circular LDPC code with a block size of Z, the first row actually represents 8*Z variable nodes connected to Z check nodes.

If two or more punctured variable nodes are connected to a single check node, as shown in 1201 and 1202 in FIG. 12A, the LLR values corresponding to the corresponding variable nodes are set to 0, and these values are transmitted to the check nodes 1210 along the respective lines 1220 connected to the variable nodes. In order to explain the decoding process in FIGS. 12A and 12B, referring to the decoding algorithm presented in the reference document 「Frank R. Kschischang, Brendan J. Frey, and Hans-Andrea Loeliger, "Factor Graphs and the Sum-Product Algorithm," IEEE TRANSACTIONS ON INFORMATION THEORY, VOL. 47, NO. 2, FEBRUARY 2001, pp498-519」, when applying the decoding update formula based on the multiplication rule using the tanh(.) function in the check node, since tanh(0) = 0, there must be at least one case where tanh(0) = 0 in the update formula. Therefore, the multiplication formula always becomes 0, so no matter how the update process is performed for any variable node, the LLR value of the variable node (e.g., bits) is not updated. In other words, if two or more punctured variable nodes (e.g., bits) are connected to a single check node, the LLR values for all variable nodes are not updated by the update rule based on the multiplication rule. For convenience, although the multiplication rule and the update rule for LLR values have been described herein, the reliability of variable nodes is not updated regardless of the application of any update rule or message value (e.g., the value obtained through demodulation for decoding, indicating the decoder input value).

FIG. 12B is a diagram illustrating the Tanner graph corresponding to the second row block in the base matrix of Equation 20. Although FIG. 12B illustrates ten variable nodes and one check node 1240 for convenience, since the base matrix of Equation 20 represents a quasi-circular LDPC code with a block size of Z, the second row actually represents 10*Z variable nodes connected to Z check nodes.

If only one punctured variable node is connected to a single check node, as shown in 1231 in FIG. 12B, the LLR value corresponding to the corresponding variable node is set to 0, and this value is transmitted to the check nodes 1240 along the line 1250. In other words, if the check node processor applies a multiplication rule-based update method while calculating the updated LLR values corresponding to the remaining lines, excluding the line 1250, the LLR values corresponding to variable nodes, excluding the line 1231, connected to the lines other than line 1250 will not be updated due to the LLR = 0 corresponding to the line 1250. However, since the update of the LLR value corresponding to the variable node corresponding to line 1250 is performed based on the values corresponding to the lines other than line 1250, the LLR value corresponding to the variable node 1231 may be updated to a value other than 0, which was set due to puncturing. Furthermore, once the LLR value corresponding to the variable node 1231 is updated to a non-zero value, since meaningful confidence values (e.g., LLR values) are configured for all variable nodes, the LLR values for all variable nodes (e.g., bits) may be updated in subsequent iterative decoding processes.

If LDPC decoding is performed using a flooding scheduling method that simultaneously decodes all rows using the base matrix of Equation 20, no updates are made to rows except the second and fourth rows during the initial iterative decoding process, and only the confidence values (e.g., LLRs) corresponding to the bits corresponding to the first two columns of the base matrix are updated due to updates to the second and fourth rows. That is, during the Oth iterative decoding process, the remaining bits, excluding the bits corresponding to the first two columns, are not updated at all, and since all bits are updated starting from the 1st iterative decoding process, the minimum number of required decoding iterations for successful LDPC decoding is 1. (The initial decoding performed based on the LLR value obtained through demodulation of the first received signal is considered the Oth decoding iteration.) The number of decoding iterations required for successful decoding may vary depending on channel conditions, but this may indicate that at least 1 decoding iteration is always required regardless of channel conditions.

Equation 21 is a simplified representation of the base matrix obtained by selecting the top 6 rows of the base matrix $M(H_{BG1})$, and it is assumed that the information bits corresponding to the first two columns are not transmitted. The method of not transmitting the information bits corresponding to the two columns may be performed through a rate matching method, or may be performed separately from the rate matching through the puncturing of the LDPC encoded bits.

$$[\text{Equation 21}]$$

$$\begin{bmatrix} 1 & 1 & 1 & 1 & & 1 & 1 & 1 & 0 & 0 & 0 & 0 \\ 1 & 0 & 1 & 1 & \cdots & 1 & 1 & 1 & 1 & 0 & 0 & 0 \\ 1 & 1 & 1 & 0 & & 0 & 0 & 0 & 1 & 1 & 0 & 0 \\ 1 & 1 & 0 & 1 & \cdots & 1 & 1 & 0 & 0 & 1 & 0 & 0 \\ 1 & 1 & 0 & 0 & & 0 & 0 & 0 & 0 & 0 & 1 & 0 \\ 1 & 1 & 0 & 1 & & 1 & 1 & 0 & 0 & 0 & 0 & 1 \end{bmatrix}$$

In the base matrix of Equation 21 above, all rows except the second row are represented as a Tanner graph, similar to FIG. 12A, in which one check node is connected to variable nodes corresponding to two punctured bits.

If LDPC decoding is performed using a flooding scheduling method that simultaneously decodes all rows using the base matrix of Equation 21, no updates are made to rows except the second row during the initial iterative decoding process, and only the confidence values (e.g., LLRs) corresponding to the bits corresponding to the first column of the base matrix are updated due to updates to the second row. That is, during the 0th iterative decoding process, the remaining bits, excluding the bits corresponding to the first one column, are not updated at all.

After the 0th iterative decoding process is completed, the bits corresponding to the second column are still considered erased. Therefore, during the 1st iterative decoding process, all bits connected to the bits corresponding to the second column remain un-updated. However, since the bits corresponding to all columns except the second column obtain meaningful confidence value (e.g., LLR values) during the 0th iterative decoding process, the bits corresponding to the second column obtain meaningful confidence values during the first iterative decoding process. For example, since meaningful confidence values are configured for all bits upon completion of the first iterative decoding process, updates for all bits are performed starting from the second iterative decoding process. Therefore, the minimum number of decoding iterations required for successful LDPC decoding is 2. The number of decoding iterations required for successful decoding may vary depending on channel conditions, but this may indicate that at least two decoding iterations are always required regardless of channel conditions.

Modern communication systems, including 5G systems, support diverse service scenarios. Among these, services for transmitting high-speed and high-capacity data require rapid data processing in the decoder. In particular, 5G systems are designed in consideration of a peak data rate of 20 Gbps, and next-generation communication systems, such as 6G, are considering supporting services with peak data rates several to tens of times higher than that.

As the number of decoding iterations necessary to achieve the error correction performance required by the system increases, the decoder's operating time also increases linearly. Therefore, the number of decoding iterations and the amount of information throughput in the decoder are inversely proportional. Therefore, in environments requiring high information throughput, a small number of decoding iterations is essential to achieve a high data rate. Thus, as the number of decoding iterations required to achieve the error correction performance required by the system, or the decoder operation time according thereto decreases, it is expressed that the decoding convergence speed is fast. On the other hand, as the number of decoding iterations or the decoder operation time according thereto increases, it is expressed that the decoding convergence speed is slow.

Existing 5G systems have a characteristic where some of the information bits are always punctured and are not transmitted to achieve superior encoding gain. Therefore, receivers employing decoding algorithms such as flooding require at least two decoding iterations, which may be detrimental to decoding convergence speed depending on the communication environment of the system. In other words, when a sufficient number of decoding iterations is available, puncturing the information bits may provide excellent encoding gain. However, in situations requiring fast data decoding (e.g., when the number of decoding iterations is limited), the encoding gain obtained from information word puncturing may not be sufficient.

The disclosure provides a method that enables efficient system operation by performing information word puncturing variably depending on system requirements.

In the existing encoding process, some of the information bits are always excluded when defining encoded bits, as shown in [Table 9], to apply information bit puncturing. The disclosure provides a method that variably performs information bit puncturing, and when information bit puncturing is not applied, a simple modification of the operation in [Table 9] may be performed, as shown in [Table 12].

[Table 12]

$$\text{for } k = 0 \quad \text{to } K - 1$$
$$\text{if } i_k \neq < NULL >$$
$$d_k = i_k;$$
$$\text{else}$$
$$i_k = 0;$$
$$d_k = < NULL >;$$
$$\text{end if}$$
$$\text{end for}$$

Referring to [Table 12] above, in the case where the input bits or code block bits are represented as $i_0, i_1, i_2, \ldots, i_{K-1}$ and the encoded bits are represented as $d_0, d_1, d_2, \ldots, d_{N-1}$, when base matrix 1 $M(H_{BG1})$ or a base matrix of the same size is applied, N=68$Z_c$, and when base matrix 2 M($H_{BG2}$) or a base matrix of the same size is applied, N=52$Z_c$.

Depending on the system configuration, including the UE or base station, if puncturing of information bits is applied, [Table 9] may be applied, and if puncturing of information bits is not applied, [Table 12] may be applied. In the disclosure, the configuration indicating that puncturing of information bits is to be performed, as shown in [Table 9], may be referred to as a first configuration, and the configuration indicating that puncturing of information bits is not to be applied, as shown in [Table 12], may be referred to as a second configuration.

These configurations may be determined based on higher layer parameters (e.g., RRC parameters). For example, if a situation requiring high encoding gain or a specific service corresponding thereto is configured (if the first configuration is indicated) through the above parameters, the operation in [Table 9] is performed, and if a situation requiring high information throughput or a specific service corresponding thereto is configured (if the second configuration is indicated), the operation in [Table 12] is performed.

Situations or services requiring high encoding gain or high information throughput may be indicated or configured based on separate signaling or parameters, or may be indicated or configured based on other existing signaling information or parameters. For example, variable puncturing of information bits may be performed based on at least one of the configured CQI or MCS index. The MCS index indicates the spectral efficiency of the system by indicating a combination of modulation order and code rate. Typically, a high spectral efficiency indicates good channel conditions, which likely requires higher information throughput rather than encoding gain. Therefore, puncturing of information bits may be applied variably based on the configured CQI or MCS index value. Furthermore, puncturing of information bits may be applied variably based on the range of values of at least one of the modulation order or code rate determined from the CQI or MCS index. For example, whether the first or second configuration is applied may be configured based on the CQI or MCS index value (e.g., in the form of a table), and the configuration may be applied based on the indicated CQI or MCS index value.

The above examples are merely examples, and the criteria for variably applying puncturing of information bits may be applied in various ways. For example, the puncturing of information bits may be variably applied based on the configured UE category, or depending on whether the UE is in the downlink or uplink.

The disclosure illustrates a case where the first or second configuration described above is configured for the UE. However, the puncturing of information bits may be basically applied as shown in [Table 9], but if a configuration indicating that puncturing of information bits is not to be applied is included, the puncturing of information bits may not be applied based on the configuration. For example, the puncturing of information bits may not be applied depending on whether a configuration indicating that puncturing of information bits is not to be applied is included.

[Table 9] and [Table 12] may also be expressed in a combined form, as shown in [Table 13].

[Table 13]

for $k = N_{punc}$ to $K - 1$

if $i_k \neq \ < NULL >$

$$d_{k-N_{punc}} = i_k;$$

else

$$i_k = 0;$$

$$d_{k-N_{punc}} = \ < NULL >;$$

end if

end for

In [Table 13] above, $N_{punc}$ represents the number of information bits to be punctured. In the case where input bits or code block bits are represented as $i_0, i_1, i_2, ..., i_{K-1}$ and encoded bits are represented as $d_0, d_1, d_2, ..., d_{N-1}$, when base matrix 1 $M(H_{BG1})$ or a base matrix having the identical size thereto is applied, $N = 68Z_c - N_{punc}$, and when base matrix 2 $M(H_{BG2})$ or a base matrix having the identical size thereto is applied, $N = 52Z_c - N_{punc}$. As a specific example, when information word puncturing of $2Z_c$ bits is applied, $N_{punc}$ = information word puncturing is not applied, $N_{punc}$ =

In general, the number of encoded bits $N$ may be defined as a difference between the maximum number of encoded bits determined by $Z_c$, e.g., the total number of columns of the parity check matrix determined by $Z_c$, and the number of punctured information word bits. In addition, since the number of parity bits that may be generated when the parity check matrix is determined is equal to a difference between the maximum number of encoded bits determined by $Z_c$, e.g., the total number of columns of the parity check matrix, and the number of given input bits (= code block bits), the parity bits may be represented as $w_0, w_1, w_2, ..., w_{68Z_c-K}-1$ when applying base matrix 1 $M(H_{BG1})$ or a base matrix having the identical size thereto, or may be represented as $w_0, w_1, w_2, ..., w_{52Z_c-K-1}$ or $w_0, w_1, w_2, ..., w_{N+Npuck-K}-1$ when applying base matrix 2 $M(H_{BG2})$ or a base matrix having the identical size thereto. Therefore, the encoded bits corresponding to the parity bits may be expressed as follows.

for

$$k = K \ \text{to} \ N + N_{punc} - 1$$

$$d_{k-N_{punc}} = w_{k-K}$$

end for

Although the above examples conveniently provide a method of applying variable puncturing to the same number of information bits regardless of the base matrix, $N_{punc}$ may be defined as different values, such as $N_{punc1}$, $N_{punc2}$ depending on the base matrix. If $N_{punc}$ is configured as a multiple of $Z_c$, it may be expressed as $N_{punc} = N_{punc,b} \cdot Z_c$ ($N_{punc,b}$: 1, 2, 3, ...), and when the total number of columns of a given base matrix (= total number of column blocks of a parity check matrix) is $n_b$, $n_b Z_c = N + N_{punc}$, expressed in various forms such as $N = n_b Z_c - N_{punc}$ or $N = (n_b - N_{punc,b})Z_c$.

In the examples of [Table 9] and [Table 12] above, only the cases where $N_{punc} = N_{punc} >$ bits, as described above, may be applied in a more detailed manner. For example, the puncturing of information bits may be variably applied in three stages, such as $N_{punc} = 0$, $N_{punc,b1} \cdot Z_c$, or $N_{punc,b2} \cdot Z_c$ ($N_{punc,b1} < N_{punc,b2}$), and may be further subdivided into more stages. Furthermore, depending on the system, there may not be a case where $N_{punc} = N = n_b' Z_c - N_{punc} \ (n_b > n_b')$. For example, in the disclosure, the second configuration may refer, for example, to a configuration that instructs not to apply puncturing of information bits, or to puncture some of the information bits (for example, when the number of punctured information bits is $2Z_c$ bits or less). In other words, when the second configuration is indicated, it may indicate that at least part of the information bits, which would be punctured during the encoding process or rate matching process when the first configuration is indicated, are not punctured during the encoding process or rate matching process. When the second configuration is indicated, it may indicate that the number of information bits that would be punctured during the encoding process or rate matching process is less than the number of information bits, which would be punctured during the encoding process or rate matching process when the first configuration is indicated, or is 0. When the first configuration is indicated, it may indicate that input bits of the first length among the input bits are not included in the encoded bits, and when the second configuration is indicated, it may indicate that input bits of the second length among the input bits are not included in the encoded bits, and the second length is 0 or less than the first length.

For example, compared to situations requiring high encoding gain or when a specific service corresponding thereto is configured (the first configuration), the characteristic of having no or fewer information bits to be punctured is maintained when a high information throughput is required or a specific service corresponding thereto is configured (the second configuration).

The value of $N_{punc}$ or $N_{punc,b}$ may be determined based on higher layer parameters (e.g., RRC parameters). For example, through the above parameters, when a high encoding gain is required or a specific service corresponding thereto is configured (the first configuration is indicated), it may be configured as a value equal to the number of first puncturing bits ($N_{punc}$ > throughput is required or a specific service corresponding thereto is configured (the second configuration is indicated), it may be configured as $N_{punc}$ = number of second puncturing bits) smaller than the number of first puncturing bits corresponding to the first configuration.

However, the disclosure is not limited thereto, and the value of $N_{punc}$ or $N_{punc,b}$ may not be separately configured but may be predetermined for the first or second configuration. Therefore, when the UE receives the first or second configuration, it may determine the number of information bits to be punctured corresponding thereto (and if the number of bits to be punctured is 0, it may be expressed as determining not to perform puncturing).

Furthermore, situations or services requiring high encoding gain or situations or services requiring high information throughput may be indicated or configured based on separate signaling or parameters, or may be indicated or configured based on other existing signaling information or parameters. For example, the puncturing of information bits may be variably applied based on at least one of the configured CQI or MCS index. The puncturing of information bits may be variably applied based on at least one of the modulation order or code rate determined from the CQI or MCS index, depending on the range of values. For example, whether to apply the first configuration or the second configuration may be configured based on the CQI or MCS index value (e.g., in the form of a table). Alternatively, the number of information bits to be punctured may be configured based on the CQI or MCS index value (e.g., in the form of a table), and the configuration may be applied or the puncturing of information bits may be performed based on the indicated CQI or MCS index value.

The puncturing of information bits may be applied variably depending on the configured CQI or MCS table. In other words, among multiple CQI or MCS tables, some CQI or MCS tables correspond to a method of applying puncturing of information bits, while others correspond to a method of not applying puncturing of information bits or puncturing a smaller number of information bits. Therefore, the base station or UE may determine whether to apply puncturing of information bits based on the configured CQI or MCS table. As an example, in the case where the first CQI or first MCS table is configured at the base station or UE, it may be determined that puncturing is to be applied to some of the information bits, thereby performing the encoding process of [Table 9] or the encoding process for $N_{punc}$ > in [Table 13]. If the second CQI or second MCS table is configured, the encoding process may be performed without puncturing the information bits, as shown in [Table 12], or the encoding process may be performed by applying puncturing to a smaller number of information bits than the number of information bits punctured when $N_{punc}$ = 0 or the first CQI or first MCS table is configured in [Table 13].

The above examples are merely examples, and various criteria for variably applying puncturing to information bits may be applied. For example, when a specific CQI or MCS table is configured, the puncturing of information bits may be applied variably depending on the CQI or MCS index, the puncturing of information bits may be applied variably based on the configured UE category, and the puncturing of information bits may be applied variably depending on whether it is downlink or uplink.

The electronic device according to various example embodiments set forth herein may be one of various types of electronic devices. The electronic device may include, for example, at least one of a portable communication device (e.g., a smart phone), a computer device, a portable multimedia device, a portable medical device, a camera, a wearable device, a home appliance, or the like. The electronic device according to various embodiments of the disclosure is not limited to those described above. In addition, an operation of transmitting a frame not only indicates that a frame is transmitted through a radio channel, but may also indicate that an interface which outputs a frame is included in order to transmit the frame to various electronic devices. For example, some processors may output a frame to an RF front end in order to transmit the frame via a bus interface. Likewise, an operation of receiving a frame from any other device may also indicate that there is an interface for obtaining, by various devices, a frame received from any other device. For example, it indicates that some processors may receive or obtain a frame from an RF front end via a bus interface.

It should be appreciated that various embodiments of the disclosure and the terms used therein are not intended to limit the technological features set forth herein to particular embodiments and the disclosure includes various changes, equivalents, and/or alternatives for a corresponding embodiment.

With regard to the description of the drawings, similar reference numerals may be used to designate similar or relevant elements. A singular expression may include a plural expression unless they are definitely different in a context. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such expressions as "a first", "a second", "the first", and "the second" may modify corresponding elements regardless of the order or importance thereof, and may be used to simply distinguish a corresponding element from the other elements and does not limit the corresponding elements. When an element (e.g., a first element) is referred to as being (operatively or communicatively) "connected" or "coupled" to/with another element (e.g., a second element), the element may be connected or coupled to/with the other element directly or via another element (e.g., a third element).

The term "determining" may imply various meanings, for example, may refer, for example, to, according to situations, various operations such as "identifying", "calculating or computing", "processing", "deriving", "investigating", "estimating", "looking up" (e.g., from other data structures in a database), or "ascertaining".

In the drawings in which methods of the disclosure are described, the order of the description does not always correspond to the order in which steps are performed, and the order relationship between the steps may be changed or the steps may be performed in parallel.

In the drawings in which methods of the disclosure are described, some elements may be omitted and only some elements may be included therein without departing from the essential spirit and scope of the disclosure.

In methods of the disclosure, some or all of the contents of each embodiment may be implemented in combination without departing from the essential spirit and scope of the disclosure.

Although various example embodiments of the disclosure have been described, various changes and modifications may be presented to those skilled in the art. These changes and modifications are intended to fall within the appended claims. In addition, operations that are represented by different blocks for the convenience of description in the operation flowcharts of the disclosure may be implemented by a plurality of separate processors in an actual system, but it will be apparent that they may also be implemented by a single integrated processor.

**Claims**

1. A method performed by a transmitting apparatus in a communication system, the method comprising:

   determining a number of input bits;
   determining a base matrix, based on the number of input bits;
   determining a lifting size, based on at least one of the number of input bits or the base matrix;
   determining a parity check matrix, based on at least one of the base matrix or the lifting size;
   determining encoded bits by performing encoding based on the parity check matrix and the input bits; and
   transmitting, to a receiving apparatus, at least part of the encoded bits,
   wherein input bits of a first length among the input bits are not included in the encoded bits based on a first configuration being indicated, and input bits of a second length among the input bits are not included in the encoded bits based on a second configuration being indicated, and
   wherein the second length is 0 or less than the first length.

2. The method of claim 1,
   wherein the first configuration or the second configuration is determined based on higher layer parameters.

3. The method of claim 1,
   wherein the first configuration or the second configuration is determined based on at least one of a CQI and/or an MCS index.

4. The method of claim 1,

   wherein the first configuration or the second configuration is determined based on at least one of a modulation order and/or a code rate, or
   wherein the first configuration or the second configuration is determined based on user equipment (UE) category information.

5. A method performed by a receiving apparatus in a communication system, the method comprising:

   receiving a signal corresponding to at least part of encoded bits;
   determining the number of input bits, based on the signal;
   determining a basic matrix, based on the number of input bits;
   determining a lifting size, based on at least one of the number of input bits or the base matrix;

determining a parity check matrix, based on at least one of the base matrix or the lifting size; and

decoding the signal, based on the parity check matrix,

wherein input bits of a first length among the input bits are not included in the encoded bits based on a first configuration being indicated, and input bits of a second length among the input bits are not included in the encoded bits based on a second configuration being indicated, and

wherein the second length is 0 or less than the first length.

6. The method of claim 5,
wherein the first configuration or the second configuration is determined based on higher layer parameters.

7. The method of claim 5,
wherein the first configuration or the second configuration is determined based on at least one of a CQI or an MCS index.

8. The method of claim 5,

wherein the first configuration or the second configuration is determined based on at least one of a modulation order or a code rate, or

wherein the first configuration or the second configuration is determined based on user equipment (UE) category information.

9. A transmitting apparatus in a communication system, the transmitting apparatus comprising:

a transmitter; and

a controller coupled with the transmitter and configured to:

determine the number of input bits;

determine a base matrix, based on the number of input bits;

determine a lifting size, based on at least one of the number of input bits or the base matrix;

determine a parity check matrix, based on at least one of the base matrix or the lifting size;

determine encoded bits by performing encoding based on the parity check matrix and the input bits; and

transmit, to a receiving apparatus, at least part of the encoded bits,

wherein input bits of a first length among the input bits are not included in the encoded bits based on a first configuration being indicated, and input bits of a second length among the input bits are not included in the encoded bits based on a second configuration being indicated, and

wherein the second length is 0 or less than the first length.

10. The transmitting apparatus of claim 9,
wherein the first configuration or the second configuration is determined based on higher layer parameters.

11. The transmitting apparatus of claim 9,
wherein the first configuration or the second configuration is determined based on at least one of a CQI or an MCS index.

12. The transmitting apparatus of claim 9,

wherein the first configuration or the second configuration is determined based on at least one of a modulation order or a code rate, or

wherein the first configuration or the second configuration is determined based on user equipment (UE) category information.

13. A receiving apparatus in a communication system, the receiving apparatus comprising:

a receiver; and

a controller coupled with the receiver and configured to:

receive a signal corresponding to at least part of encoded bits;

determine the number of input bits, based on the signal;

determine a base matrix, based on the number of input bits;

determine a lifting size, based on at least one of the number of input bits or the base matrix;

determine a parity check matrix, based on at least one of the base matrix or the lifting size; and

decode the signal, based on the parity check matrix,

wherein input bits of a first length among the input bits are not included in the encoded bits based on a first configuration being indicated, and input bits of a second length among the input bits are not included in the encoded bits based on a second configuration being indicated, and

wherein the second length is 0 or less than the first length.

14. The receiver of claim 13,

wherein the first configuration or the second configuration is determined based on higher layer parameters.

15. The receiver of claim 13,

wherein the first configuration or the second configuration is determined based on at least one of a CQI or an MCS index,

wherein the first configuration or the second configuration is determined based on at least one of a modulation order or a code rate, or

wherein the first configuration or the second configuration is determined based on user equipment (UE) category information.

FIG. 1

# FIG. 2

$$H_1 = \begin{cases} 1 & 1 & 1 & 1 & 1 & 1 & 0 & 0 \\ 1 & 1 & 0 & 1 & 0 & 1 & 1 & 0 \\ 1 & 1 & 1 & 0 & 0 & 0 & 1 & 1 \\ 1 & 0 & 1 & 1 & 1 & 0 & 0 & 1 \end{cases}$$

FIG. 3A

FIG. 3B

FIG. 4

Transport Block | TB-CRC

K

Code Block #0 | CB-CRC | FB

K

Code Block #1 | CB-CRC | FB

K

Code Block #2 | CB-CRC | FB

FB : filler bits

# FIG. 5

# FIG. 6

```
                    ┌──────────────┐
                    │    Start     │
                    └──────┬───────┘
                           │
              ┌────────────▼────────────┐  610
              │       Determine TBS     │
              └────────────┬────────────┘
                           │
                          ╱ ╲  620
                        ╱     ╲          Yes
                     ╱  TBS > max ╲──────────────┐
                     ╲   CBS ?    ╱               │
                        ╲       ╱                 ▼
                          ╲   ╱          ┌──────────────────┐ 630
                           │ No          │  Determine size  │
                           │             │ of segmented CBS │
                           │             └────────┬─────────┘
              ┌────────────▼────────────┐  640     │
              │ Determine lifting size (Z) │◄───────┘
              └────────────┬────────────┘
                           │
              ┌────────────▼────────────┐  650
              │ Determine LDPC exponent matrix │
              └────────────┬────────────┘
                           │
              ┌────────────▼────────────┐  660
              │       Decode LDPC       │
              └────────────┬────────────┘
                           │
                    ┌──────▼───────┐
                    │     End      │
                    └──────────────┘
```

FIG. 7

Transmitting apparatus (700)

710

**Segmentation unit**

720

**Zero padding unit**

730

**LDPC encoder**

740

**Rate matching unit**

750

**Modulator**

741

**Interleaver**

742

**Puncturing/repetition /zero remover**

Rate matching unit (740)

EP 4 779 909 A1

FIG. 8

Receiving apparatus (800)

810
Demodulator

820
Rate dematching unit

830
LDPC decoder

840
Zero remover

850
Desegmentation unit

Rate dematching unit (820)

822
LLR inserter

823
LLR combiner

824
Deinterleaver

EP 4 779 909 A1

FIG. 9

900

901

904

Input
processor

Variable node
operator

910

Output
processor

902

Memory

Controller

906

Check node
operator

908

# FIG. 10

FIG. 11A

Information 22 blocks

| 250 | 69 | 226 | 159 |  | 100 | 10 |  |  | 59 | 229 | 110 | 191 | 9 |  | 195 | 23 |  | 190 | 35 | 239 | 31 | 1 | 0 |  |  |  |  |
|---|---|---|---|---|---|---|---|---|---|---|---|---|---|---|---|---|---|---|---|---|---|---|---|---|---|---|---|
| 2 |  | 239 | 117 | 124 | 71 |  | 222 | 104 | 173 |  | 220 | 102 |  | 109 | 132 | 142 | 155 |  | 255 |  | 28 | 0 | 0 | 0 |  |  |  |
| 106 | 111 | 185 |  | 63 | 117 | 93 | 229 | 177 | 95 | 39 |  |  | 142 | 225 | 225 |  | 245 | 205 | 251 | 117 |  |  |  | 0 | 0 |  | 68 |
| 121 | 89 |  | 84 | 20 |  | 150 | 131 | 243 |  | 136 | 86 | 246 | 219 | 211 |  | 240 | 76 | 244 |  | 144 | 12 | 1 |  |  | 0 |  |  |
| 157 | 102 |  |  |  |  |  |  |  |  |  |  |  |  |  |  |  |  |  |  |  |  |  |  |  |  | 0 |  |
| 205 | 236 |  | 194 |  |  |  |  |  |  | 231 |  |  |  | 28 |  |  |  | 123 | 115 |  |  |  |  |  |  | 0 |  |

FIG. 11B

Information 10 blocks

| | | | | | | | | | | | | | | | | | | | |
|---|---|---|---|---|---|---|---|---|---|---|---|---|---|---|---|---|---|---|---|
| 9 | 117 | 204 | 26 | | 189 | | | 205 | 0 | 0 | | | | | | | | | |
| 167 | | | 166 | 253 | 125 | 226 | 156 | 224 | 252 | | 0 | 0 | | | | | | | |
| 81 | 114 | | 44 | 52 | | | | 240 | | 1 | | 0 | 0 | | | | | | |
| | 8 | 58 | | 158 | 104 | 209 | 54 | 18 | 128 | 0 | | | 0 | | | | | | |
| 179 | 214 | | | | | | | | | | 71 | | | 0 | | | | | |
| 231 | 41 | | | 194 | | 159 | | | | | 103 | | | | 0 | | | | |
| 155 | | | | 228 | | 45 | | 28 | | | 158 | | | | | 0 | | | |
| | 129 | | | 147 | | 140 | | | | | 3 | | 116 | | | | 0 | | |
| 142 | 94 | | | | | | | | | | | 230 | | | | | | 0 | |
| | 203 | | | | | 205 | | 61 | 247 | | | | | | | | | | 0 |
| 11 | 185 | | | | 0 | 117 | | | | | | | | | | | | | 0 |

FIG. 12A

FIG. 12B

## INTERNATIONAL SEARCH REPORT

| International application No. |
| --- |
| **PCT/KR2024/015449** |

| A. | CLASSIFICATION OF SUBJECT MATTER |
| --- | --- |

**H04L 1/00**(2006.01)i; **H03M 13/11**(2006.01)i

According to International Patent Classification (IPC) or to both national classification and IPC

| B. | FIELDS SEARCHED |
| --- | --- |

Minimum documentation searched (classification system followed by classification symbols)

H04L 1/00(2006.01); H03M 13/00(2006.01); H03M 13/11(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 입력 비트(input bit), 기본 행렬(basic matrix), 리프팅(lifting), 패리티 검사 행렬 (parity check matrix), 길이(length)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-2276721 B1 (HUAWEI TECHNOLOGIES CO., LTD.) 12 July 2021 (2021-07-12)<br>See paragraphs [0164]-[0188]; claims 1-12; and figure 6. | 1-15 |
| A | KR 10-2018-0104759 A (LG ELECTRONICS INC.) 21 September 2018 (2018-09-21)<br>See claims 1-2. | 1-15 |
| A | KR 10-2018-0071919 A (SAMSUNG ELECTRONICS CO., LTD.) 28 June 2018 (2018-06-28)<br>See paragraphs [0018]-[0268]; claims 1-8; and figures 1-23. | 1-15 |
| A | KR 10-2020-0035023 A (ZTE CORPORATION) 01 April 2020 (2020-04-01)<br>See paragraphs [1527]-[1565]; claims 1-9; and figures 3-4. | 1-15 |
| A | KR 10-2023-0107872 A (SAMSUNG ELECTRONICS CO., LTD.) 18 July 2023 (2023-07-18)<br>See paragraphs [0046]-[0273]; claims 1-15; and figures 1-13. | 1-15 |

☐ Further documents are listed in the continuation of Box C.    ☑ See patent family annex.

| | |
| --- | --- |
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **17 January 2025** | **20 January 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/015449**

| Patent document cited in search report | | | Publication date (day/month/year) | Patent family member(s) | | | Publication date (day/month/year) |
|---|---|---|---|---|---|---|---|
| KR | 10-2276721 | B1 | 12 July 2021 | AU | 2020-294981 | A1 | 30 January 2020 |
| | | | | AU | 2020-294981 | B2 | 22 October 2020 |
| | | | | BR | 112019027688 | A8 | 29 September 2020 |
| | | | | BR | 112019027876 | A2 | 07 July 2020 |
| | | | | CA | 3068553 | A1 | 03 January 2019 |
| | | | | CN | 109150197 | A | 04 January 2019 |
| | | | | CN | 109150197 | B | 14 May 2024 |
| | | | | CN | 109327225 | A | 12 February 2019 |
| | | | | CN | 109327225 | B | 03 September 2019 |
| | | | | CN | 111066253 | A | 24 April 2020 |
| | | | | CN | 111066253 | B | 18 October 2024 |
| | | | | CN | 118473422 | A | 09 August 2024 |
| | | | | EP | 3567731 | A1 | 13 November 2019 |
| | | | | EP | 3567731 | B1 | 12 January 2022 |
| | | | | EP | 4064573 | A1 | 28 September 2022 |
| | | | | EP | 4064573 | B1 | 27 December 2023 |
| | | | | EP | 4376337 | A2 | 29 May 2024 |
| | | | | EP | 4376337 | A3 | 27 November 2024 |
| | | | | ES | 2907089 | T3 | 21 April 2022 |
| | | | | ES | 2970217 | T3 | 27 May 2024 |
| | | | | JP | 2020-526111 | A | 27 August 2020 |
| | | | | JP | 2022-179504 | A | 02 December 2022 |
| | | | | JP | 7143343 | B2 | 28 September 2022 |
| | | | | JP | 7471360 | B2 | 19 April 2024 |
| | | | | KR | 10-2020-0013794 | A | 07 February 2020 |
| | | | | MY | 196344 | A | 24 March 2023 |
| | | | | PL | 3567731 | T3 | 28 February 2022 |
| | | | | RU | 2020102671 | A | 27 July 2021 |
| | | | | RU | 2020102671 | A3 | 07 September 2021 |
| | | | | RU | 2758968 | C2 | 03 November 2021 |
| | | | | US | 10771092 | B2 | 08 September 2020 |
| | | | | US | 11277153 | B2 | 15 March 2022 |
| | | | | US | 11671116 | B2 | 06 June 2023 |
| | | | | US | 12047096 | B2 | 23 July 2024 |
| | | | | US | 2020-0052720 | A1 | 13 February 2020 |
| | | | | US | 2021-0058095 | A1 | 25 February 2021 |
| | | | | US | 2022-0231705 | A1 | 21 July 2022 |
| | | | | US | 2023-0361787 | A1 | 09 November 2023 |
| KR | 10-2018-0104759 | A | 21 September 2018 | CN | 109891755 | A | 14 June 2019 |
| | | | | EP | 3567730 | A2 | 13 November 2019 |
| | | | | JP | 2020-501429 | A | 16 January 2020 |
| | | | | US | 2021-0167800 | A1 | 03 June 2021 |
| | | | | WO | 2018-128435 | A2 | 12 July 2018 |
| | | | | WO | 2018-128435 | A3 | 30 August 2018 |
| KR | 10-2018-0071919 | A | 28 June 2018 | AU | 2019-379533 | A1 | 11 July 2019 |
| | | | | AU | 2021-379533 | B2 | 23 December 2021 |
| | | | | CN | 110100402 | A | 06 August 2019 |
| | | | | CN | 110100402 | B | 16 July 2021 |
| | | | | KR | 10-2018-0071917 | A | 28 June 2018 |
| | | | | KR | 10-2018-0071921 | A | 28 June 2018 |

Form PCT/ISA/210 (patent family annex) (July 2022)

**INTERNATIONAL SEARCH REPORT**
Information on patent family members

International application No.

**PCT/KR2024/015449**

| Patent document cited in search report | | | Publication date (day/month/year) | Patent family member(s) | | | Publication date (day/month/year) |
|---|---|---|---|---|---|---|---|
| | | | | KR | 10-2018-0071923 | A | 28 June 2018 |
| | | | | KR | 10-2445150 | B1 | 21 September 2022 |
| KR | 10-2020-0035023 | A | 01 April 2020 | AU | 2018-295221 | A1 | 06 February 2020 |
| | | | | AU | 2018-295221 | B2 | 24 June 2021 |
| | | | | CA | 3068497 | A1 | 03 January 2019 |
| | | | | CA | 3068497 | C | 30 August 2022 |
| | | | | CN | 109120374 | A | 01 January 2019 |
| | | | | CN | 109120374 | B | 18 November 2022 |
| | | | | CN | 115801191 | A | 14 March 2023 |
| | | | | CN | 115801191 | B | 13 September 2024 |
| | | | | DK | 3648379 | T3 | 02 September 2024 |
| | | | | EP | 3648379 | A1 | 06 May 2020 |
| | | | | EP | 3648379 | B1 | 14 August 2024 |
| | | | | EP | 4422100 | A2 | 28 August 2024 |
| | | | | JP | 2020-526117 | A | 27 August 2020 |
| | | | | JP | 6990259 | B2 | 12 January 2022 |
| | | | | RU | 2743857 | C1 | 01 March 2021 |
| | | | | SG | 11201913212 | A | 30 January 2020 |
| | | | | US | 11159178 | B2 | 26 October 2021 |
| | | | | US | 11626888 | B2 | 11 April 2023 |
| | | | | US | 2020-0145026 | A1 | 07 May 2020 |
| | | | | US | 2022-0069843 | A1 | 03 March 2022 |
| | | | | WO | 2019-001263 | A1 | 03 January 2019 |
| KR | 10-2023-0107872 | A | 18 July 2023 | US | 12170528 | B2 | 17 December 2024 |
| | | | | US | 2023-0253984 | A1 | 10 August 2023 |
| | | | | WO | 2022-080975 | A1 | 21 April 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. MYUNG** ; **K. YANG** ; **Y. KIM**. Lifting Methods for Quasi-Circular LDPC codes. *IEEE Communications Letters*, June 2006, vol. 10, 489-491
- **S. MYUNG** ; **K. YANG** ; **J. KIM**. Quasi-Circular LDPC Codes for Fast Encoding. *IEEE Transactions on Information Theory*, August 2005, vol. 51 (8), 2894-2901
- **FRANK R. KSCHISCHANG** ; **BRENDAN J. FREY** ; **HANS-ANDREA LOELIGER**. Factor Graphs and the Sum-Product Algorithm. *IEEE TRANSACTIONS ON INFORMATION THEORY*, February 2001, vol. 47 (2), 498-519